# EUROPÄISCHE PATENTANMELDUNG

(11) **EP 2 226 648 A2**
(43) Veröffentlichungstag der Anmeldung: **08.09.2010**
(21) Anmeldenummer: 10164790.7
(22) Anmeldetag: 25.02.2009
(51) Int. Cl.: G01S 17/89, H01L 27/146

(54) **3D -Bilderzeugungssystem mit Multispektralsensor**

(30) Priorität: 29.02.2008 DE 102008011793
(62) Teilanmeldung aus: 09715284.7
(71) Anmelder: Fraunhofer-Gesellschaft zur Förderung der Angewandten Forschung e.V., 80686 München (DE)
(72) Erfinder: Weber, Norbert, 91367 Weissenohe (DE); Junger, Stephan, 91088, Bubenreuth (DE); Tschekalinskij, Wladimir, 90429 Nürnberg (DE)
(74) Vertreter: Schenk, Markus

(57) **Zusammenfassung**

Ein 3DBildeszeugungssystem bei dem von einer Lichtquelle (45') ein gepulster Strahl ausgesendet wird, von einem Objekt (44) reflektiert, und anschliessend zeitlich getaktet in einem multispektralen Bildsensor (40) aufgenommen wird. Aus der kombinierten Antwort bei verschiedenen Wellenlängen kann aus der Zeit messung und den 2D Bild aufnahmen ein 3D-Bild des Objektes erzeugt werden.
Der multispektrale Bildsensor ist einem zweidimensionalen Array aus Superpixel ausgestattet wobei jeder Superpixel wenigstens fünf Sensorelemente aufweist mit jeweils einem Pixelsensor, einer Filterstruktur mit wenigstens einer strukturierten Schicht aus Metall oder polykristallinem Halbleitermaterial, die ansprechend auf elektromagnetische Strahlung eines Wellenlängenbereichs eine höhere Transmission durch die Filterstruktur zu dem Pixelsensor ergibt als für den Wellenlängenbereich umgebende Wellenlängen, wobei die wenigstens fünf Sensorelemente gemeinsam auf einem Halbleitersubstrat integriert sind und paarweise auf unterschiedliche Wellenlängenbereiche ausgelegt sind.

## Beschreibung

Die vorliegende Erfindung bezieht sich auf einen Multispektralsensor mit spektralen Filterstrukturen aus wenigstens einer strukturierten Schicht aus Metall oder polykristallinem Halbleitermaterial und der wenigstens einen strukturierten Schicht zugeordnete Pixelsensoren.

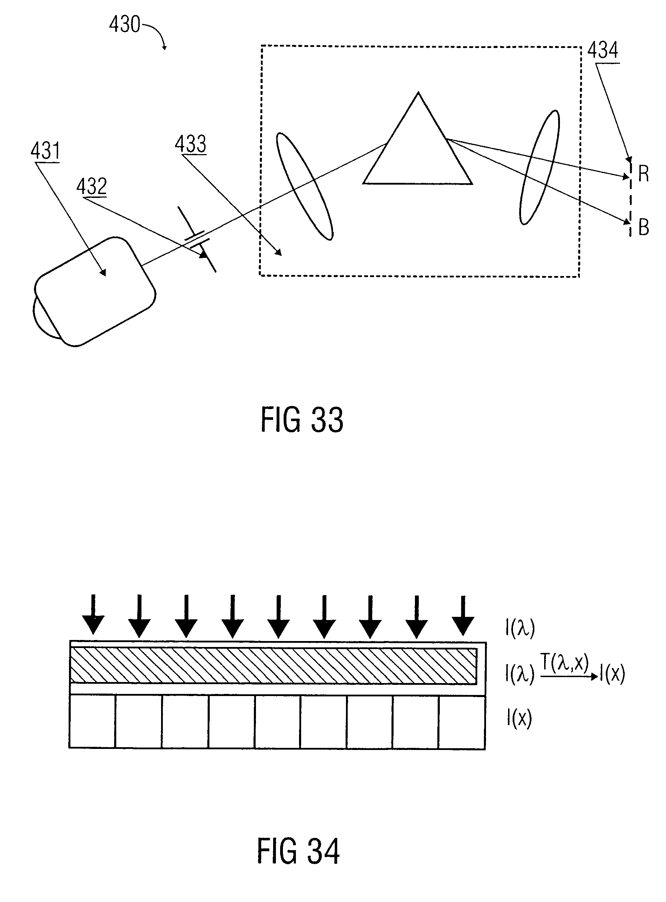

Optische Spektrometer bestehen derzeit in der Regel aus einem Aufbau, wie er schematisch in Fig. 33 dargestellt ist. Ein optisches System 431, wie z.B. eine Linse, sammelt und überträgt Licht auf eine Lichteintrittsöffnung 432, die die Auflösung des Spektrometers 430 definiert. Anschließend trifft das Licht auf eine Dispersionseinheit 433 und einen Zeilensensor 434, welcher das spektral aufgefächerte Licht detektiert. Das dispersive Element 433 ist dabei entweder ein Prisma oder ein Gitter und hat die Aufgabe, die einzelnen Spektralanteile des Lichts in unterschiedlichen Winkeln abzulenken, so dass in einer gewissen Entfernung von dem dispersiven Element 433 eine ausreichende Trennung der Spektrallinien erfolgt und mit dem Zeilensensor 434 erfasst werden kann.

Bei einfachen Spektrometeraufgaben mit nur wenigen zu messenden Spektrallinien können anstelle der Dispersionseinheit 433 auch Farbfilter verwendet werden, um die spektrale Trennung zu realisieren. Diese Farbfilter können entweder direkt auf dem Detektor 434 abgeschieden sein oder sich z.B. in einer Gehäusekappe des Detektors 434 befinden.

In konventionellen Chip-Size-Spektrometern wird meist ein Verlaufsfilter benutzt, der zu einer ortsabhängigen spektralen Filterung führt, wie es schematisch in Fig. 34 gezeigt ist. Hierzu sind aber zusätzliche Prozessschritte, wie z.B. das präzise Justieren und Verkleben optischer Filterelemente erforderlich.

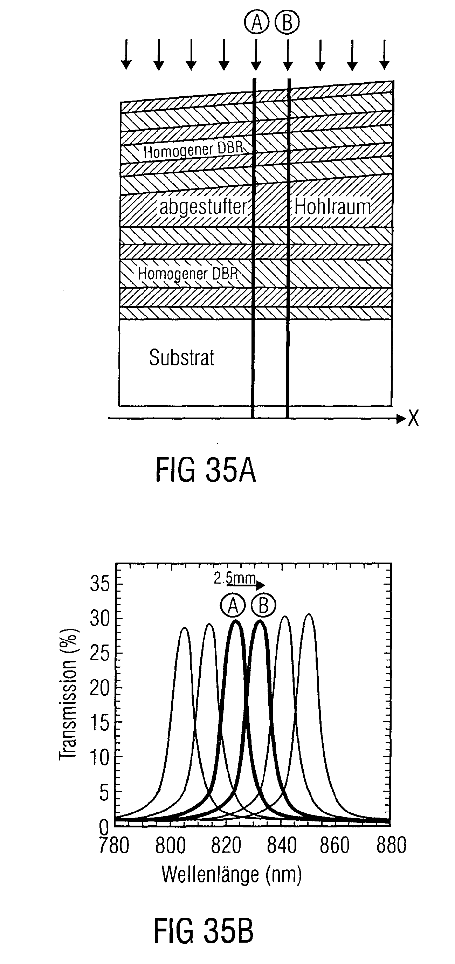

Ein weiterer Ansatz, eine lateral variierende spektrale Transmission zu erzielen, besteht darin, einen keilförmigen Resonator zwischen Bragg-Reflektoren zu verwenden, wie es schematisch in den Fig. 35a,b gezeigt ist.

In den letzten Jahren sind mehrere Simulationen und Experimente veröffentlicht worden, welche auch für den sichtbaren Wellenlängenbereich eine spektrale Selektivität von Strukturen bestätigen, die sog. Sub-Wellenlängen-Öffnungen in mehrstufig strukturierten Metallschichten aufweisen. In der Veröffentlichung P. B. Catrysse und B. A. Wandell, "Integrated color pixels in 0.18-µm complementary metal oxide semiconductor technology", wird ein Farbsensor auf der Basis von periodisch strukturierten Metallschichten im Rahmen von CMOS-Technologie beschrieben. Die Autoren zeigen, dass eine spektrale Empfindlichkeit deutlich von geometrischen Parametern (Breite und Periode von Streifen einer Gitterstruktur) einer Sub-Wellenlängen-Struktur abhängig ist und dass bereits mit einer relativ einfachen Struktur wie einem Liniengitter steile Filterflanken, z.B. für ein Tiefpass-Filter, realisierbar sind.

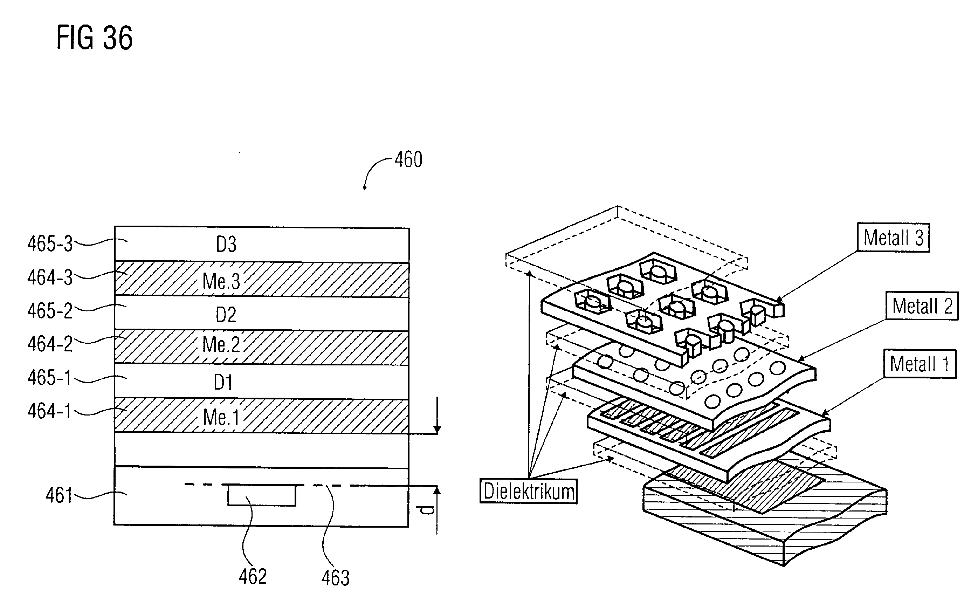

Mit Hilfe von Sub-Wellenlängen-strukturierten Metallschichten eines CMOS-Prozesses und der dort vorhandenen pn-Übergänge besteht die Möglichkeit, eine spektral empfindliche Photodiode zu realisieren. Fig. 36 zeigt dazu ein Beispiel für einen Schichtaufbau eines CMOS-Prozesses.

Fig. 36 zeigt ein Zwischenprodukt 460 eines CMOS-Prozesses, welches ein Substrat 461, insbesondere ein Halbleitersubstrat aufweist, in dem ein Pixelsensor 462 (z.B. Fotodiode) eingebracht ist. Dabei ist der Pixelsensor 462 in einer Ebene 463 angeordnet, die einen Feldkonzentrationsbereich (eine Art Brennebene, die man aus der klassischen Optik kennt) des darüber liegenden Schichtstapels aus metallischen Schichten 464 und dielektrischen Schichten 465 umfasst. Fig. 36 zeigt lediglich exemplarisch drei metallische strukturierte Schichten 464-1 bis 464-3 und drei dielektrische Schichten 465-1 bis 465-3, die ebenfalls strukturiert sein können. Mit einer entsprechenden Arrayförmigen Strukturierung der einzelnen Metallschichten, die man im Rahmen eines Chip-Designs definieren kann (z.B. Bild 36 rechts: oberste Schicht: Polygone, mittlere Schicht: kreisförmige Öffnungen, unterste Schicht: streifenförmig) erhält man eine definierte spektrale Transmission.

Beim Konzept des Spektrometers mit einer dispersiven Einheit müssen in der Regel drei verschiedene optisch aktive Bauteile (Eintrittsoptik, dispersives Element, Zeilensensor) verwendet werden. Diese Bauteile müssen sorgfältig justiert und aufgebaut werden, um den gewünschten Effekt zu erzielen. Dies erfordert einerseits einen gewissen Aufwand bei der Montage und benötigt außerdem relativ viel Platz trotz der verwendeten Ansätze eines Mikrosystem-gerechten Aufbaus. Zudem sind die Einzelbauelemente, vor allem die Detektorzeile und das Gitter, das häufig ebenfalls mikrosystemtechnisch hergestellt wird, relativ teuer. Die Positionierung und Fixierung der optischen Bauteile erfordert eine hohe mechanische Präzision, was ebenfalls zu hohen Kosten führt. Für einen Einsatz in großen Stückzahlen oder bei geforderter, extrem kleiner Baugröße sind die existierenden Lösungen daher kaum geeignet.

Spektrometer, die auf Farbfiltern basieren, können prinzipiell kleiner oder billiger hergestellt werden, haben aber den Nachteil, dass die spektrale Auflösung bei gleichzeitig kleiner Baugröße begrenzt ist und dass daher nur relativ wenige Wellenlängen (ca. 3-5) sinnvoll damit gemessen werden können. Die Aufbautechnik erfordert entweder ein nachträgliches Aufbringen von Farbfiltern auf Detektor-Chips oder von Farbfolien in das Gehäuse und ist daher ebenfalls mit Aufwand verbunden. Außerdem muss der Lichteintritt senkrecht zur Sensoroberfläche erfolgen, um gute Filterwirkung zu erzielen. Daher wird eine externe Kollimationsoptik benötigt.

Angesichts der genannten Nachteile des Stands der Technik besteht die Aufgabe der vorliegenden Erfindung somit darin, ein verbessertes Konzept zum Aufbau von Multispektralsensoren bzw. Spektrometern bereitzustellen, welches die Realisierung von Multispektralsensoren bzw. Spektrometern mit geringer Baugröße und hoher spektraler Auflösung ermöglicht.

Diese Aufgabe wird durch einen integrierten Multispektralsensor mit den Merkmalen des Patentanspruchs 1, ein Verfahren gemäß Patentanspruch 37, einen multispektralen Bildsensor nach Patentanspruch 38 und ein Verfahren nach Patentanspruch 44 gelöst.

Der vorliegenden Erfindung liegt die Erkenntnis zugrunde, dass ein Multispektralsensor bzw. Spektrometer mit den gewünschten Eigenschaften realisiert werden kann, indem eine Mehrzahl von Pixelsensoren (z.B. wenigstens fünf), in Form eines eindimensionalen oder zweidimensionalen Sensorarrays, gemeinsam mit den Pixelsensoren zugeordneten spektralen Filterstrukturen aus wenigstens einer strukturierten Metallschicht auf einem Halbleitersubstrat integriert wird, so dass durch unterschiedliche spektrale Selektivität der spektralen Filterstrukturen ein Multispektralsensor, der beliebige Spektrallinien gleichzeitig detektieren kann, aufgebaut werden kann.

Ausführungsbeispiele der vorliegenden Erfindung umfassen einen multispektralen Bildsensor mit einem zweidimensionalen Array aus Superpixeln, wobei jeder Superpixel wenigstens fünf Sensorelemente aufweist. Dabei weist ein erstes Sensorelement einen ersten Pixelsensor und eine erste Filterstruktur auf, mit wenigstens einer strukturierten Metallschicht, die ansprechend auf elektromagnetische Strahlung eines ersten Wellenlängenbereichs eine höhere Transmission durch die erste Filterstruktur zu dem ersten Pixelsensor ergibt als für den ersten Wellenlängenbereich umgebende Wellenlängen. Ein zweites Sensorelement weist einen zweiten Pixelsensor und eine zweite Filterstruktur auf, mit wenigstens einer strukturierten Metallschicht, die ansprechend auf elektromagnetische Strahlung eines zweiten Wellenlängenbereichs eine höhere Transmission durch die zweite Filterstruktur zu dem zweiten Pixelsensor ergibt als für den zweiten Wellenlängenbereich umgebende Wellenlängen. Bei bevorzugten Ausführungsbeispielen sind das erste und zweite Sensorelement gemeinsam auf einem Halbleitersubstrat integriert.

Weitere Ausführungsbeispiele der vorliegenden Erfindung umfassen einen multispektralen Bildsensor zur Erfassung eines zweidimensionalen Bildfeldes, mit einem Zeilensensor mit einer Mehrzahl eindimensional angeordneten Sensorelementen zum spektralen Erfassen einer geometrischen Linie, wobei jedes Sensorelement einen Pixelsensor und eine Filterstruktur mit wenigstens einer strukturierten Metallschicht aufweist, die ansprechend auf elektromagnetische Strahlung eines dem Sensorelement zugeordneten Wellenlängenbereichs eine höhere Transmission durch die Filterstruktur zu dem Pixelsensor ergibt als für den zugeordneten Wellenlängenbereich umgebende Wellenlängen. Jedem Sensorelement ist ein anderer Wellenlängenbereich zugeordnet. Die Sensorelemente sind vorzugsweise gemeinsam auf einem Halbleitersubstrat integriert. Ferner umfasst der multispektrale Bildsensor eine Einrichtung zum Abbilden einer Linie aus dem zweidimensionalen Bildfeld auf den Zeilensensor und eine Einrichtung zum Bewirken, dass eine auf den Zeilensensor abgebildete Linie das zweidimensionale Bildfeld durchläuft.

Die Einrichtung zum Abbilden einer Linie dient dabei zur Projektion der Linie auf eine Bildebene, in der sich der Zeilendetektor befindet. Sie kann beispielsweise eine Linse oder einen Hohlspiegel aufweisen.

Die Einrichtung zum Bewirken, dass eine auf den Zeilensensor abgebildete Linie das zweidimensionale Bildfeld durchläuft, erzeugt praktisch eine Abtastung unterschiedlicher Linien aus dem zweidimensionalen Bildfeld. Dies kann durch Bewegen des zweidimensionalen Bildfeldes an sich erfolgen, beispielsweise durch ein Transport- bzw. Förderband, oder durch Kippbewegung eines an einer Drehachse aufgehängten, elektromagnetische Strahlung reflektierenden Bauteils, wodurch unterschiedliche Linien des zweidimensionalen Bildfeldes auf den Zeilendetektor abgebildet werden können.

Gemäß einer Ausführungsform können die spektralen Filterstrukturen zum Detektieren von elektromagnetischer Strahlung jeweils eines vorbestimmten Wellenlängenbereichs ausgebildet sein. Die Pixelsensoren sind beispielsweise als Photodioden ausgebildet.

Gemäß einem Ausführungsbeispiel weisen die strukturierten Metallschichten der spektralen Filterstrukturen Eigenschaften eines photonischen Kristalls auf. Unter einem photonischen Kristall soll im Nachfolgenden eine dreidimensionale periodische Struktur verstanden werden, deren periodisch angeordnete Strukturelemente Abmessungen und Abstände zueinander aufweisen, die in der Größenordnung eines vorbestimmten Wellenlängenbereichs für elektromagnetische Strahlung liegen, der durch einen photonischen Kristall zu einem ihm zugeordneten Pixelsensor transmittiert werden kann. Photonische Kristalle umfassen strukturierte Metalle, Halbleiter, Gläser oder Polymere und zwingen elektromagnetische Strahlung, insbesondere Licht, mittels ihrer spezifischen Struktur dazu, in der sich für eine Bauteilfunktion notwendigen Art und Weise im Medium auszubreiten. Es sind gemäß Ausführungsbeispielen periodisch dielektrische und/oder metallische Strukturen, deren Periodenlänge so eingestellt ist, dass sie die Ausbreitung elektromagnetischer Strahlung, insbesondere Licht, in ähnlicher Weise beeinflussen, wie das periodische Potential in Halbleiterkristallen die Ausbreitung von Elektroden. Dies führt dazu, dass sich elektromagnetische Strahlung bzw. Licht bestimmter Wellenlängen nicht im photonischen Kristall ausbreiten kann. Diese Wellenlängen sind dann gewissermaßen verboten. Die spektrale Filterwirkung photonischer Kristalle ist seit einigen Jahren bekannt und durch Experimente bestätigt. Beispielsweise zeigen Ergebnisse in "Air-bridged phototonic crystal slabs at visible and near-infrared wavelenghts" K.B. Crozier, Virginie Lousse, Onur Kilic, Sora Kim, Shanhui Fan, and Olav Solgaard, dass bei dreidimensional periodisch strukturierten Metallflächen nicht alle Wellenlängen gleichermaßen durch solche Strukturen hindurchtreten, wenn die Strukturen kleiner als die Wellenlänge sind. Aus der Arbeit "The Optical Properties of Metal Nanoparticles: The Influence of Size, Shape, and Dielectric Environment" K. Lance Kelly, Eduardo Coronado, Lin Lin Zhao, and George C. Schatz folgt, dass die spektralen Eigenschaften solcher periodischer Strukturen stark von der Form der einzelnen Strukturelemente abhängen. Die fokussierende Wirkung dreidimensionaler photonischer Kristalle (d.h. eine Ablenkung elektromagnetischer Strahlung vom Rand zur Mitte des photonischen Kristalls hin) wurde gezeigt in "Analysis of focusing effects of 3-D photonic crystal lens by the method of moments" Chaowei Su, Chi Hou Chan, Ka Fai Chan.

Gemäß Ausführungsbeispielen der vorliegenden Erfindung wird zusätzlich zu einer Mehrzahl von array- oder matrix-förmig angeordneten Pixelsensoren auf einem Halbleitersubstrat jedem Pixelsensor wenigstens ein photonischer Kristall bzw. eine periodische Anordnung von photonischen Kristallen aus einem Schichtstapel aus strukturierten metallischen dielektrischen Schichten zugeordnet und integriert, mit optisch filternden und fokussierenden Eigenschaften. Die strukturierten Metallschichten weisen dazu Struktur- bzw. Mikroelemente auf, deren Abmessungen und Abstände zueinander in der Größenordnung des jeweiligen vorbestimmten Wellenlängenbereichs liegen, für den die zugeordnete integrierte spektrale Filterstruktur in Form wenigstens eines photonischen Kristalls ausgebildet ist. Die Mikroelemente der Metallschichten sind dreidimensional periodisch angeordnet. Gemäß Ausführungsbeispielen sind benachbarte Mikroelemente benachbarter Metallschichten für einen vorbestimmten Wellenlängenbereich identisch ausgebildet und liegen auf einer gemeinsamen optischen Achse. Mikroelemente können gemäß Ausführungsbeispielen Mikroöffnungen mit Abmessungen und Abständen in dem jeweils vorgesehenen Transmissionswellenlängenbereich sein. Gemäß Ausführungsbeispielen umfassen die Mikroelemente sogenannte Split-Ring-Resonatoren mit Abmessungen und Abständen in dem jeweiligen vorbestimmten Transmissionsbereich.

Eine auf einer einem Pixelsensor bzw. einer Photodiode abgewandten Seite des wenigstens einen photonischen Kristalls einer spektralen Filterstruktur einfallende elektromagnetische Strahlung wird durch die auf den jeweils vorbestimmten Wellenlängenbereich abgestimmte dreidimensionale periodische Struktur des als Filterstruktur wirkenden wenigstens einen photonischen Kristalls gefiltert, so dass in einer Nähe des Pixelsensors nur noch elektromagnetische Strahlung des vorbestimmten Wellenlängenbereichs empfangbar ist. Das heißt, der Pixelsensor ist in einem Feldkonzentrationsbereich (quasi ein Brennpunktbereich, wenn man den photonischen Kristall als Linse betrachten würde) der Filterstruktur für die elektromagnetische Strahlung angeordnet. Durch die fokussierende Wirkung der Filterstruktur bzw. des wenigstens einen photonischen Kristalls wird in der Nähe des Pixelsensors das elektromagnetische Feld des vorbestimmten Wellenlängenbereichs konzentriert.

Um die spektral selektierende Wirkung einer spektralen Filterstruktur gemäß Ausführungsbeispielen zu verbessern, kann zwischen einem Pixelsensor und der Filterstruktur mit dem wenigstens einen photonischen Kristall eine Metallschicht mit einer Öffnung angeordnet werden. Dabei befindet sich der Mittelpunkt der Öffnung, welcher insbesondere eine kreisförmige Öffnung sein kann, vorzugsweise auf der optischen Achse der Filterstruktur (Mikrolinse auf Basis photonischer Kristalle) nahe dem Feldkonzentrationsbereich. Gemäß Ausführungsbeispielen ist der Abstand zwischen den Pixelsensoren und den als spektrale Filterstrukturen wirkenden photonischen Kristallen kleiner als 20 µm und bevorzugt kleiner als 8 µm. Bei 0,18 µm-CMOS-Prozessen ist der Abstand zwischen einem Pixelsensor und einer spektralen Filterstruktur kleiner als 2 µm.

Aus einer Mehrzahl von als optische Sensoren wirkenden integrierten Sensorelementen kann ein Multispektralsensor aufgebaut werden, der beliebige Spektrallinien gleichzeitig detektieren kann, indem eine Mehrzahl von Sensorelementen aus spektralen Filterstrukturen mit photonischen Kristallen und Pixelsensoren in einer Ebene benachbart zueinander integriert wird. Dabei entsteht ein Array bzw. eine Matrix aus Sensorelementen mit photonischen Kristallen. Dabei können die photonischen Kristalle der einzelnen Sensorelemente auf unterschiedliche Wellenlängenbereiche eingestellt werden. Für einen Multispektralsensor werden benachbarte Sensorelemente auf Licht unterschiedlicher Wellenlänge eingestellt.

Gemäß einem weiteren Ausführungsbeispiel der vorliegenden Erfindung ist bei den Sensorelementen eines Multispektralsensors jeweils ein Pixelsensor gemeinsam mit einem Schichtstapel aus dielektrischen Schichten und strukturierten Metallschichten auf ein Substrat integriert, wobei die strukturierten Metallschichten eine Zonenplattenstruktur aufweisen, wie z.B. ein Array von Zonenplatten, die einem Pixelsensor zugeordnet sind.

Eine Zonenplatte weist eine fokussierende Wirkung auf. Aus der Theorie der Zonenplatte folgt, dass bei einem entsprechenden Verhältnis von Radien von transparenten und nichttransparenten Zonen in einem bestimmten Abstand von der Zoneplatte für eine vorbestimmte Wellenlänge bzw. einen vorbestimmten Wellenlängenbereich eine Konzentration der elektromagnetischen Strahlung bzw. des Lichts ähnlich einem Brennpunkt entsteht. Ein an dieser Stelle platzierter Pixelsensor, beispielsweise in Form einer Photodiode, kann nun von einer mit Zonenplattenstruktur strukturierten Metallschicht so abgedeckt werden, dass nur die elektromagnetische Strahlung bzw. das Licht der gewünschten Wellenlänge λ_{des} oder des gewünschten Wellenlängenbereichs zumindest näherungsweise verlustfrei auf dem Pixelsensor trifft, während andere Wellenlängen herausgefiltert werden.

Durch eine optionale, weitere strukturierte Metallschicht, beispielsweise mit einer Öffnung, zwischen der mit Zonenplattenstruktur strukturierten Metallschicht und dem Pixelsensor kann eine spektrale Trennung gegenüber Ausführungsbeispielen ohne diese weitere Metallschicht nochmals verbessert werden.

Eine auf einer dem Pixelsensor bzw. der Photodiode abgewandten Seite der mit Zonenplattenstruktur strukturierten Metallschicht einfallende elektromagnetische Strahlung wird durch die auf den vorbestimmten Wellenlängenbereich abgestimmte Zonenplattenstruktur gefiltert, so dass in einer Nähe des Pixelsensors nur noch elektromagnetische Strahlung des vorbestimmten Wellenlängenbereichs empfangbar ist. Das heißt der Pixelsensor ist in einem Feldkonzentrationsbereich - im Folgenden auch manchmal als Brennpunktbereich bezeichnet - der Zonenplatte angeordnet. Durch die fokussierende Wirkung der Zonenplatte wird in der Nähe des Pixelsensors das elektromagnetische Feld des vorbestimmten Wellenlängenbereichs konzentriert.

Gemäß Ausführungsbeispielen ist der Abstand zwischen dem Pixelsensor und der nächstgelegenen mit Zonenplattenstruktur strukturierten Metallschicht eines Sensorelements kleiner als 20 µm oder liegt zwischen 6 und 10 µm.

Aus einer Mehrzahl derartiger Sensorelemente kann beispielsweise ein integrierter Multispektralsensor aufgebaut werden, indem eine Mehrzahl von Sensorelementen mit Zonenplatten und Pixelsensoren in einer Ebene benachbart zueinander integriert werden. Dabei können einzelnen Zonenplatten aus dem Array der einzelnen Sensorelemente auf unterschiedliche Wellenlängenbereiche eingestellt werden.

Gemäß einem weiteren Ausführungsbeispiel der vorliegenden Erfindung wird ein einzelnes Sensorelement des integrierten Multispektralsensors bzw. Spektrometers aus einem Pixelsensor und einer den Pixelsensor abdeckenden Metallstruktur beispielsweise einer oder mehrerer strukturierten Metallschichten gebildet, die so strukturiert sind, dass sich für einen vorbestimmten Wellenlängenbereich bzw. eine vorbestimmte Wellenlänge ein Plasmon-Polariton-Resonanz-Effekt ausbilden kann. Durch eine Sub-Wellenlängen-Öffnung in der strukturierten Metallschicht kann sich für die vorbestimmte Wellenlänge aufgrund des Plasmon-Polariton-Resonanz-Effekts in der Nähe des Pixelsensors eine elektromagnetische Feldkonzentration ausbilden, die dann von dem Pixelsensor detektiert werden kann.

Der Plasmon-Polariton-Resonanz-Effekt führt zu einer sogenannten außergewöhnlichen optischen Übertragung, die durch Schlitze oder Löcher in Metallen stattfinden kann, die schneller als eine Wellenlänge des vordefinierten Wellenlängenbereichs bzw. die vordefinierten Resonanzwellenlänge sind. Wenn elektromagnetische Strahlung außerhalb des vordefinierten Wellenlängenbereichs, d.h. mit einer anderen Wellenlänge als die vordefinierte Resonanzwellenlänge, auf eine solche strukturierte Metallschicht trifft, breitet sie sich jenseits einer zweiten Seite der strukturierten Metallschicht lediglich an einer Sub-Wellenlängen-Öffnung aus, als wäre sie dort isotropisch gebeugt worden, d.h. sie streut gleichmäßig in alle Richtungen. Der größte Teil aber wird auf der ersten Seite am Metall zurückreflektiert bzw. gestreut. Wenn die Sub-Wellenlängen-Öffnung auf der ersten Seite der strukturierten Metallschicht jedoch beispielsweise von periodischen Furchen bzw. Rillen umgeben ist, deren Abmessungen auf den vordefinierten Wellenlängenbereich abgestimmt sind, breitet sich ausgehend von der Sub-Wellenlängen-Öffnung jenseits der zweiten Seite der strukturierten Metallschicht für elektromagnetische Strahlung des vordefinierten Wellenlängenbereichs gerichtete stark isotropische elektromagnetische Strahlung aus.

Dieses Phänomen rührt von sogenannter Oberflächenplasmonenresonanz her. Ein Oberflächenplasmon ist eine Dichteschwankung von Ladungsträgern an der Grenze von Halbleitern oder Metallen zu dielektrischen Medien und ist beispielsweise eine von vielen Interaktionen zwischen Licht und einer metallischen Oberfläche.

Gemäß Ausführungsbeispielen weist das Metall der Metallstruktur zusammen mit einem umgebenden Dielektrikum eine effektive negative Dielektrizitätskonstante auf. Negative effektive Dielektrizitätskonstanten bei Frequenzen von elektromagnetischer Strahlung im optischen Spektralbereich weisen beispielsweise Aluminium (Al), Gold (Au), Silber (Ag) und Kupfer (Cu) auf.

Eine Metallstruktur weist beispielsweise eine strukturierte Metallschicht mit einer Öffnung mit Sub-Wellenlängen-Abmessungen, im Folgenden auch als Sub-Wellenlängen-Öffnung bezeichnet, und um die Sub-Wellenlängen-Öffnung periodisch angeordnete rotationssymmetrische oder parallele Rillen bzw. entsprechende Vorsprünge bzw. Erhöhungen auf, die derart angeordnet in einem Dielektrikum eingebettet sind, um für den vorbestimmten Wellenlängenbereich in der strukturierten Metallschicht den Oberflächen-Plasmon-Polariton-Resonanz-Effekt zu erzeugen. Dabei ist eine Sub-Wellenlängen-Öffnung eine Öffnung mit einer Breite bzw. einem Durchmesser kleiner als eine Wellenlänge des vordefinierten Wellenlängenbereichs bzw. die Resonanzwellenlänge.

Gemäß Ausführungsformen kann die Sub-Wellenlängen-Öffnung rotationssymmetrisch bzw. kreisförmig oder schlitzförmig ausgebildet sein. Ein Durchmesser bzw. eine Breite der Sub-Wellenlängen-Öffnung ist dabei kleiner als die Resonanzwellenlänge. Neben einer schlitzförmigen Sub-Wellenlängen-Öffnung sind periodisch parallele Rillen in der strukturierten Metallschicht angeordnet, wobei Abstände und Abmessungen der Rillen geeignet sind, um für den vorbestimmten Wellenlängenbereich den Oberflächen-Plasmon-Polariton-Effekt zu erzeugen. Um eine kreisförmige Sub-Wellenlängen-Öffnung sind periodisch ringförmige Rillen in der strukturierten Metallschicht angeordnet, wobei Abstände und Abmessungen der ringförmigen Rillen geeignet sind, um für den vorbestimmten Wellenlängenbereich den Oberflächen-Plasmon-Polariton-Effekt zu erzeugen.

Eine weitere Möglichkeit, die Metallschicht geeignet zu strukturieren, besteht darin, einen eindimensionalen oder zweidimensionalen Array aus periodisch angeordneten Sub-Wellenlängen-Öffnungen in die Metallschicht einzubringen.

Aus einer Mehrzahl von Sensorelementen gemäß Ausführungsbeispielen der vorliegenden Erfindung kann ein Multispektralsensor aufgebaut werden, indem die Mehrzahl von Sensorelementen in einer Ebene benachbart zueinander integriert wird. Dabei können die Metallschichtstrukturen der einzelnen Sensorelemente auf unterschiedliche Wellenlängenbereiche eingestellt werden.

Mit Ausführungsbeispielen der vorliegenden Erfindung ist es möglich, einen Multispektralsensor aufzubauen, der beliebige Spektrallinien gleichzeitig detektieren kann, ohne dass dazu eine Beschichtung des Sensors bzw. des Sensorchips erforderlich ist. Der Multispektralsensor kann in allen CMOS-Prozesson integriert werden, die eine minimale Strukturgröße von 0,18 µm oder kleiner aufweisen. Für die Erkennung von Licht bei größeren Wellenlängen, z.B. im nahen Infrarot-Bereich (800 nm bis 1100 nm) kann der Multispektralsensor auch mit größeren Strukturen gefertigt werden, solange die Strukturgröße nicht größer ist als die halbe Wellenlänge des zu messenden Lichts.

Ein durch das erfindungsgemäße Konzept realisierter Multispektralsensor bzw. Spektrometer ist aus einer Photodiodenzeile oder einem zweidimensionalen Photodiodenarray aufgebaut. Oberhalb einer jeden Photodiode wird ein entsprechender schmalbandiger Filter realisiert, der auf Basis von strukturierten Metall- und/oder Dielektrikumsschichten gebildet wird. Dabei sind die Strukturgrößen im Sub-Lambda-Bereich (bezogen auf die zu detektierenden Wellenlängen). Die gesamte Filteranordnung deckt einen bestimmten Spektralbereich ab, so dass das Photodiodenarray mit den Filtern die gleiche Wirkung hat wie ein dispersives Element (Prisma oder Gitter) in der Spektroskopie.

Zum Aufbau des Multispektralsensors bzw. Spektrometers wird ein Sensorchip verwendet, der mit einer Standard-CMOS-Technologie mit genügend kleiner Strukturgröße hergestellt wurde. Der Sensorchip ist als Array von Einzelsensoren aufgebaut. Die einzelnen Sensorelemente bzw. die darüber liegenden Filterschichten sind so ausgeführt, dass sie jeweils eine Bandpasscharakteristik haben. Die Filter sind dabei nach einer der oben beschriebenen Struktur realisiert (photonischer Kristall, Zonenplatten, Plasmon-Polariton-Resonanz-Effekt). Mit einer Vielzahl solcher Elemente wird eine optische Filterbank mit darunter liegenden Detektoren aufgebaut.

Ein Spektrometer kann gemäß Ausführungsbeispielen mit oder ohne einem zusätzlichen optischen System vor dem Empfänger realisiert werden. Die einzelnen Sensorelemente können so ausgelegt werden, dass sie eine fokussierende Wirkung haben, so dass der Multispektralsensor nur auf einen bestimmten Empfangs-Raumwinkel empfindlich wird. Gemäß Ausführungsbeispielen werden die Sensorelemente so angeordnet, dass der Multispektralsensor entweder mit Einkoppeloptik oder mit einer optischen Faser gut ausgeleuchtet werden kann. Die Geometrie der Anordnung kann beim Chip-Design frei definiert werden. Der Multispektralsensor ist daher in der Lage, viele Spektrallinien gleichzeitig zu erfassen und zu detektieren. Gemäß Ausführungsbeispielen kann auch noch an jedes Pixel on-Chip eine analoge oder digitale Signalverarbeitungsschaltung mit integriert werden.

Ausführungsbeispiele der vorliegenden Erfindung ermöglichen die Realisierung eines Spektrometers, das die Funktionen der spektralen Trennung, der Lichtdetektion und der Bündelung des Lichts sämtlich auf einem Chip vereint. Dabei können Ausführungsbeispiele derart aufgebaut werden, dass ein Spektrometer nicht oder nur unwesentlich größer als der zugrunde liegende Multispektral-Detektorchip ist.

Ein Multispektralsensor bzw. Spektrometer gemäß Ausführungsbeispielen der vorliegenden Erfindung kann ohne externe Eintrittsoptik oder Strahlkollimation auskommen und in einem Raumwinkel das entsprechende Spektrum messen.

Integrierte Multispektralsensoren bzw. Spektrometer gemäß Ausführungsbeispielen der vorliegenden Erfindung können so ausgelegt werden, dass mehrere Spektralbereiche beliebig definiert und auf einem Chip gemessen werden können, auch mit verschiedenen spektralen Auflösungen. Die einzelnen Spektralkanäle können dabei eine sehr kleine spektrale Breite haben, wesentlich kleiner als beispielsweise bei einem RGB-Sensor auf einem CMOS-Chip. Eine derartig schmale spektrale Breite kann ansonsten nur mit einem teuren Interferenz-Filter erreicht werden, noch dazu muss dann eine aufwendige Justierung des Filters zum Sensor vorgenommen werden.

Ausführungsbeispiele ermöglichen also den Aufbau eines Chip-Size-Spektrometers, das in CMOS-Technologie kostengünstig und in großen Stückzahlen hergestellt werden kann. Dadurch eröffnen sich neue Einsatzmöglichkeiten in der Massenanwendung, die extrem kleine Baugröße und/oder geringe Kosten erfordert. Es ist sogar ein Einweg-Messchip denkbar, der extrem kostengünstig gefertigt werden kann.

Denkbare Anwendungen sind beispielsweise eine Überwachung des Müdigkeitszustandes von Autofahrern durch spektroskopische Messung des Bluts in einem Finger, Multigasanalysen bei der Lebensmittelüberwachung, Erkennung von bestimmten organischen Abweichungen (Gammelfleisch, Pflanzenkrankheiten etc.) und vieles andere mehr. Beispielsweise ermöglichen Ausführungsbeispiele der vorliegenden Erfindung auch den Aufbau einer Multispektralkamera. Bilder, die damit erzeugt werden können, enthalten ein Vielfaches an Spektralinformationen verglichen mit einem Standard-Kamerachip auf RGB-Basis.

Bevorzugte Ausführungsbeispiele der vorliegenden Erfindung werden nachfolgend Bezug nehmend auf die beiliegenden Zeichnungen näher erläutert. Es zeigen:
Fig. 1 eine schematische Darstellung eines Teils eines integrierten multispektralen Bildsensors mit Superpixeln mit einem ersten und einem zweiten Sensorelement gemäß einem Ausführungsbeispiel der vorliegenden Erfindung;
Fig. 2a eine schematische Darstellung eines Aufbaus und einer Funktion eines integrierten Multispektralsensors in Zeilenform gemäß einem Ausführungsbeispiel der vorliegenden Erfindung;
Fig. 2b eine schematische Darstellung eines Aufbaus eines multispektralen Bildsensors mit Zeilendetektor gemäß einem Ausführungsbeispiel der vorliegenden Erfindung;
Fig. 2c eine schematische Seitenansicht eines Systems zur spektralen Untersuchung einer zweidimensionalen Fläche gemäß einem Ausführungsbeispiel der vorliegenden Erfindung;
Fig. 2d eine schematische Seitenansicht eines Systems zur spektralen Untersuchung einer zweidimensionalen Fläche gemäß einem weiteren Ausführungsbeispiel der vorliegenden Erfindung;
Fig. 3 eine schematische Darstellung einer matrix-förmigen Anordnung von Sensorelementen eines Multispektralsensors gemäß einem Ausführungsbeispiel der vorliegenden Erfindung;
Fig. 4a eine schematische Darstellung eines spektral sensitiven Arrays aus 3x3 Pixeln gemäß einem Ausführungsbeispiel der vorliegenden Erfindung;
Fig. 4b eine schematische Darstellung eines Systems zur Bestimmung von dreidimensionalen Bildern mit einem zweidimensionalen Array aus Superpixeln, gemäß einem Ausführungsbeispiel der vorliegenden Erfindung;
Fig. 4c eine schematische Darstellung einer Zeile aus Superpixeln eines 3D-Bildsensors, gemäß einem Ausführungsbeispiel der vorliegenden Erfindung;
Fig. 5 eine schematische Darstellung von Beleuchtungsmöglichkeiten eines Spektrometers gemäß Ausführungsbeispielen der vorliegenden Erfindung;
Fig. 6 eine perspektivische Ansicht eines Sensorelements mit einer Filterstruktur mit einem Array aus photonischen Kristallen und einem Pixelsensor gemäß einem Ausführungsbeispiel der vorliegenden Erfindung;
Fig. 7 eine Draufsicht auf das Sensorelement gemäß Fig. 6;
Fig. 8 eine Seitenansicht eines mit CMOS-Technik gefertigten Schichtstapels aus Pixelsensor, Metallschichten und dielektrischen Schichten gemäß einem Ausführungsbeispiel der vorliegenden Erfindung;
Fig. 9a eine Seitenansicht eines Ausschnitts eines Sensorelements mit wenigstens einem photonischen Kristall gemäß einem Ausführungsbeispiel der vorliegenden Erfindung;
Fig. 9b eine Seitenansicht von drei benachbart integrierten Sensorelementen gemäß Fig. 9a;
Fig. 10a eine Draufsicht auf eine Metallschicht mit Split-Ring-Resonatoren gemäß einem Ausführungsbeispiel der vorliegenden Erfindung;
Fig. 10b eine Draufsicht auf eine Metallschicht mit Split-Ring-Resonatoren und darunter liegender Metallschicht mit Lochöffnung, gemäß einem Ausführungsbeispiel der vorliegenden Erfindung;
Fig. 11a eine Seitenansicht eines Ausschnitts eines Sensorelements mit wenigstens einem photonischen Kristall und zusätzlicher Metallschicht mit Öffnung zwischen photonischem Kristall und Pixelsensor gemäß einem Ausführungsbeispiel der vorliegenden Erfindung;
Fig. 11b eine Seitenansicht von drei benachbart integrierten Pixelelementen gemäß Fig. 11a;
Fig. 12 eine schematische Darstellung einer elektromagnetischen Feldkonzentration in einer Nähe einer mit einer Öffnung versehenden Metallschicht gemäß einem Ausführungsbeispiel der vorliegenden Erfindung;
Fig. 13 eine schematische Seitenansicht von dreidimensionalen Mikroelementen;
Fig. 14 eine schematische perspektivische Darstellung eines Sensorelements mit Zonenplattenstruktur gemäß einem Ausführungsbeispiel der vorliegenden Erfindung;
Fig. 15a eine Seitenansicht eines in CMOS-Technik gefertigten integrierten Sensorelements mit Zonenplattenstruktur gemäß einem Ausführungsbeispiel der vorliegenden Erfindung;
Fig. 15b eine Seitenansicht eines in CMOS-gefertigten integrierten Sensorelements mit Zonenplattenstruktur gemäß einem weiteren Ausführungsbeispiel der vorliegenden Erfindung;
Fig. 16 eine Draufsicht und eine Seitenansicht einer strukturierten Metallschicht mit Zonenplattenstruktur gemäß einem Ausführungsbeispiel der vorliegenden Erfindung;
Fig. 17 eine schematische Darstellung der fokussierenden Wirkungsweise der Zonenplattenstruktur gemäß einem Ausführungsbeispiel der vorliegenden Erfindung;
Fig. 18 eine Seitenansicht eines in CMOS-Technik integrierten Sensorelements mit zwei Zonenplattenstrukturen versehenen Metallschichten gemäß einem weiteren Ausführungsbeispiel der vorliegenden Erfindung;
Fig. 19 eine Seitenansicht eines in CMOS-Technik integrierten Multispektralsensors mit einer Mehrzahl von integrierten Sensorelementen, gemäß einem Ausführungsbeispiel der vorliegenden Erfindung;
Fig. 20a eine Draufsicht einer strukturierten Metallschicht mit mehreren Zonenplattenstrukturen gemäß einem Ausführungsbeispiel der vorliegenden Erfindung;
Fig. 20b eine Seitenansicht eines integrierten Sensorelements mit einer strukturierten Metallschicht gemäß Fig. 20a;
Fig. 21 eine schematische perspektivische Darstellung eines integrierten Sensorelements mit Plasmon-Polariton-Resonanz-Effekt gemäß einem Ausführungsbeispiel der vorliegenden Erfindung;
Fig. 22 eine Schnittansicht einer strukturierten Metallschicht mit Sub-Wellenlängen-Strukturen und einem Pixelsensor gemäß einem Ausführungsbeispiel der vorliegenden Erfindung;
Fig. 23 eine detaillierte Schnittansicht eines Sensorelements mit strukturierter Metallschicht mit Sub-Wellenlängen-Strukturen gemäß einem Ausführungsbeispiel der vorliegenden Erfindung;
Fig. 24 eine perspektivische Darstellung einer strukturierten Metallschicht gemäß einem Ausführungsbeispiel der vorliegenden Erfindung;
Fig. 25 eine perspektivische Darstellung einer strukturierten Metallschicht gemäß einem weiteren Ausführungsbeispiel der vorliegenden Erfindung:
Fig. 26 eine schematische Darstellung zu Erläuterung der Wirkungsweise der strukturierten Metallschicht gemäß einem Ausführungsbeispiel der vorliegenden Erfindung;
Fig. 27 eine schematische Darstellung von transmittierter elektromagnetischer Strahlung für unterschiedliche Wellenlängen;
Fig. 28 eine schematische Drauf- und Seitenansicht eines mehrere Sensorelemente umfassenden Sensors, gemäß einem Ausführungsbeispiel der vorliegenden Erfindung;
Fig. 29 eine schematische Draufsicht einer strukturierten Metallschicht mit einer schlitzförmigen Öffnung gemäß einem Ausführungsbeispiel der vorliegenden Erfindung,
Fig. 30 eine schematische Ansicht einer Metallschicht mit einer zweidimensional periodischen Anordnung von Sub-Wellenlängen-Öffnungen;
Fig. 31 eine schematische Drauf- und Seitenansicht eines verschiedene Sensorelemente umfassenden Multispektralsensors gemäß einem Ausführungsbeispiel der vorliegenden Erfindung;
Fig. 32 eine detaillierte Schnittansicht eines Sensorelements mit zwei strukturierten Metallschichten und einer dazwischen liegenden dielektrischen Schicht mit Sub-Wellenlängen-Strukturen, gemäß einem Ausführungsbeispiel der vorliegenden Erfindung;
Fig. 33 eine schematische Darstellung eines Spektrometers gemäß dem Stand der Technik;
Fig. 34 eine Darstellung eines Chip-size-Spektrometers gemäß dem Stand der Technik;
Fig. 35 eine Darstellung von kreisförmigen Resonatoren zwischen Bragg-Reflektoren zur Erzielung variierender spektraler Transmissionen gemäß dem Stand der Technik;
Fig. 36 eine Darstellung eines Schichtaufbaus eines CMOS-Prozesses mit strukturierten Metallebenen gemäß dem Stand der Technik; und
Fig. 37 eine Seitenansicht eines mit CMOS-Technik gefertigten Schichtstapels aus Pixelsensor und Schichten aus Metall oder polykristallinem Halbleitermaterial gemäß einem weiteren Ausführungsbeispiel der vorliegenden Erfindung.

Bezüglich der nachfolgenden Beschreibung sollte beachtet werden, dass bei den unterschiedlichen Ausführungsbeispielen gleiche oder gleichwirkende Funktionselemente gleiche Bezugszeichen aufweisen und somit die Beschreibungen dieser Funktionselemente in den verschiedenen, im Nachfolgenden dargestellten, Ausführungsbeispielen untereinander austauschbar sind.

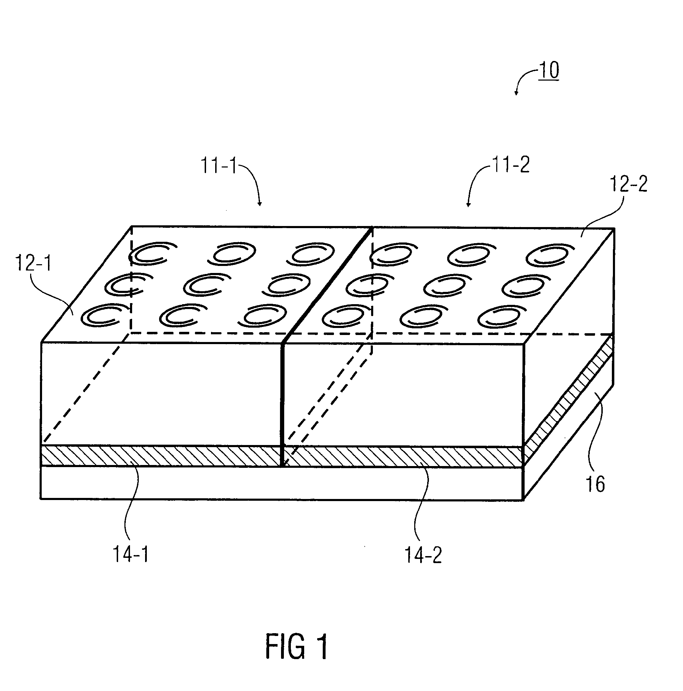

Fig. 1 zeigt schematisch einen Teil eines integrierten Multispektralsensors 10 gemäß einem Ausführungsbeispiel der vorliegenden Erfindung.

Der integrierte Multispektralsensor 10 weist ein erstes Sensorelement 11-1 zur Selektion eines ersten vorbestimmten Wellenlängenbereichs bzw. einer ersten vorbestimmten Wellenlänge λ₁ und ein zweites Sensorelement 11-2 zur Selektion eines zweiten vorbestimmten Wellenlängenbereichs bzw. einer Wellenlänge λ₂ auf. Das erste Sensorelement 11-1 weist einen ersten Pixelsensor 14-1 und eine erste Filterstruktur 12-1 mit wenigstens einer strukturierten Metallschicht auf, die ansprechend auf elektromagnetische Strahlung des ersten Wellenlängenbereichs λ₁ eine höhere Transmission durch die erste Filterstruktur 12-1 zu dem ersten Pixelsensor 14-1 ergibt als für den ersten Wellenlängenbereich umgebende Wellenlängen. Das zweite Sensorelement 11-2 weist einen zweiten Pixelsensor 14-2 und eine zweite Filterstruktur 12-2 mit wenigstens einer strukturierten Metallschicht auf, die ansprechend auf elektromagnetische Strahlung des zweiten Wellenlängenbereichs λ₂ eine höhere Transmission durch die zweite Filterstruktur 12-2 zu dem zweiten Pixelsensor 14-2 ergibt als für den zweiten Längenbereich umgebende Wellenlängen. Das erste Sensorelement 11-1 und das zweite Sensorelement 11-2 sind gemeinsam in einem Halbleitersubstrat 16 integriert.

Wie bereits erläutert wurde, können die erste und zweite Filterstruktur 12-1, 12-2 jeweils als photonischer Kristall ausgebildet sein. Gemäß weiteren Ausführungsbeispielen können die wenigstens eine Metallschicht der ersten und zweiten Filterstruktur 12-1, 12-2 jeweils eine Zonenplattenstruktur aufweisen. Gemäß noch weiteren Ausführungsbeispielen kann die wenigstens eine Metallschicht der ersten und zweiten Filterstruktur 12-1, 12-2 jeweils strukturiert sein, um einen Plasmon-Polariton-Resonanz-Effekt hervorzurufen. Auf die verschiedenen Aufbaumöglichkeiten der Sensorelemente 11-1, 11-2 wird weiter unten noch detailliert eingegangen.

Die Sensorelemente 11-1, 11-2, von denen lediglich exemplarisch in Fig. 1 nur zwei dargestellt sind, können bei Ausführungsbeispielen eindimensional in Zeilenform oder zweidimensional in Matrixform angeordnet werden, um einen multispektralen Bildsensor zu erhalten.

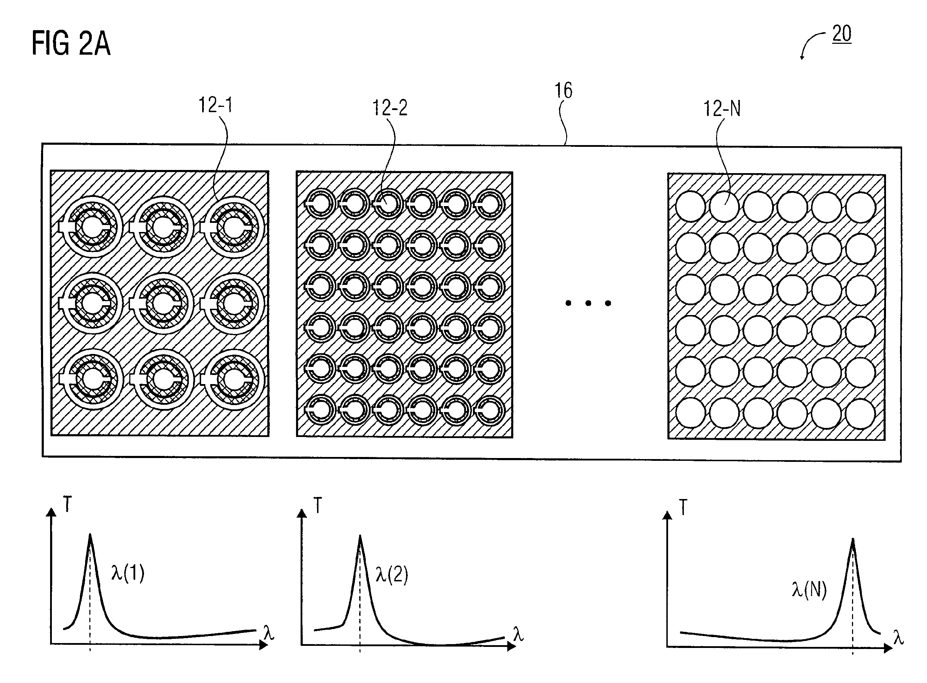

Zunächst zeigt Fig. 2a schematisch eine Draufsicht eines zeilenförmigen Aufbaus eines Multispektralzeilendetektors 20 gemäß einem Ausführungsbeispiel der vorliegenden Erfindung.

Der Multispektralzeilendetektor20 umfasst eine Photodiodenzeile aus N auf dem Halbleitersubstrat 16 integrierten Photodioden (nicht gezeigt), welche sich unterhalb der N dargestellten Filterstrukturen 12-1, 12-2, ...., 12-N befinden. Das heißt, oberhalb jeder Photodiode 14-n (n=1,2,...,N) ist eine (arrayförmige) Filterstruktur 12-n (n=1,2,...,N) angeordnet, die wiederum aus dreidimensional strukturierten metallischen und dielektrischen Schichten aufgebaut ist. Die Photodioden und die Filterstrukturen 12-1, 12-2, ...., 12-N bilden zusammen jeweils Sensorelemente 11-n (n=1,2,...,N). Die Filterstrukturen 12-n (n=1,2,...,N) sind als optische Bandpassfilter dimensioniert, so dass durch jede der N Filterstrukturen 12-n (n=1,2,...,N) eine vordefinierte spektrale Transmission erreicht wird, wie es in Fig. 2a (unten) angedeutet ist. Wie noch detailliert beschrieben wird, hängt die spektrale Transmission lediglich von der geometrischen, dreidimensionalen Form der strukturierten Metall- und/oder Dielektrikumsschichten der Filterstrukturen 12-n (n=1,2,...,N) ab.

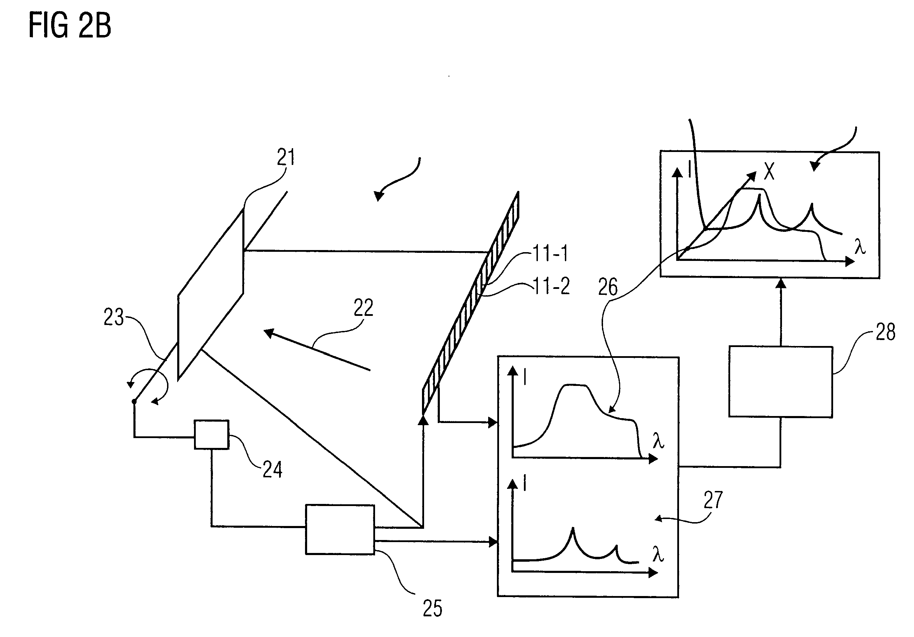

Fig. 2b zeigt schematisch eine Ausführungsform eines multispektralen Bildsensors zur Erfassung eines zweidimensionalen Bildfeldes mit einem Multispektralzeilendetektor 20.

Der multispektrale Bildsensor nach Fig. 2b umfasst ein bewegliches, reflektierendes Bauteil 21, auf welches Lichtstrahlen 22 von einer geometrischen Linie einfallen, deren spektrale Verteilung zu bestimmen ist. Das reflektierende Bauteil 21 kann beispielsweise einen Spiegel oder ein Metall aufweisen. Das reflektierendes Bauteil 21 ist um eine Achse 23 drehbar gelagert. Der Multispektralzeilendetektor 20 aus mehreren Sensorelementen 11-1, 11-2, von denen der Übersichtlichkeit halber lediglich zwei mit Bezugszeichen versehen sind, ist angeordnet, um das durch das bewegliche, reflektierende Bauteil 21 reflektierte Licht von der Linie zu empfangen. Dabei ist der Multispektralzeilendetektor 20 in einer die Drehachse 23 des reflektierenden Bauteils 21 durchlaufenden Ebene angeordnet. Die spektrale Auflösung des multispektralen Bildsensors kann entweder durch die Entfernung des Multispektralzeilendetektors 20 zu dem reflektierenden Bauteil 21, oder durch eine abbildende Optik zwischen dem reflektierenden Bauteil 21 und dem Zeilendetektor 20 eingestellt werden, die hier der Übersichtlichkeit halber nicht gezeigt ist. Handelt es sich bei dem reflektierenden Bauteil 21 beispielsweise um einen Hohlspiegel, so kann auf eine zusätzliche abbildende Optik, z. B. eine Linse, verzichtet werden. Bei einem einfachen Spiegel als reflektierendes Bauteil 21 ist zwischen Spiegel und Multispektralzeilendetektor 20 z. B. noch eine Linse notwendig, um das Licht 22 der geometrischen Linie auf den Multispektralzeilendetektor 20 abzubilden.

Zur Bewegung des beweglichen, reflektierenden Bauteils 21 ist eine geeignete Ansteuerung 24 vorgesehen, die zur Ansteuerung mit dem beweglichen, reflektierenden Bauteil 21 z. B. über eine induktive, kapazitive oder mechanische Kopplung gekoppelt ist. Mit der Ansteuerung 24 auf der einen und dem Multispektralzeilendetektor 20 auf der anderen Seite ist eine Steuereinheit 25 gekoppelt, die die Belichtungszeitpunkte, zu denen der Multispektralzeilendetektor 20 Aufnahmen durchführt, relativ zu der Bewegung des reflektierenden Bauteils 21, steuert. Hierzu erfasst die Ansteuerung 24 (über einen bekannten Zusammenhang zwischen Ansteuerung und Auslenkung oder mittels einer eigens vorgesehenen Erfassungseinrichtung) die augenblickliche Stellung des reflektierenden Bauteils 21 und gibt an die Steuereinheit 25 ein Signal aus, das die augenblickliche Stellung anzeigt. Die Steuereinheit 25 bestimmt ihrerseits die Belichtungszeitpunkte, zu denen der Multispektralzeilendetektor 20 Aufnahmen vornehmen soll, und sendet hierzu Auslösesignale an den Multispektralzeilendetektor 20.

Jedes Sensorelement 11-n (n=1,...,N) erfasst zu einem gegebenen Zeitpunkt einen unterschiedlichen spektralen Bestandteil eines Lichtstrahls von einer Linie einer Fläche, der aufgrund der Auslenkung des reflektierenden Bauteils 21 auf die auf den Multispektralzeilendetektor 20 gespiegelt wird. Trifft Licht ausgehend von einer Linie, die im wesentlichen parallel zum Multispektralzeilendetektor 20 verläuft, in einem geeigneten Einfallswinkel α auf das reflektierende Bauteil 21, so wird dieses durch das reflektierende Bauteil 21 nach dem bekannten physikalischen Gesetz Einfallswinkel = Ausfallswinkel reflektiert. Dadurch, dass sich der Multispektralzeilendetektor 20 im zum Einfallswinkel betragsmäßig gleichen Ausfallswinkel α relativ zum reflektierenden Bauteil 21 befindet, kann der Multispektralzeilendetektor 20 das reflektierte und durch ein optisches System (Hohlspiegel, Linse) auf ihn abgebildete Licht spektral abtasten.

Bezug nehmend auf Fig. 2a wird zur Bestimmung der spektralen Verteilung des Lichts ausgehend von einer geometrischen Linie erfindungsgemäß zunächst eine erste Aufnahme durch den Multispektralzeilendetektor 20 aufgenommen. Jedes Sensorelement 11-n (n=1,...,N) erfasst für diese Aufnahme einen unterschiedlichen spektralen Bestandteil des reflektierten Lichts. Der Multispektralzeilendetektor 20 gibt das Ergebnis der ersten Aufnahme aus, wobei das Ergebnis schematisch bei 26 als ein Graph gezeigt ist, bei dem die Intensität I(λ,x) über der Wellenlänge λ aufgetragen ist und in welchem ein exemplarischer Intensitätsverlauf angenommen ist. Nach der ersten Aufnahme bewegt die Ansteuerung 24 das reflektierende Bauteil 21 in eine andere Stellung. Der Multispektralzeilendetektor 20 nimmt eine zweite Aufnahme vor, die einer zweiten geometrischen Linie entspricht. Das Ergebnis der zweiten Aufnahme bzw. Belichtung ist in einem Graphen 27 schematisch gezeigt, wobei wiederum die Intensität I(λ,x) über der Wellenlänge λ aufgetragen ist. Die beiden Aufnahmen 26 und 27 werden an eine Kombinationseinrichtung 28 weitergeleitet, die sowohl mit dem Multispektralzeilendetektor 20, um von demselben die Intensitätswerte jedes Detektorelements zu jeder Belichtung zu erhalten, als auch über die Steuereinheit 25 mit der Ansteuerung 24, um von einem der beiden Informationen hinsichtlich der Stellung des reflektierenden Bauteils 21 zu den Belichtungszeitpunkten zu erhalten, verbunden ist, und die basierend auf den Aufnahmen 26 und 27 ein Ergebnis liefert, das der Bestimmung der spektralen Verteilung der Lichtstrahlen ausgehend von den zwei geometrischen Linien entspricht. Auf die beschriebene Art und Weise können durch Auslenken des reflektierenden Bauteils 21 Lichtstrahlen beliebig vieler geometrischen Linien spektral zerlegt werden. Die Größe eines Winkelinkrements zwischen zwei diskreten Auslenkwinkeln hängt dabei von der gewünschten geometrischen Auflösung ab.

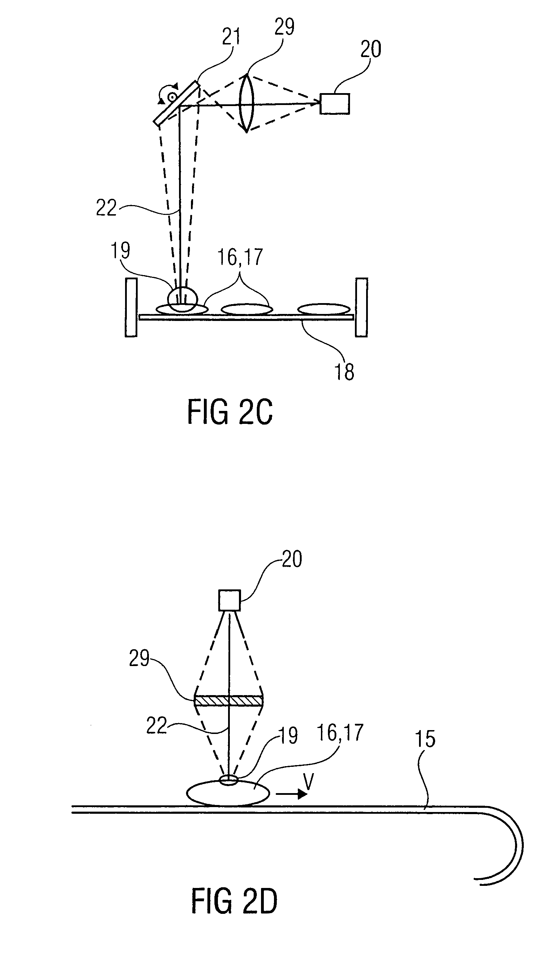

Bezug nehmend auf die Fig. 2c und d werden im Folgenden Ausführungsbeispiele von erfindungsgemäßen Systemen zur Untersuchung einer geometrischen Fläche anhand eines möglichen Anwendungsbeispiels beschrieben. Die Anordnung sind schematisch in Seitenansicht dargestellt.

An dieser Stelle soll erwähnt werden, dass es sich bei den beschriebenen zu untersuchenden geometrischen Linien und Flächen in der Regel um Projektionslinien und -flächen handelt. D.h. es werden nicht die Linien und Flächen an sich untersucht, sondern Objekte, die zumindest teilweise auf diese Linien und/oder Flächen abgebildet werden.

Die Fig. 2c zeigt voneinander verschiedene zu inspizierende Objekte 16 und 17, die sich auf einer Fläche 18 befinden. Ein linearer Bereich 19 wird von einer Lichtquelle (nicht gezeigt) bestrahlt. Von verschiedenen Punkten des linearen Bereichs 19 reflektierte Lichtstrahlen 22 treffen auf ein drehbar gelagertes reflektierendes Element 21, an dem sie zu einer abbildenden Optik 29 hin reflektiert werden. Zur Detektion der spektralen Eigenschaften des reflektierten Lichts ist in der Bildebene der abbildenden Optik 29 der Multispektralzeilendetektor 20 angebracht. Sowohl die Belichtungszeitpunkte des Multispektralzeilendetektors 20 als auch die Bewegung des reflektierenden Elements 21 werden durch eine mit dem Multispektralzeilendetektor 20 und dem reflektierenden Element 21 verbundene Steuereinrichtung (nicht gezeigt) gesteuert. Durch Auslenkung des reflektierenden Elements 21 um seine Drehachse 23 können mehrere Linien 19 spektral erfasst werden, um die spektralen Eigenschaften der Fläche 18 bzw. der Objekte 16, 17 zu bestimmen. D.h. das drehbar aufgehängte reflektierenden Element 21 entspricht einer Einrichtung zum Bewirken, dass eine auf den Multispektralzeilendetektor 20 abgebildete Linie das zweidimensionale Bildfeld 18 durchläuft.

Die Fig. 2d zeigt ein weiteres Ausführungsbeispiel bei dem die Einrichtung zum Bewirken, dass eine auf den Zeilensensor 20 abgebildete Linie das zweidimensionale Bildfeld durchläuft, ein Förderband 15 ist.

Die Fig. 2d zeigt voneinander verschiedene zu inspizierende Objekte 16 und 17, die sich auf einer Beförderungseinrichtung 15 mit einer Geschwindigkeit v bewegen. Ein linearer Bereich 19 wird von einer Lichtquelle (nicht gezeigt) bestrahlt. Von verschiedenen Punkten des linearen Bereichs 19 reflektierte Lichtstrahlen 22 treffen auf eine abbildende Optik 29, z.B. eine Linse. Zur Detektion der spektralen Eigenschaften des von der Linie 19 ausgehenden Lichts ist in der Bildebene der abbildenden Optik 29 ein Multispektralzeilendetektor 20 angebracht. Die Belichtungszeitpunkte des Multispektralzeilendetektors 20 werden durch eine mit dem Multispektralzeilendetektor 20 verbundene Steuereinrichtung (nicht gezeigt) gesteuert.

Im Hinblick auf weitere Anwendungsmöglichkeiten ist es auch denkbar, dass der Multispektralzeilendetektor 20 selbst relativ zu einer zu analysierenden Fläche bewegt wird. Denkbar sind beispielsweise Anwendungen in Satelliten oder anderen Flugkörpern zur Erdbeobachtung, bei denen beispielsweise eine Landschaft auf optische Eigenarten, wie z.B. charakteristische Pflanzeneigenschaften (z.B. die Farbe der Blüten), hin untersucht werden soll. Auch hier wird durch den Scanvorgang eines eindimensionalen Bereichs und die senkrecht dazu erfolgende Relativbewegung mit langsamer Relativgeschwindigkeit letztendlich die spektrale Analyse einer zweidimensionalen Oberfläche erreicht.

Anwendungsbeispiele der Form mit festem Multispektralzeilendetektor 20 und bewegten Gütern sind in der Recyclingindustrie bei der Selektion von Kunststoff- oder Papierabfällen, in der Landwirtschaft bei der Selektion von Erntegut (z.B. Kartoffeln/Steine) oder in der Lebensmittel- bzw. Pharmabranche zahlreich zu finden. Weiterhin ist eine Überwachung von Fließgewässern denkbar, indem der Multispektralzeilendetektor 20 beispielsweise an einer Brücke oberhalb des Gewässers angebracht wird. Somit kann ein unter der Brücke fließender Fluss überwacht werden auf Schiffe, Ölteppiche, etc..

Die Inspektion kann dabei mit oder ohne zusätzliche Lichtquelle erfolgen. Entsprechend können die spektroskopischen Verfahren der Emissions-, Reflexions-, Absorptionsmessung ,Fluoreszenz-Spektroskopie oder auch sogenannte Raman-Spektroskopie und/oder artverwandte Verfahren eingesetzt werden. Wesentlich ist, dass von den an dem Multispektralzeilendetektor 20 auftreffenden optischen Signalen bestimmte Wellenlängen oder Wellenlängenbereiche bewertet werden. Generell ist es möglich, die Abbildungsqualität eines abzubildenden linearen Bereichs auf den Multispektralzeilendetektor 20 zu erhöhen, indem man z.B. zwischen jeweils zwei aufeinanderfolgenden Abtastzeitpunkten des Multispektralzeilendetektor 20 das Eintreten von Lichtstrahlen in den Multispektralzeilendetektor 20 verhindert. Dies kann beispielsweise mit der Verwendung eines optischen Shutters geschehen.

An dieser Stelle soll noch hervorgehoben werden, dass ein multispektraler Bildsensor zur Erfassung eines zweidimensionalen Bildfeldes z.B. auch einfach mit einem zu zwei orthogonalen Achsen drehbar aufgehängtem Superpixel zum spektralen Erfassen eines Punkts eines zweidimensionalen Bildfelds realisiert werden könnte. Dabei weist das zu den zwei zueinander orthogonalen Achsen drehbar aufgehängte, integrierte Superpixel wenigstens fünf Sensorelemente 11 auf mit jeweils einem Pixelsensor 14 und einer Filterstruktur 12 mit wenigstens einer strukturierten Metallschicht, die ansprechend auf elektromagnetische Strahlung eines Wellenlängenbereichs eine höhere Transmission durch die Filterstruktur zu dem Pixelsensor 14 ergibt, als für den Wellenlängenbereich umgebende Wellenlängen. Jedem Sensorelement 11 des Superpixels ist dabei ein anderer Wellenlängenbereich zugeordnet und die Sensorelemente 11 sind gemeinsam auf einem Halbleitersubstrat 16 integriert. Mit einem Stellmotor könnte das Superpixel jeweils um seine orthogonalen Drehachsen geschwenkt werden. Ferner umfasst ein derartiger multispektraler Bildsensor eine Einrichtung zum Abbilden des Punkts aus dem zweidimensionalen Bildfeld auf das Superpixel, beispielsweise in Form einer Optik (z.B. Linse). In dem Stellmotor kann eine Einrichtung zum Bewirken, dass ein auf das Superpixel abgebildeter Punkt das zweidimensionale Bildfeld durchläuft, gesehen werden. Genauso könnte das Superpixel auch starr durch eine Art Scanvorgang (z.B. zeilenweise) über das zweidimensionale Bildfeld bewegt werden, um spektrale Information des Bildfelds abzutasten.

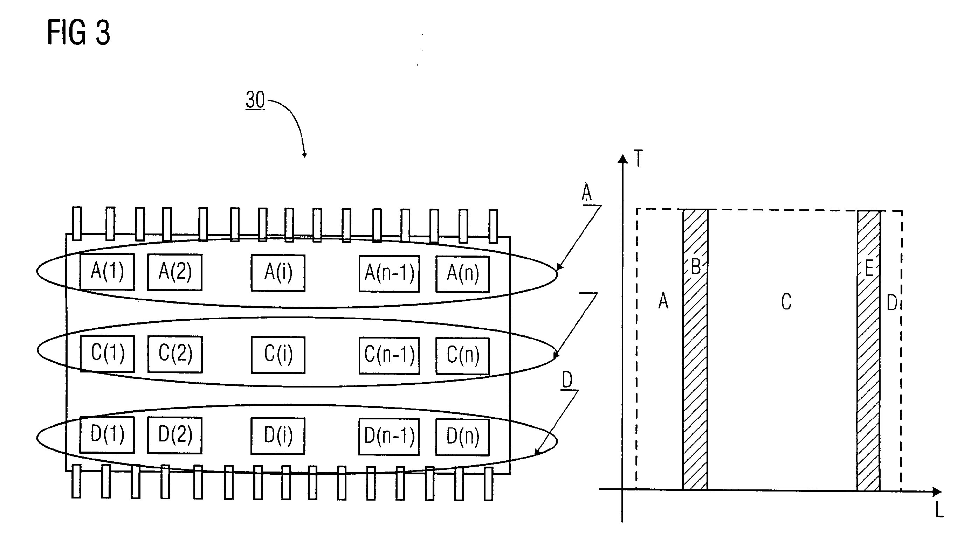

Nachdem anhand der Fig. 2a-d Anwendungsmöglichkeiten eines eindimensionalen Multispektralzeilendetektors beschrieben wurden, wird im Nachfolgenden näher auf zweidimensional angeordnete Multispektralsensoren eingegangen. Dazu ist ein weiteres Ausführungsbeispiel eines multispektralen Bildsensors 30 in Fig. 3 schematisch dargestellt.

Mit einer Matrixanordnung von Sensorelementen können verschiedene Spektralbereiche mit unterschiedlicher spektraler Auflösung abgetastet werden. Im Beispiel von Fig. 3 ist die Zeile mit den Sensorelementen von A(1) bis A(n) für einen Spektralbereich **A** gedacht, die Zeile mit den Sensorelementen C(1) bis C(n) ist für Spektralbereich **C** gedacht. Eine spektrale Auflösung im Bereich der Sensorelemente A(1) bis A(n) ist beispielsweise höher als die spektrale Auflösung im Bereich der Sensorelemente C(1) bis C(n). In den Bereichen D und E sind keine Sensorelemente angeordnet. Dort wird keine Messung gemacht, weil beispielsweise in diesem Bereich kein Licht auf den multispektralen Bildsensor 30 trifft. Der multispektrale Bildsensor 30 bietet also die Möglichkeit, bereits beim Design zu definieren, welche Bereiche mit welcher Auflösung gemessen werden sollen. Es kann für industrielle Anwendungen von Bedeutung sein, bei denen einzelnen spektrale Linien oder Bereiche kontrolliert werden müssen. Die Größe von Mikroelementen der Filterstrukturen bzw. der sich darunter befindlichen Photodioden spielt dabei eine ähnliche Rolle wie der Eingangsspalt bei einem herkömmlichen Spektrometer.

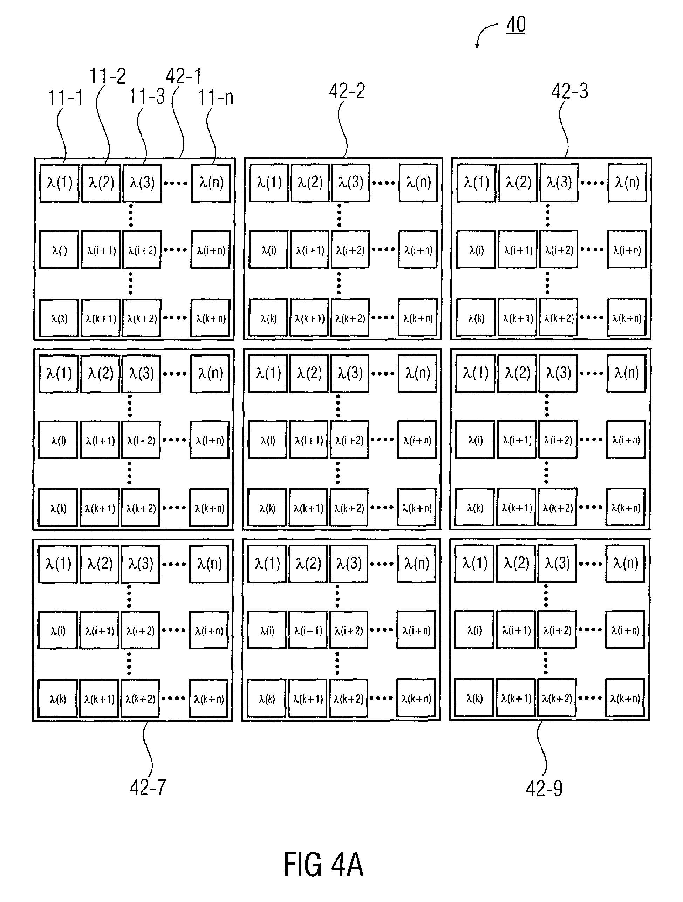

Eine weitere Alternative zur Anordnung der Sensorelemente ergibt sich dadurch, dass ein zweidimensionales Pixelarray aufgebaut wird, wobei jedes Pixel bzw. Superpixel für sich aus einer Matrix von wellenlängenselektiven Sensorelementen besteht, so wie es beispielhaft in Fig. 4a gezeigt ist.

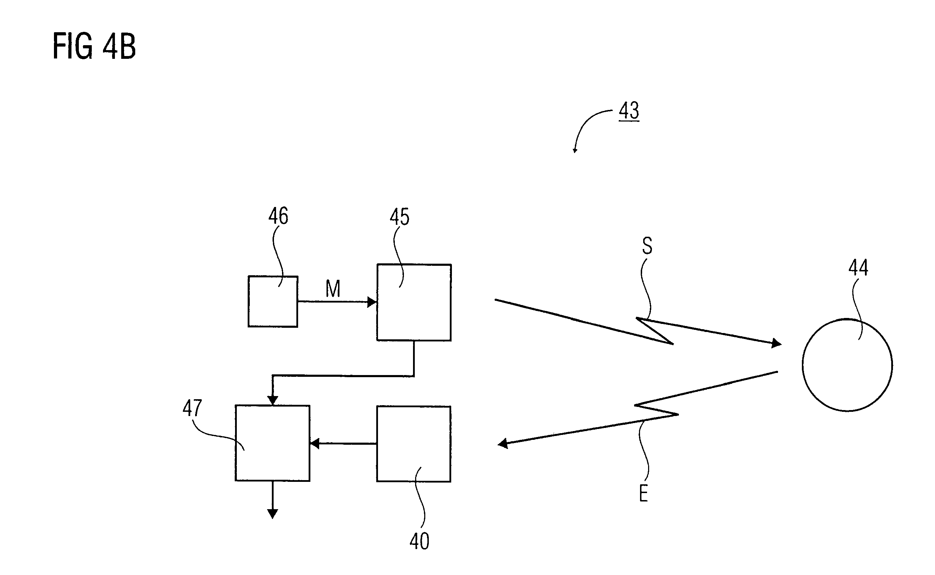

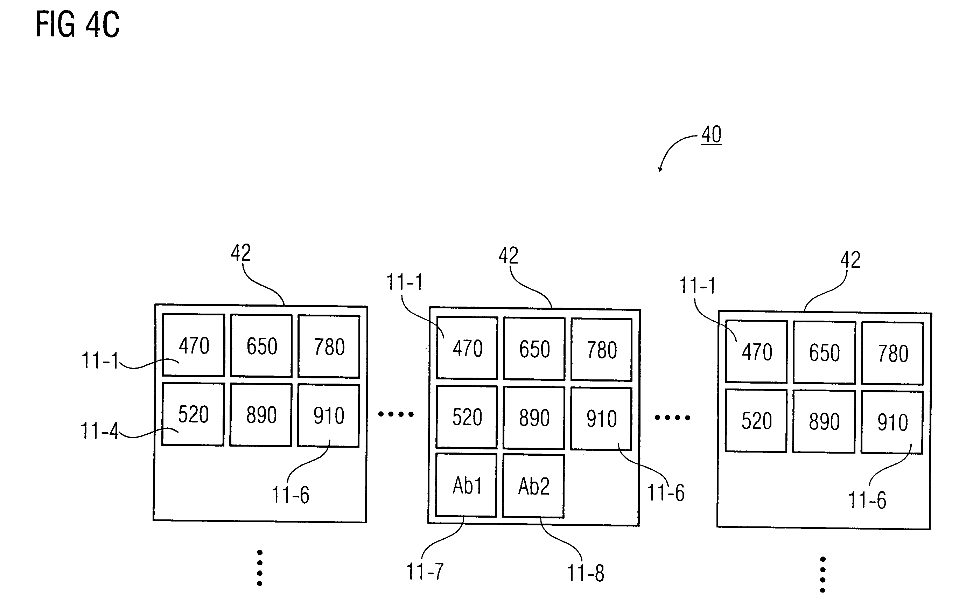

Dadurch kann ein beispielsweise Kamerachip realisiert werden, dessen einzelne Pixel bzw. Superpixel vielfältige spektrale Informationen enthalten können. Dementsprechend können mit der in Fig. 4 gezeigten Anordnung vielfältige Multispektralbilder geliefert werden, die um ein Vielfaches mehr an Informationen enthalten als ein Standard-Kamerachip mit RGB-Sensoren bzw. Bayer-Maske. Die in Fig. 4a schematisch gezeigte Anordnung 40 kann beispielsweise als bildgebender Fingerprint-Sensor angewendet werden, der zu jedem Superpixel 42-1 bis 42-9 die zugehörige Spektralinformation liefert. Damit kann z.B. ein grüner Ball (aus PVC) in einer grünen Wiese leicht erkannt werden, weil sich das Spektrum von PVC deutlich von dem von Chlorophyll unterscheidet, und selbst im grünen Spektralbereich unterschiedliche Linien aufweist. Dies ist mit einem herkömmlichen Farbsensor so nicht möglich, weil dort die verwendeten spektralen Filter eine viel zu breite Bandpasscharakteristik aufweisen. Bei herkömmlichen Farbsensoren kann nur mit Bildverarbeitungsalgorithmen versucht werden, die oben genannte Erkennung zu bewerkstelligen, dies ist aber wesentlich aufwendiger als gleich im Sensor die relevanten Informationen aufzunehmen.

Mit einem multispektralen Bildsensor 40 mit einem zweidimensionalen Array aus Superpixeln 42 gemäß Fig. 4a kann, gemäß Ausführungsbeispielen der vorliegenden Erfindung, auch ein dreidimensionaler Bildsensor bzw. ein Entfernungsmesssystem realisiert werden. Dazu zeigt Fig. 4b eine schematische Darstellung eines erfindungsgemäßen Entfernungsmesssystems 43 zur Bestimmung von dreidimensionalen Bildern mit einem multispektralen Bildsensor 40 mit einem zweidimensionalen Array aus Superpixeln 42 gemäß Fig. 4a.

Das Entfernungsmesssystem 43 kann, zusätzlich zu zweidimensionalen Bildinformationen, eine Entfernung zwischen dem Entfernungsmesssystem 43 und einem Objekt 44 bestimmen und somit eine dritte Bildinformation (Bildtiefe) bereitstellen. Dazu umfasst das Entfernungsmesssystem 43 eine Quelle bzw. Sendeeinrichtung 45 zum Aussenden eines Sendesignals S in Form von elektromagnetischer Strahlung, insbesondere Licht, während eines Sendezeitintervalls T_{S}. Die Sendeeinrichtung 45 umfasst dabei gemäß Ausführungsbeispielen eine Lichtquelle, z.B. in Form einer LED (LED = Light Emitting Diode), einer IR-LED (IR-LED = Infra-Red LED) oder einer Laserdiode. Die Sendeeinrichtung 45 generiert das Sendesignal S beispielsweise in Form eines frequenzmodulierten Lichtsignals oder in Form von kurzen Lichtpulsen. Zur Steuerung der Modulation des Sendesignals S kann die Entfernungsmessvorrichtung 43 eine Modulationseinrichtung 46 umfassen, welche zwecks Steuerung der Modulation auf die Sendeeinrichtung 45 einwirken kann. Bei der auf das Sendesignal S einwirkenden Modulation kann es sich beispielsweise um eine Amplitudenmodulation des Lichtsignals S handeln. Dabei kann eine Modulationsfrequenz beispielsweise in einem Frequenzbereich von 1 MHz bis 10 GHz liegen, je nach Messgenauigkeitsanforderungen und Messmethode des Entfernungsmesssystems 43. Die Einwirkung erfolgt in der Weise, dass die Modulationseinrichtung 46 ein Modulationssignal M an die Sendeeinrichtung 45 ausgibt, wobei das Modulationssignal M beispielsweise rechteckförmig, sinusförmig oder dreiecksförmig ausgebildet sein kann. Weiterhin umfasst das Entfernungsmesssystem 43 eine Empfangseinrichtung in Form eines erfindungsgemäßen multispektralen Bildsensors 40 zum Empfangen eines Bildsignals bzw. Empfangssignals E, bei dem es sich um einen an dem Bildobjekt 44 reflektierten Anteil des Sendesignals S handelt. Der Empfang des Empfangssignals E findet während eines Empfangszeitintervalls T_{E} statt, welches mit dem Sendezeitintervall T_{S} synchronisiert sein kann, derart, dass Empfangs- und Sendezeitintervall T_{S} entweder zeitlich parallel liegen oder, dass Empfangs- und Sendezeitintervall zeitlich aufeinander folgen. Die Synchronisation von Empfangs- und Sendezeitintervall kann beispielsweise von einer Steuereinrichtung bewerkstelligt werden (nicht gezeigt). Ferner umfasst das Entfernungsmesssystem 43 eine Verarbeitungseinrichtung 47 zum Bestimmen eines 3D-Bildes des Objekts 44 basierend auf einem Ausgangssignal des multispektralen Bildsensors 40. Dabei ist die Verarbeitungseinrichtung 47 ausgebildet, um das 3D-Bild so zu bestimmen, dass das 3D-Bild für eines oder mehrere der Superpixel eine Entfernungsinformation aufweist, die von einem Ausgangssignal wenigstens eines der Sensorelemente 11 der Superpixel 42 abhängt, sowie eine spektrale Verteilung, die von dem Ausgangssignal von wenigstens mehreren der anderen Sensorelemente 11 der Superpixel 42 abhängt. Verarbeitungseinrichtung 47 kann also u.a. eine Entfernung zwischen dem Bildobjekt 44 und dem Entfernungsmesssystem 43 bzw. zwischen dem Bildobjekt 44 und dem multispektralen Bildsensor 40 bestimmen. Die Verarbeitungseinrichtung 47 kann dabei beispielsweise ein PMD (PMD = Photonic Mixer Device) umfassen. PMDs berechnen eine gesuchte Entfernung, in dem sie u.a. einen Vergleich der Phasenlagen des Sendesignals S mit einer Phasenlage des Empfangssignals E durchführen. Theorie und Funktionsprinzip von PMDs sind beispielsweise in "Solid-State Time-of-Flight Range Camera" von Robert Lange und Peter Seitz, IEEE Journal of Quantum Electronics, Vol. 37, No. 3, March 2001 beschrieben.

Vorzugsweise ist das Sendesignal S ein moduliertes Lichtsignal im Infrarotbereich. Dementsprechend weist der multispektrale Bildsensor 40 Superpixel mit jeweils wenigstens fünf Sensorelementen auf, wobei wenigstens ein Pixel bzw. Sensorelement 11, im Folgenden als Demodulator-Sensorelement bezeichnet, eines Superpixels 42 auf die Wellenlänge bzw. den Wellenlängenbereich des Sendesignals S anspricht. Das heißt, die dem Demodulator-Sensorelement zugeordnete Filterstruktur ist ausgelegt, um die Wellenlänge bzw. die Wellenlänge des Sendesignals S durchzulassen und umliegende Wellenlängen herauszufiltern. Bei Ausführungsbeispielen der vorliegenden Erfindung ist also bei einem multispektralen Bildsensor 40 mindestens ein Farbkanal, d.h. ein Pixel 11 eines Superpixels 42, für Abstandsmessungen reserviert, vorzugsweise in einem spektralen Bereich, in dem eine Spektralmessung nicht notwendig ist (z.B. in einem Bereich von 850 nm bis 980 nm). Innerhalb eines Superpixels 42 kann derart ein Abstandsmesskanal realisiert werden, der eine dritte Dimension, d.h. Entfernung, zum aufgenommenen 2D-Bild liefert. Für die Abstandsmessung können mehrere alternative Methoden eingesetzt werden, wie beispielsweise durch die in der Offenlegungsschrift DE 10 04 050 627 A1 beschriebene Methode, durch Triangulation, Interferrometrie oder Laufzeitmessung.

Um die Messgenauigkeit zu erhöhen, oder um andere Entfernungsmessverfahren zu nutzen, können auch mehrere Farbkanäle pro Superpixel 42 für Abstandsmessungen vorgesehen sein, wobei dann jedes der für die Entfernungsmessung vorgesehenen Sensorelemente 11 auf einen unterschiedlichen Wellenlängenbereich unterschiedlicher Sendesignale S abgestimmt ist. Dementsprechend können auch mehrere Lichtquellen mit unterschiedlichen Wellenlängen verwendet werden, um das Bildobjekt 44 auszuleuchten.

Ein Anwendungsbeispiel eines erfindungsgemäßen multispektralen 3D-Bildsensors zur Abstandsmessung besteht beispielsweise in Form einer Fahrer-Assistenz-Kamera.

Fig. 4c zeigt schematisch einen Ausschnitt aus einer Zeile eines 3D-Bildsensors 40, wobei weitere Zeilen ähnlich aufgebaut sind. Es lässt sich erkennen, dass jedes Superpixel 42 sechs Sensorelemente 11-1,..., 11-6 für sechs Spektralkanäle aufweist. Drei im sichtbaren RGB-Bereich (470 µm, 520 µm, 650 µm) und drei im IR-Bereich (780 µm, 890 µm, 910 µm). Beispielsweise hat lediglich jeder fünfte Superpixel 42 noch zwei Zusatzkanäle bzw. Sensorelemente 11-7, 11-8 für eine Abstandsmessung. Für Fahrer-Assistenz-Systeme ist dies ausreichend, um die dritte Dimension, d.h. die Entfernung, zum Bildobjekt zu messen. Nach einer Signalverarbeitung und -auswertung erhält man somit zwei 3D-Bilder, ein 3D-RGB-Bild und ein 3D-IR-Bild. Das 3D-IR-Bild kann besonders bei Nebel oder Nacht hilfreich sein.

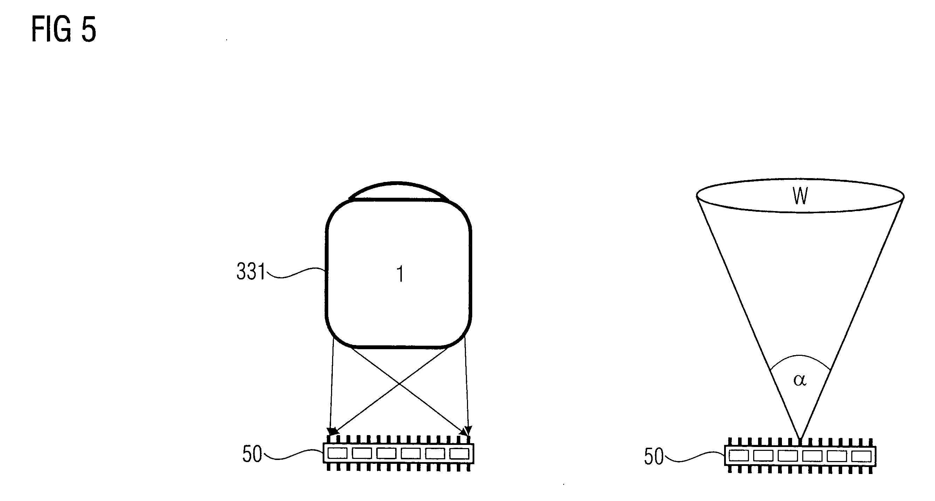

Fig. 5 zeigt exemplarisch zwei Aufbaumöglichkeiten eines Spektrometers mit einem Multispektralsensorchip gemäß Ausführungsbeispielen der vorliegenden Erfindung.

Fig. 5 (links) zeigt einen Aufbau eines Spektrometers aus einem optischen System 331, welches Licht sammelt und auf einen erfindungsgemäßen multispektralen Bildsensor 50 überträgt. Die Empfangsoptik 331 kann beispielsweise ein optisches Modul sein in einem herkömmlichen Spektrometer, oder aber auch nur ein Objektiv, das Umgebungslicht auf den Chip 50 fokussiert.

Eine zweite Möglichkeit ist ein Aufbau ohne optisches System, wie es in Fig. 5 (rechts) gezeigt ist. In diesem Fall sind die Filterstrukturen des Multispektralchips 50 so ausgeführt, dass sie winkelselektiv sind und auch noch eine fokussierende Wirkung aufweisen. Dann empfängt der Chip 50 nur Licht eines vordefinierten Raumwinkelbereichs W, wie es in Fig. 5 (rechts) angedeutet ist.

Nachdem im Vorhergehenden diverse Ausführungsformen von erfindungsgemäßen Multispektralchips und daraus aufgebauten Spektrometern erläutert wurden, soll im Nachfolgenden detailliert auf die Einzelelemente bzw. Sensorelemente eines derartigen Multispektralchips eingegangen werden.

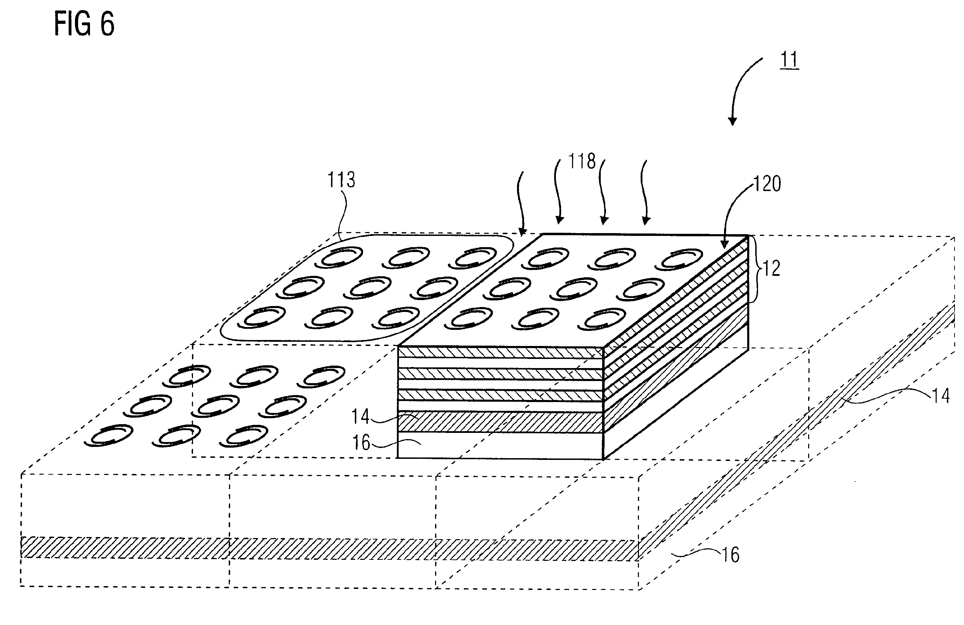

Dazu zeigt Fig. 6 zunächst eine schematische Ansicht eines Sensorelements 11 zur Filterung von elektromagnetischer Strahlung eines vorbestimmten Wellenlängenbereichs, wobei zur Verdeutlichung des Aufbaus des Sensorelements 11 ein Ausschnitt besonders hervorgehoben ist.

Das Sensorelement 11 weist eine Filterstruktur 12 mit wenigstens einem photonischen Kristall bzw. einem Array aus photonischen Kristallen auf und einen Pixelsensor 14, wobei die Filterstruktur 12 und der Pixelsensor 14 gemäß Ausführungsbeispielen derart in einem Halbleitersubstrat 16 integriert sind, so dass der Pixelsensor 14 in einem Feldkonzentrationsbereich der Filterstruktur 12 angeordnet ist.

Wie im Vorhergehenden bereits beschrieben wurde, handelt es sich bei der Filterstruktur 12 gemäß Ausführungsbeispielen um einen photonischen Kristall bzw. um eine periodische Anordnung einer Mehrzahl von photonischen Kristallen, wobei die Filterstruktur 12 bzw. jeder der photonischen Kristalle aus einem Schichtstapel aus dielektrischen Schichten und strukturierten Metallschichten gebildet ist, worauf im Nachfolgenden noch näher eingegangen wird.

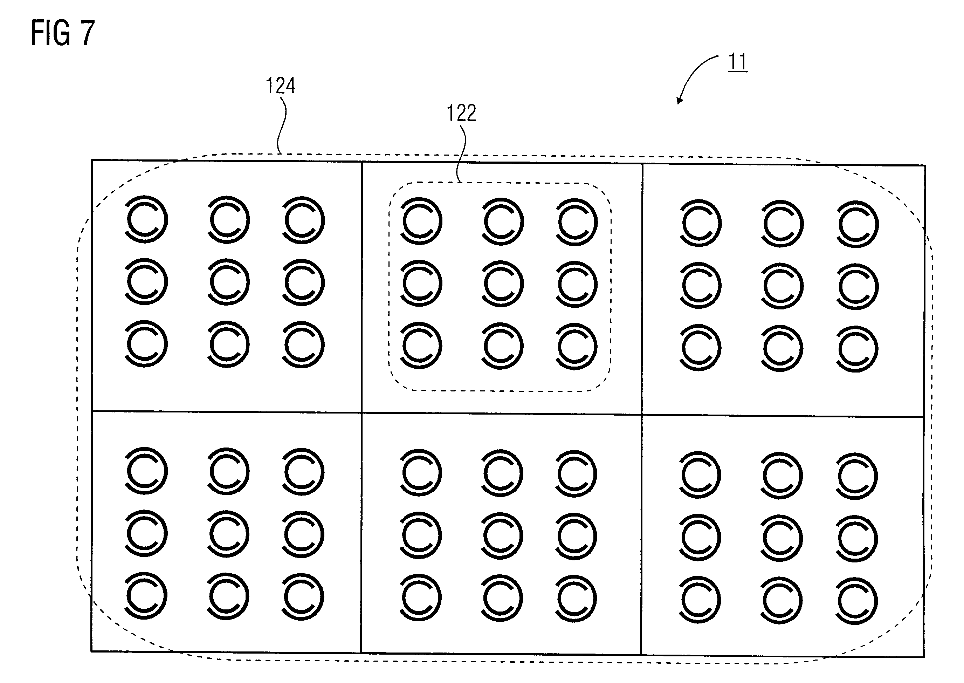

An dieser Stelle soll anhand von Fig. 7, welche eine Draufsicht auf Fig. 6 darstellt, erläutert werden, was im Folgenden unter einem photonischen Kristall bzw. einem Array aus photonischen Kristallen verstanden werden soll.

Ein einzelner photonischer Kristall der Filterstruktur 12 ist in Fig. 7 mit Bezugszeichen 122 gekennzeichnet, während die Gesamtheit der photonischen Kristalle als Array 124 bzw. periodische Anordnung von photonischen Kristallen bezeichnet werden soll. Dabei kann der Array 124 von photonischen Kristallen wiederum als ein größerer, übergeordneter photonischer Kristall betrachtet werden.

Bei Ausführungsbeispielen bewirkt die Filterstruktur 12 mit dem wenigstens einen photonischen Kristall 122 für auf einer dem Pixelsensor 14 abgewandten Seite 120 eintreffenden elektromagnetischen Strahlung 118 eine spektrale Selektion bzw. eine spektrale Filterung sowie eine Fokussierung elektromagnetischer Strahlung eines vordefinierten Wellenlängenbereichs in dem Feldkonzentrationsbereich, so dass nahe einer dem Pixelsensor 14 zugewandten Seite der Filterstruktur bzw. nahe dem Pixelsensor 14 für den vordefinierten Wellenlängenbereich eine elektomagnetische Feldkonzentration vorherrscht, welche von dem Pixelsensor 14 detektiert werden kann. Dabei handelt es sich bei Ausführungsbeispielen bei dem Pixelsensor 14 um ein Bauteil, das elektromagnetische Strahlung in ein elektrisches Signal umwandeln kann, wie z.B. ein PN-Übergangssensor. Dabei meint ein PN-Übergangssensor einen Sensor mit einem durch unterschiedliche Dotierung realisierten PN-Übergang. Gemäß Ausführungsbeispielen ist der PN-Übergangssensor als Photodiode ausgebildet.

Im optischen Wellenlängenbereich bedeutet dies eine spektrale Selektion einer bestimmten Wellenlänge bzw. eines vordefinierten Wellenlängenbereichs um die Wellenlänge durch den wenigstens einen photonischen Kristall 122, und eine Fokussierung des Lichts mit der vorbestimmten Wellenlänge. Welche Wellenlänge der wenigstens eine photonische Kristall 122 passieren lässt und welche Wellenlängen von ihm herausgefiltert werden, hängt von der dreidimensionalen periodischen Struktur des wenigstens einen photonischen Kristalls 122 bzw. dem Array 124 ab.

Somit kann das Sensorelement 11 als Bandpass verwendet werden, um elektromagnetische Strahlung, insbesondere Licht, in dem vordefinierten Wellenlängenbereich zu detektieren.

Der Pixelsensor 14 ist also vorzugsweise in dem Feldkonzentrationsbereich der Filterstruktur 12 bzw. des Arrays 124 von photonischen Kristallen 122 angeordnet. Der Feldkonzentrationsbereich weist von der zweiten Seite der Filterstruktur 12 einen vorbestimmten Abstand d auf, der im Wesentlichen durch die Prozesstechnologie bestimmt wird. Gemäß Ausführungsbeispielen ist der Abstand d bei einer 0,18 µm CMOS-Prozesstechnologie kleiner als 3 µm, vorzugsweise kleiner als 2µm.

Sensorelemente basierend auf photonischen Kristallen lassen sich mit CMOS-Prozessen, wie beispielsweise einem CMOS-Opto-Prozess realisieren, ohne dass zusätzliche Prozessschritte oder weitere Bearbeitungen erforderlich sind.

Ein Verfahren zum Herstellen eines integrierten Sensorelements auf einem Substrat umfasst gemäß Ausführungsbeispielen einen Schritt des Erzeugens eines Pixelsensors 14 an einer Substratoberfläche des Substrats und ein Aufbringen einer Filterstruktur 12 mit wenigstens einem photonischen Kristall auf den Pixelsensor 14, so dass sich der Pixelsensor 14 in einem Feldkonzentrationsbereich des wenigstens einen photonischen Kristalls befindet und von diesem vollständig bedeckt wird, wobei das Erzeugen und das Aufbringen Teile eines CMOS-Prozesses sind.

Gemäß Ausführungsbeispielen umfasst das Aufbringen des wenigstens einen photonischen Kristalls 122 ein Aufbringen eines Schichtstapels von dielektrischen Schichten und Metallschichten, wobei die Metallschichten jeweils Mikrostrukturen aufweisen, welche Abmessungen und Abstände zwischen zwei benachbarten Mikrostrukturen aufweisen, die eine Übertragung elektromagnetischer Strahlung des vordefinierten Wellenlängenbereichs durch den wenigstens einen photonischen Kristall 122 erlauben.

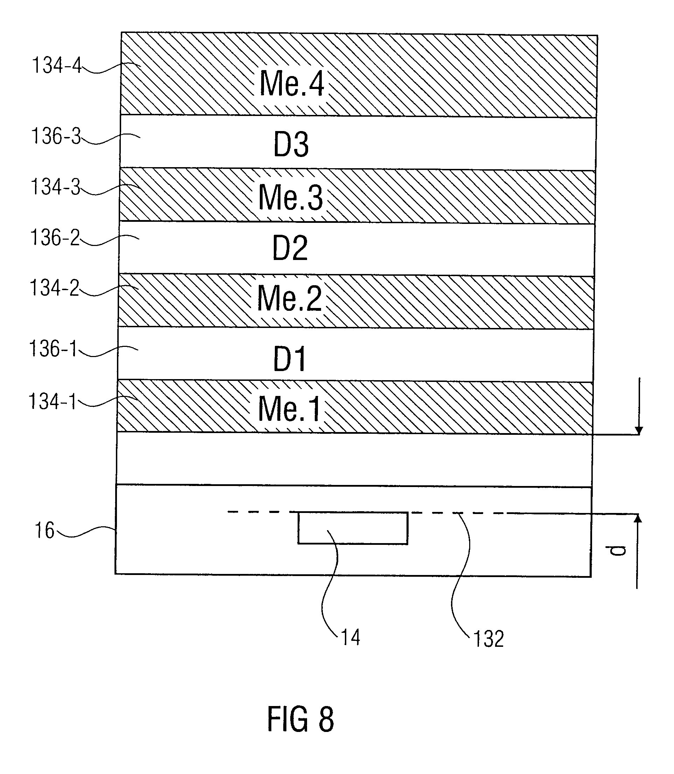

Ein Zwischenprodukt eines integrierten Sensors gemäß Ausführungsbeispielen ist schematisch in Fig. 8 gezeigt.

Des in Fig. 8 gezeigte, noch nicht fertig hergestellte, integrierte Sensorelement umfasst ein Substrat 16, insbesondere ein Halbleitersubstrat, indem ein Pixelsensor 14 eingebracht ist. Dabei ist der Pixelsensor 14 in einer Ebene 132 angeordnet, die den Feldkonzentrationsbereich (eine Art Brennebene, die man aus der klassischen Optik kennt) der Filterstruktur 12 bzw. des Arrays 124 aus photonischen Kristallen 122 umfasst.

Die nicht fertiggestellte optische Struktur in Fig. 8 weist einen Schichtstapel aus metallischen Schichten 134 und dielektrischen Schichten 136 auf. Fig. 8 zeigt lediglich exemplarisch vier metallische Schichten 134-1 bis 134-4 und drei dielektrische Schichten 136-1 bis 136-3. Je nach Ausführungsform kann die Schichtanzahl von dem in Fig. 8 gezeigten Beispiel abweichen.

Bei aktuellen CMOS-Prozessen besteht die Möglichkeit, die Metallschichten 134-1 bis 134-4 so zu strukturieren, dass daraus resultierende Mikrostrukturen bzw. Mikroelemente periodisch angeordnet sind und Abmessungen und Abstände aufweisen, die in der Größenordnung von Wellenlängen eines vorbestimmten Wellenlängenbereichs, insbesondere eines optischen Wellenlängenbereichs, liegen. Dies ermöglicht es, dreidimensionale periodische Strukturen mit Eigenschaften von photonischen Kristallen direkt auf einem Chip zu erzeugen. Wie im Vorhergehenden bereits beschrieben wurde, sind bei Ausführungsbeispielen die einzelnen Mikroelemente bzw. Mikrostrukturen in der Größenordnung einer vorbestimmten optischen Wellenlänge, so dass ein dreidimensionaler photonischer Kristall entsteht.

Gemäß Ausführungsbeispielen wird der Pixelsensor 14 vorzugsweise sehr nahe an der letzten Metallschicht 134-1 der Struktur platziert, wobei der Abstand d abhängig vom Herstellungsprozess ist. Der Abstand des Feldkonzentrationsbereichs von der letzten Metallschicht 134-1 der Filterstruktur 12 kann durch Abmessungen und Abstände von Strukturierungen der Metallschichten 134 eingestellt werden. Für ein integriertes optisches Sensorelement wird der Abstand d daher kleiner als 20 µm und bevorzugt kleiner als 8 µm gewählt. Bei 0,18 µm CMOS-Prozessen ist der Abstand zwischen dem Pixelsensor 14 und der Filterstruktur 12 bzw. der letzten Metallschicht 134-1 kleiner als 2 µm.

Die in Fig. 8 exemplarisch gezeigten Metallschichten 134-1 bis 134-4 werden in einem CMOS-Prozess geeignet strukturiert, um einen photonischen Kristall mit einer guten optischen Filterwirkung und evtl. sogleich fokussierender Wirkung zu erhalten, so dass keine zusätzliche Farbfilterbeschichtung benötigt wird.

Ein Sensorelement 11 gemäß Ausführungsbeispielen kann also realisiert werden, indem man die vorhandenen metallischen 134 und dielektrischen Schichten 136 ausnutzt. Bei Ausführungsbeispielen ist der Pixelsensor 14 das einzige optoelektronische Bauteil, insbesondere eine Photodiode, eines integrierten Sensorelements eines multispektralen Bildsensors. Dabei überlappt der Pixelsensor 14 lateral mit der Filterstruktur und ist individuell ansteuerbar. Der Pixelsensor 14 ist gemäß Ausführungsbeispielen vorzugsweise von den Metallschichten 134 vollständig abgedeckt.

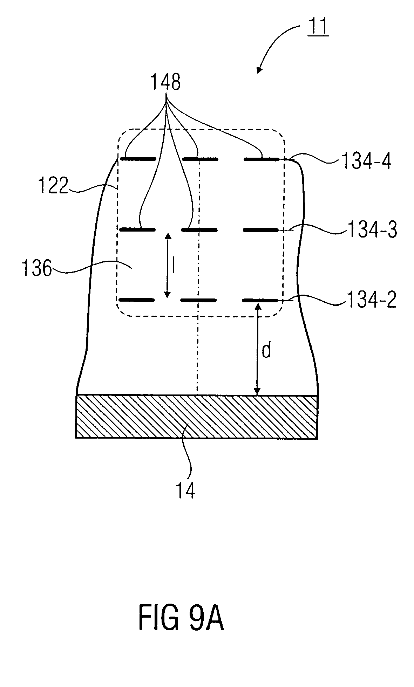

Fig. 9a zeigt eine schematische Seitenansicht eines Ausschnitts eines integrierten Sensorelements 11 mit einem photonischen Kristall 122 und einem Pixelsensor 14.

Der in Fig. 9a gezeigte photonische Krista111 122 umfasst periodisch angeordnete strukturierte Metallschichten 134-2 bis 134-4 in einem dielektrischen Medium 136, wie z.B. SiO₂ (Siliziumdioxid). Die strukturierten Metallschichten 134 weisen Mikroelemente 148 mit Mikroöffnungen auf, so wie es in der Seitenansicht des integrierten Sensorelements 11 in Fig. 9a angedeutet ist. Die geometrische Form dieser Mikroelemente 148 bzw. Mikroöffnungen kann vielfältig ausgestaltet sein und hängt von den gewünschten elektromagnetischen Eigenschaften des photonischen Kristalls 122 ab. Möglich sind beispielsweise kreisförmige Mikroöffnungen, deren Abmessungen und Abstände zueinander in der Größenordnung einer Wellenlänge des vorbestimmten Wellenlängenbereichs sind. Ein Abstand 1 zwischen benachbarten strukturierten Metallschichten 134 liegt ebenfalls in der Größenordnung der Wellenlänge des gewünschten Wellenlängenbereichs.

Gemäß Ausführungsbeispielen weisen die strukturierten Metallschichten 134-2 bis 134-4 des Sensorelements 11, das für einen vorbestimmten Wellenlängenbereich bzw. eine Farbe selektiv ist, Mikroelemente 148 auf, deren Abstände und Abmessungen eine Größenordnung aufweisen, um beispielsweise an einer dem Pixelsensor 14 zugewandten Seite des photonischen Kristalls 122 eine spektrale Selektion und Konzentration des vordefinierten Wellenlängenbereichs zu bewirken. Die Abmessungen und Abstände der Mikroelemente 148 weisen gemäß Ausführungsbeispielen eine Größenordnung auf, welche in einem vordefinierten Bereich, z.B. unterhalb, um die gewünschte Wellenlänge λᵣₑₛ des vordefinierten Wellenlängenbereichs liegt. Daher werden die Mikroelemente 148 im Nachfolgenden auch als Sub-Wellenlängen-Strukturen bezeichnet. Für optische Wellenlängenbereiche weisen die Sub-Wellenlängen-Strukturen Abmessungen und Abstände zwischen zwei benachbarten Sub-Wellenlängen-Strukturen 148 auf, die im Bereich des vordefinierten Wellenlängenbereichs liegen.

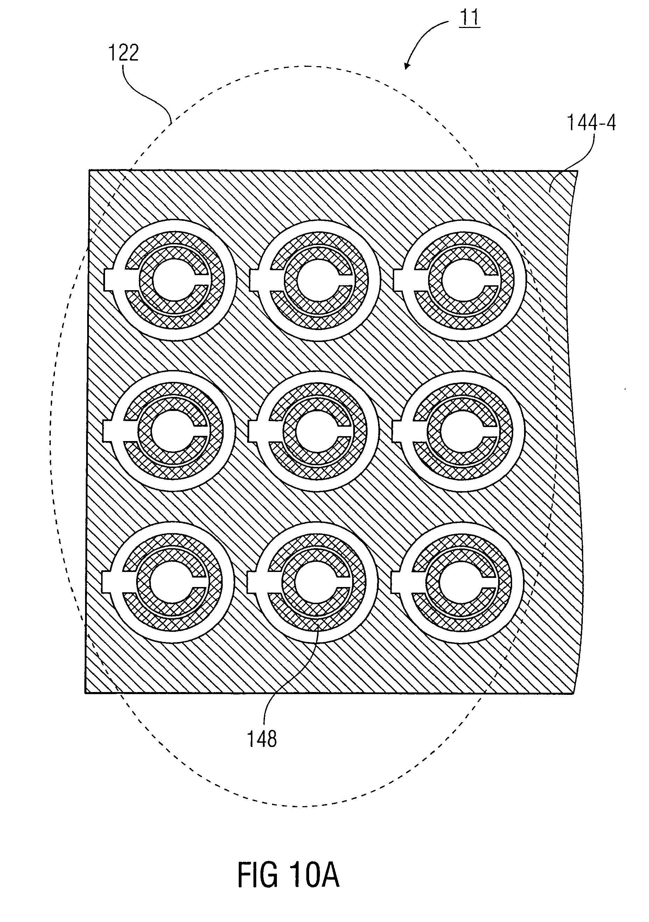

Fig. 10a zeigt eine Draufsicht auf eine mögliche Ausführungsform von den in den Metallschichten 134 realisierten Sub-Wellenlängen-Strukturen 148.

Fig. 10a kann als eine Draufsicht auf einen Ausschnitt einer strukturierten Metallschicht 134 des integrierten Sensorelements 11 gesehen werden. In eine Metallschicht sind Sub-Wellenlängen-Elemente 148 angebracht. Dabei zeigt Fig. 10a exemplarisch einen Ausschnitt mit in einer 3x3-Matrix angeordneten Sub-Wellenlängen-Elementen 148, welche eine sogenannte Split-Ring-Resonator-Struktur aufweisen. Fig. 10a zeigt also eine Draufsicht einer möglichen Realisierungsform der in Fig. 9a in einer Seitenansicht gezeigten verschiedenen Metallschichten 134 mit metallischen Sub-Wellenlängen-Strukturen 148. Die Abmessungen der Sub-Wellenlängen-Strukturen 148 sind dabei vergleichbar oder kleiner als die Wellenlänge λᵣₑₛ des vordefinierten Wellenlängenbereichs. Gemäß Ausführungsbeispielen liegen die Abmessungen der Sub-Wellenlängen-Strukturen 148 in einem Bereich von beispielsweise 0.3 λᵣₑₛ bis 3λᵣₑₛ.

Ändert man das Verhältnis der Radien eines äußeren und eines inneren Kreises eines in Fig. 10a gezeigten Split-RingResonators 148, so verändert sich die entsprechende Resonator-Wellenlänge. Es sei hervorzuheben, dass auch andere Sub-Wellenlängen-Strukturen, wie beispielsweise sogenannte LC-Loaded-Transmission Lines, möglich sind, wobei wichtig ist, dass eine spektral selektive Transmission erzielt werden sollte.

Fig. 11a zeigt einen Ausschnitt eines integriertes Sensorelements 11 gemäß einem weiteren Ausführungsbeispiel der vorliegenden Erfindung.

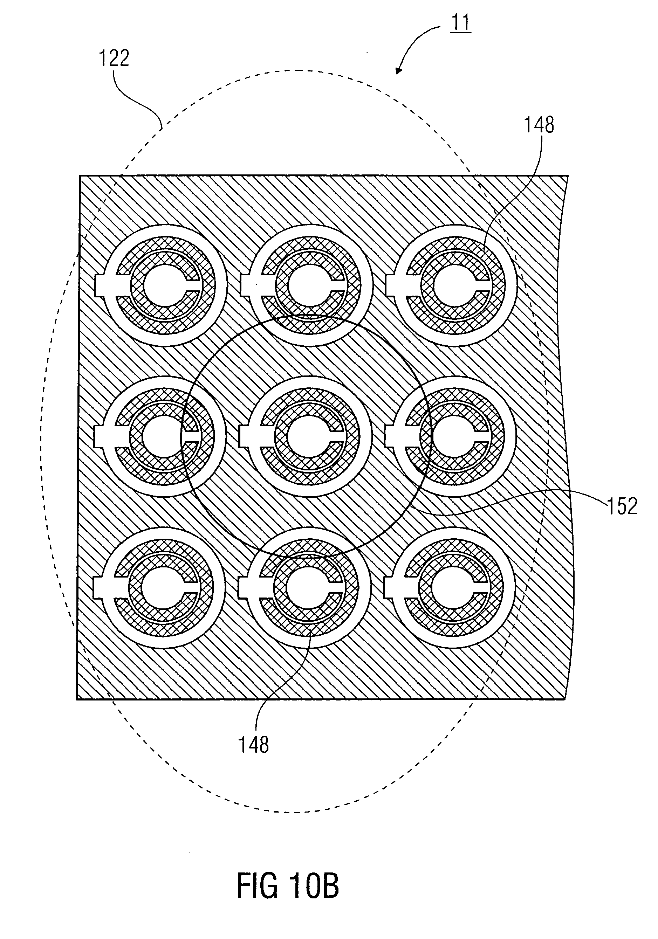

Zusätzlich zu den anhand von Fig. 9a beschriebenen strukturierten Metallschichten weist das in Fig. 11a dargestellte integrierte Sensorelement 11 zusätzlich eine Metallschicht 134-1 zwischen dem mittels der Schichten 134-2 bis 134-4 gebildeten photonischen Kristall 122 und dem Pixelsensor 14 auf, welche eine Öffnung 152 aufweist. Dabei ist der Pixelsensor 14 in einem Abstand d von der untersten Metallschicht 134-2 des photonischen Kristalls beabstandet. Für einen integrierten optischen Sensor wird der Abstand d kleiner als 20 µm und bevorzugt kleiner als 8 µm gewählt. Bei 0,18 µm CMOS-Prozessen ist der Abstand d zwischen dem Pixelsensor 14 und untersten Metallschicht 134-2 des photonischen Kristalls kleiner als 2 µm. Auch hier sind die Sub-Wellenlängen-Elemente 148 der verschiedenen Metallschichten 134-2 bis 134-4, genau wie bei dem in Fig. 9a gezeigten Ausführungsbeispiel, jeweils exakt untereinander platziert. Ein derartiger dreidimensionaler Aufbau strukturierten Metallschichten 134-2 bis 134-4 bildet ein als Linse wirkenden photonischen Kristall. In der untersten, das heißt, dem Pixelsensor 14 am nächstliegenden Metallschicht 134-1, befindet sich eine Öffnung 152, so dass das Zentrum der Öffnung 152 und eine Symmetrieachse 154 des photonischen Kristalls zusammenfallen. Die aus dem photonischen Kristall 122 bestehende Filterstruktur und die Öffnung 152 befinden sich somit idealerweise auf einer gemeinsamen optischen Achse 154. Dieser Zusammenhang ist zur Veranschaulichung noch einmal in einer Draufsicht auf das Sensorelement 11 in Fig. 10b gezeigt.

Die Symmetrieachse 154 des photonischen Kristalls 122 bzw. des Sensorelements 11 fällt zumindest näherungsweise mit dem Mittelpunkt der Öffnung 152 zusammen. Unterhalb der Öffnung 152 in einem Abstand kleiner als d befindet sich eine optisch aktive Oberfläche des Pixelsensors 14, welcher eine Photodiode sein kann.

Die im Vorhergehenden beschriebene Filterstruktur 12 bzw. der wenigstens eine photonische Kristall 122 weist für eine bestimmte Resonanzwellenlänge λᵣₑₛ bzw. für einen vorbestimmten Resonanzwellenlängenbereich eine fokussierende Wirkung auf. Das heißt, das sich beim Auftreffen von elektromagnetischer Strahlung auf den photonischen Kristall 122 lediglich die Resonanzwellenlänge bzw. der Resonanzwellenlängenbereich ungehindert durch diesen ausbreiten kann. Durch die fokussierende Wirkung des photonischen Kristalls 122 bildet sich ein Feldkonzentrationsbereich, in dem für die Resonanzwellenlänge λᵣₑₛ bzw. den Resonanzwellenbereich eine erhöhte elektromagnetische Feldkonzentration vorherrscht. Wellenlängen außerhalb des vordefinierten Wellenlängenbereichs werden von dem photonischen Kristall 122 erst gar nicht durchgelassen bzw. sehr stark gedämpft.

Wird kollimiertes Licht verwendet, kann die Filterstruktur 12 mit dem Array 124 photonischer Kristalle 122 derart ausgebildet werden, dass sie keine nennenswerte Fokussierwirkung aufweist. D.h. die Subwellenlängenstrukturen 148 werden derart dimensioniert, dass der Feldkonzentrationsbereich quasi im Unendlichen liegt.

Bei dem im Vorhergehenden beschriebenen Ausführungsbeispielen liegt der Feldkonzentrationsbereich eines photonischen Kristalls 122 in der Nähe der Symmetrieachse 154. Wird der Pixelsensor 14 in der Nähe dieses Feldkonzentrationsbereichs bzw. in diesem Feldkonzentrationsbereich angeordnet, so kann von dem Pixelsensor 14 bei Ausführungsbeispielen die Feldkonzentration der Resonanzwellenlänge λᵣₑₛ bzw. des Resonanzwellenbereichs detektiert werden.

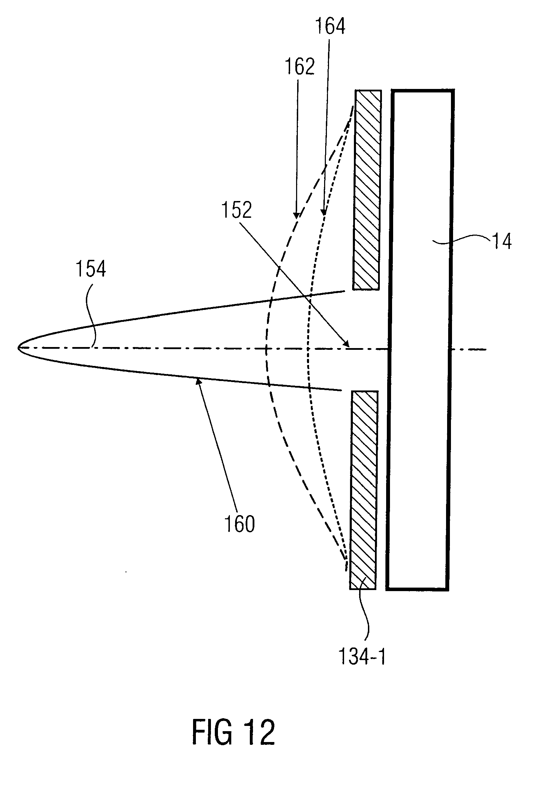

Durch die Metallschicht 134-1 mit der Öffnung 52 zwischen dem photonischen Kristall 12 und der Photodiode 14 kann eine spektrale Selektivität nochmals erhöht werden. Dieser Zusammenhang ist in Fig. 12 gezeigt.

Der Übersichtlichkeit halber zeigt Fig. 12 lediglich einen Pixelsensor 14 in Form einer Photodiode 14, welche hinter bzw. unter der Metallschicht 134-1 mit der Öffnung 152 angeordnet ist. Der photonische Kristall 122, der vor bzw. über der Metallschicht 134-1 angeordnet ist, ist der Übersichtlichkeit halber nicht gezeigt.

Wie im Vorhergehenden bereits beschrieben wurde, bildet sich bei Ausführungsbeispielen durch die fokussierende Wirkung des photonischen Kristalls 122 in der Nähe der Metallschicht 134-1, die der Photodiode 14 am nächsten liegt, für eine bestimmte Resonanzwellenlänge λᵣₑₛ eine Feldkonzentration aus, nicht aber für andere Wellenlängen. Das bedeutet, dass nur die elektromagnetische Strahlung der gewünschten bzw. durch die dreidimensionale periodische Struktur des photonischen Kristalls eingestellten Wellenlänge λᵣₑₛ zumindest nahezu verlustfrei auf die Photodiode 14 treffen kann, während andere Wellenlängen durch den photonischen Kristall ausgefiltert werden. D.h. der Feldkonzentrationsbereich des photonischen Kristalls 122 ist wellenlängenabhängig.

Durch die Öffnung 152 in der Metallschicht 134-1 kann die spektrale Trennung deutlich verbessert werden, so dass eine optische Kopplung zwischen der Filterstruktur und dem Pixelsensor 14 auf einen Filterwellenlängentransmissionsbereich begrenzt ist. In Fig. 12 sind exemplarisch drei elektromagnetische Feldverteilungen 160, 162, 164 für drei unterschiedliche Wellenlängen in der Nähe der Photodiode 14 eingezeichnet. Für die Resonanzwellenlänge λᵣₑₛ, die im Filterwellenlängentransmissionsbereich liegt, ist die Feldverteilung 160 am stärksten ausgebildet, d.h. die ganze Energie kann die Öffnung 152 passieren, während für die anderen Wellenlängen 162, 164 nur ein kleiner Anteil die Photodiode 14 erreicht.

Der photonische Kristall 122 in Form der Sub-Wellenlängen-Strukturen der oberen Metallschichten 134-2 bis 134-4 (nicht gezeigt) bewirkt zusammen mit der Öffnung 152 in der unteren Metallschicht 134-1, dass nur die vorbestimmte Wellenlänge λᵣₑₛ bzw. ein vorbestimmter Wellenlängenbereich die Photodiode 14 erreicht. Dazu befindet sich vorzugsweise das Zentrum der Öffnung 152 und das Zentrum der Sub-Wellenlängen-Strukturen 148 des photonischen Kristalls auf der Symmetrieachse 154 des photonischen Kristalls 122. Anders ausgedrückt, liegen das Zentrum der Öffnung 152 und das Zentrum der Sub-Wellenlängen-Strukturen 148 des photonischen Kristalls 122 übereinander, so dass die Sub-Wellenlängen-Strukturen und die Öffnung 152 eine gemeinsame optische Achse 154 aufweisen. Um eine Resonanz für andere Spektralbereiche zu erzielen, muss eine andere, geeignete Form für die Sub-Wellenlängen-Strukturen und ggf. die Öffnung 152 gewählt werden. Gemäß Ausführungsbeispielen weist die Öffnung 152 einen Durchmesser von ca. 1 µm auf.

An dieser Stelle soll noch einmal erwähnt werden, dass die Metallschicht 134-1 mit der Öffnung 152 nicht zwingend notwendig ist, um ein Sensorelement gemäß Ausführungsbeispielen herzustellen. Jedoch umfassen bevorzugte Ausführungsformen die unterste Metallschicht 134-1 mit der Öffnung 152, da durch die sie die spektrale Selektivität der Anordnung verbessert werden kann.

Eine weitere Möglichkeit des Schichtaufbaus der strukturierten Metallschichten 134 besteht darin, statt der Lochöffnung 152 der untersten Metallschicht 134-1 eine periodische Struktur aus den gleichen oder anderen Mikroelementen 148, wie in den darüber liegenden Metallschichten 134-2 bis 134-4 auszubilden, wobei die Mikroelemente der untersten Metallschicht 134-1 aber zu denen der darüber liegenden Metallschichten lateral verschoben sind (gebrochene Symmetrie).

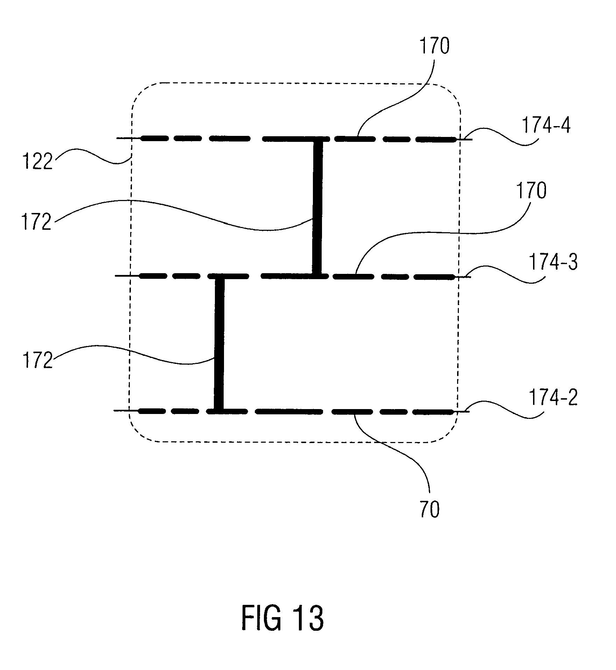

Wie im Vorhergehenden bereits erwähnt wurde, können die Mikroelemente 148 eine Vielzahl von Formen annehmen. Es sind also beispielsweise die beschriebenen sogenannten Split-Ring-Resonatoren möglich. Andere Formen sind aber ebenfalls denkbar. Die Mikroelemente 148 haben eine eigene Filterwirkung, die eine Transmission von elektromagnetischer Strahlung des photonischen Kristalls stark beeinflusst. Durch CMOS-Prozesse können nicht nur zweidimensionale, d.h. planare, sondern auch dreidimensionale Sub-Wellenlängen-Elemente 148 erzeugt werden. Dazu zeigt Fig. 13 schematisch ein Beispiel.

Fig. 13 zeigt drei strukturierte Metallschichten 174-2 bis 174-4 mit planaren Strukturen 170 und vertikalen Durchkontaktierungen 172 zwischen den strukturierten Metallschichten 174. Hier umfassen die einzelnen Sub-Wellenlängen-Elemente also planare Strukturen 170 und vertikale Strukturen 172, die zusammen dreidimensionale Sub-Wellenlängen-Elemente bilden. Die Durchkontaktierungen 172 stehen in Rahmen von herkömmlichen CMOS-Prozessen zur Verfügung. Diese dreidimensionalen Strukturen erlauben mehr Optimierungsmöglichkeiten hinsichtlich der spektralen Selektivität und der Fokussierung von elektromagnetischer Strahlung als zweidimensionale, d.h. planare Strukturen.

Lediglich exemplarisch wurde im Vorhergehenden der Aufbau von Sensorelementen 11, anhand eines Ausschnitts mit nur einem photonischen Kristall 122 beschrieben. Die Abmessungen des Arrays 124 von photonischen Kristallen 122 sind bei Ausführungsbeispielen derart gewählt, dass der die Filterstruktur 12 bzw. der Array 124 aus photonischen Kristallen 122 eine ihm bzw. der Filterstruktur 12 zugewandte Oberfläche des Pixelsensors 14 vollständig abdeckt. Dazu wird ein Array 124 aus mehreren gleichartigen, d.h. auf die gleiche Wellenlänge λᵣₑₛ eingestellten, photonischen Kristallen 122 in einen Ebene über einer Photodiode platziert, um eine Photodiode vollständig abzudecken. Ein einzelner photonischer Kristall 122 kann bei dieser Anordnung als ein Arrayelement oder photonischer Sub-Kristall betrachtet werden. Im Fall einer untersten Metallschicht mit Öffnungen 152 liegen die Öffnungen 152 und die jeweiligen Zentren der Sub-Wellenlängen-Strukturen der Arrayelemente auf einer gemeinsamen optischen Symmetrieachse 154 der Arrayelemente, so wie es im Vorhergehenden bereits beschrieben wurde.

Mittels der im Vorhergehenden beschriebenen Ausführungsformen integrierter Sensorelemente 11 lassen sich gemäß Ausführungsbeispielen integrierte multispektrale Bildsensoren bzw. integrierte Spektrometer aufbauen. Werden beispielsweise integrierte Sensorelemente, welche jeweils für unterschiedliche Wellenlängen bzw. Wellenlängenbereiche selektiv sind, in einer Ebene nebeneinander angeordnet, so kann ein integrierter multispektraler Bildsensor aufgebaut werden.

Für einen multispektralen Bildsensor können beispielsweise für einen Bildpunkt mehrere integrierte Sensorelemente verwendet werden, wobei ein erstes ausgebildet ist, um auf einen ersten Wellenlängenbereich anzusprechen, ein zweites ausgebildet ist, um auf einen zweiten Wellenlängenbereich anzusprechen usw.. Das heißt, ein integrierter multispektraler Bildsensor gemäß Ausführungsbeispielen umfasst eine Mehrzahl von integrierten Bauteilen mit Filterstrukturen mit wenigstens einem photonischen Kristall und Pixelsensoren bzw. Fotodioden, wie sie im Vorhergehenden beschrieben wurden, wobei die Filterstrukturen von unterschiedlichen der Mehrzahl der integrierten Bauteile ausgebildet sind, um ansprechend auf elektromagnetische Strahlung unterschiedlicher Wellenlängenbereiche jeweils an einer dem entsprechenden Pixelsensor zugewandten Seite der Filterstruktur eine elektromagnetische Feldkonzentration in der Nähe des jeweiligen Pixelsensors zu erzeugen, für die der jeweilige Pixelsensor empfindlich ist.

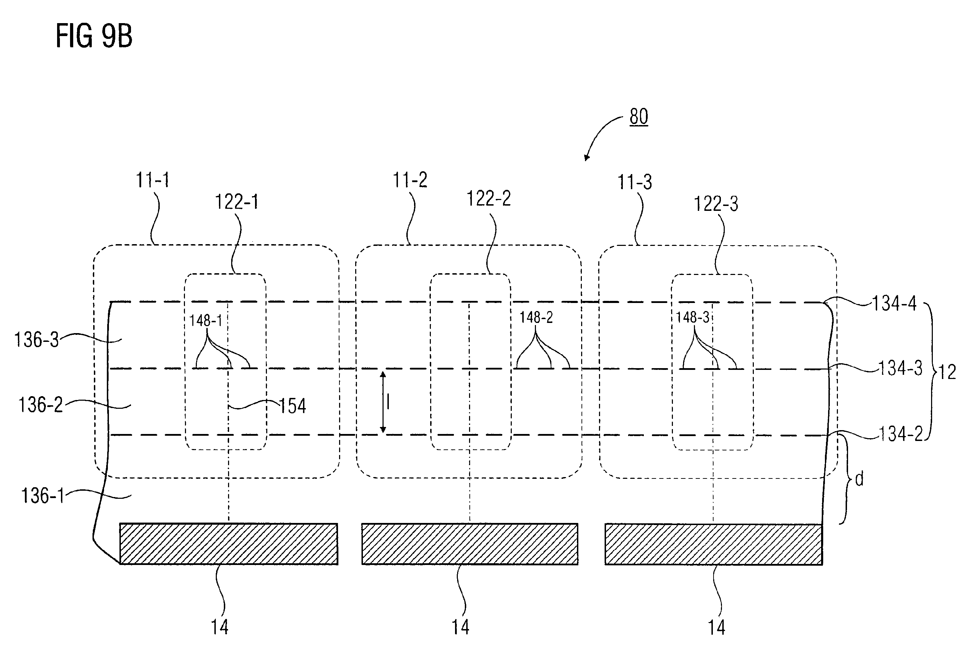

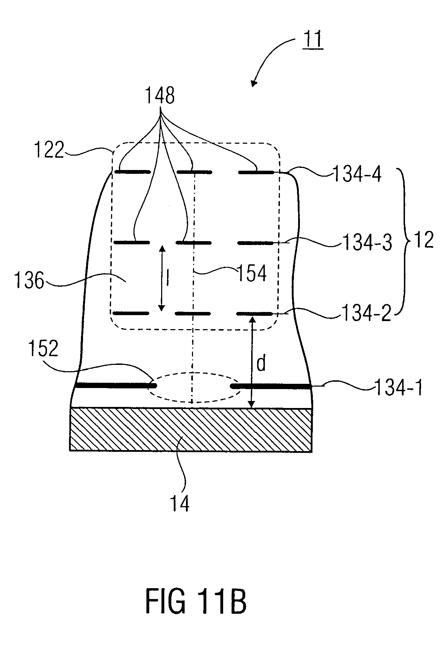

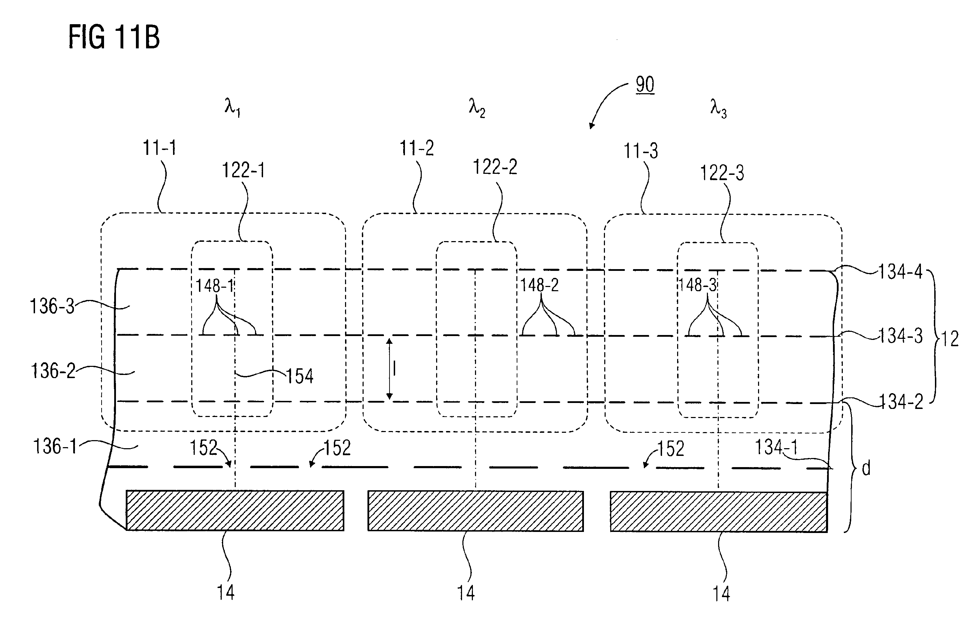

Ausführungsbeispiele für integrierte multispektrale Bildsensoren mit einer Mehrzahl von integrierten Sensorelementen sind exemplarisch in den Fig. 9b und 11b gezeigt.

Fig. 9b zeigt exemplarisch eine Seitenansicht von drei benachbart integrierten Sensorelementen 11-1 bis 11-3, die jeweils für sich eine Struktur aufweisen, wie sie im Vorhergehenden bereits anhand von Fig. 9a beschrieben wurde. Dabei ist bei dem in Fig. 9b dargestellten multispektralen Bildsensor 80 zu bemerken, dass die Mikroelemente 148-1 bis 148-3 der photonischen Kristalle 122-1 bis 122-3 der drei benachbarten Sensorelemente 11-1 bis 11-3 jeweils auf unterschiedliche Wellenlängen bzw. unterschiedliche Wellenlängenbereiche eingestellt sein können.

Fig. 11b zeigt exemplarisch einen integrierten multispektralen Bildsensor 90 mit drei benachbart integrierten Sensorelementen 11-1 bis 11-3, wie sie bereits anhand von Fig. 11a ausführlich beschrieben wurden. Auch hier sind die Mikroelemente 148-1 bis 148-3 der photonischen Kristalle 122-1 bis 122-3 der jeweiligen ausgebildet, um jeweils unterschiedliche Wellenlängen zu den jeweiligen Photodioden 14 passieren zu lassen.

Nachdem im Vorhergehenden detailliert auf Sensorelemente mit als photonische Kristalle ausgebildeten Filterstrukturen eingegangen wurde, werden im Nachfolgenden Ausführungsbeispiele von Sensorelementen eines erfindungsgemäßen multispektralen Bildsensors mit Zonenplatten-Metallschichtstrukturen beschrieben.

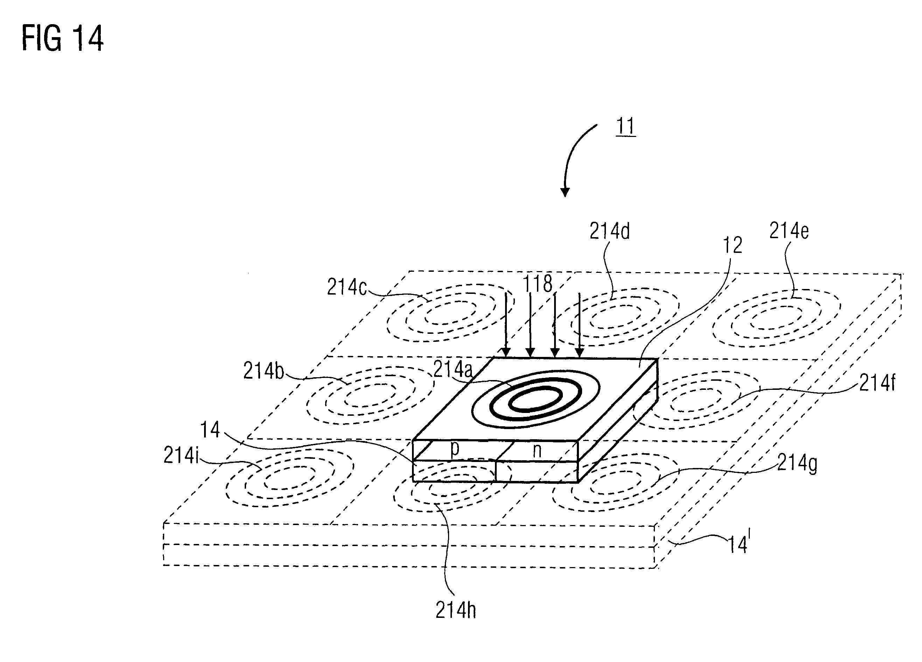

Dazu zeigt Fig. 14 eine schematische Seitenansicht eines integrierten Sensorelements 11 zur Filterung von elektromagnetischer Strahlung eines vorbestimmten Wellenlängenbereichs gemäß einem weiteren Ausführungsbeispiel.

Das integrierte Sensorelement 11 weist eine Filterstruktur 12 aus einer strukturierten Metallschicht mit einer Zonenplattenstruktur 214 und einen Pixelsensor 14 auf, wobei die Filterstruktur 12 und der Pixelsensor 14 derart in einem Halbleitersubstrat integriert 16 sind, so dass der Pixelsensor 14 in einem Feldkonzentrationsbereich der Filterstruktur 12 angeordnet ist.

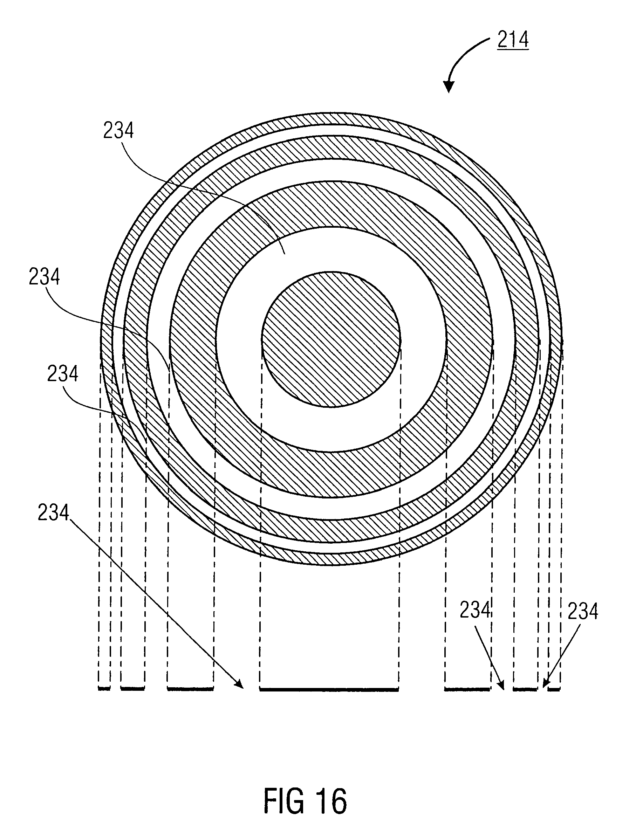

Die Filterstruktur 12 weist eine Sub-Lambda-Zonenplattenstruktur 214 auf, in der konzentrische Ringe eine Zonenplatte definieren. Wie es mit gestrichelten Linien gezeigt ist, kann die Zonenplattenstruktur 214 aber auch ein Array von Zonenplatten aufweisen, die dem einen Pixelsensor 14' zugeordnet ist. Obwohl hier nur ein 3x3-Array von Zonenplatten gezeigt sind, sind andere Verhältnisse auch möglich. Insbesondere ist es möglich, dass der Pixelsensor 14' größer oder kleiner als die Ausdehnung des Arrays ist. Die folgende Beschreibung konzentriert sich vornehmlich auf die isolierte Betrachtung einer Zonenplatte, aber die Betrachtungen sind dann auch übertragbar auf den Fall eines Arrays von Zonenplatten, indem die entsprechenden Maßnahmen auf alle Zonenplatten 214a-214i übertragen werden. Die Abmessung der einzelnen transmittierenden und nicht transmittierenden Zonen der Zonenplatten kann variieren, wobei aber beispielsweise zumindest eine transmittierende Zone irgendeiner Ordnung eine Zonenbreite kleiner als die gewünschte Durchlasswellenlänge λ (Lambda) des Zonenplattenstrukturfilters, wie z.B. kleiner als 2µm oder sogar 1,2 µm, aufweist. Näher wird ein exemplarischer Aufbau Bezug nehmend auf Fig. 16 erläutert.

Die verschiedenen Zonen einer Zonenplatte unterscheiden sich dabei in ihrer Transparenz. Im einen Fall wird die elektromagnetische Strahlung an den ringförmigen Spalten gebeugt und durch konstruktive Interferenz in wellenlängenspezifischen Feldkonzentrationsbereichen verstärkt. Je nachdem für welche Wellenlänge λᵣₑₛ bzw. für welchen vordefinierten Wellenlängenbereich das integrierte Sensorelement 11 empfindlich sein soll, wird der Pixelsensor 14 in unterschiedlichen Abständen zu der strukturierten Metallschicht mit Zonenplattenstruktur 214 angeordnet. Der Abstand des Pixelsensors 14 von der Zonenplatte 214 wird durch den Feldkonzentrationsbereich der Zonenplatte für die vorbestimmte Wellenlänge λᵣₑₛ festgelegt. Eine Zonenplatte mit binärer Abstufung, also völlig transparent abwechselnd mit total nicht transparent, so wie sie in Fig. 14 schematisch dargestellt ist, hat viele Brennpunkte für jeweils verschiedene Wellenlängen.

Bei Ausführungsbeispielen bewirkt die Zonenplattenstruktur 214 für auf einer dem Pixelsensor 14 abgewandten Seite der Metallschicht eintreffenden elektromagnetischen Strahlung 118 eine spektrale Selektion bzw. eine spektrale Filterung sowie eine Fokussierung elektromagnetischer Strahlung eines vordefinierten Wellenlängenbereichs in dem Feldkonzentrationsbereich, so dass nahe einer dem Pixelsensor 14 zugewandten Seite bzw. nahe dem Pixelsensor 14 für den vordefinierten Wellenlängenbereich eine elektomagnetische Feldkonzentration in dem Feldkonzentrationsbereich vorherrscht, welche von dem Pixelsensor 14 detektiert werden kann.

Im optischen Wellenlängenbereich bedeutet dies eine spektrale Selektion einer bestimmten Wellenlänge bzw. eines vordefinierten Wellenlängenbereichs um die Wellenlänge durch die Zonenplatte 214, und eine Fokussierung des Lichts mit der vorbestimmten Wellenlänge λᵣₑₛ im Feldkonzentrationsbereich. Welche Wellenlänge die Zonenplatte im Feldkonzentrationsbereich, in dem der Pixelsensor 14 angeordnet ist, fokussiert und welche Wellenlängen von ihr herausgefiltert werden, hängt von der Struktur der Zonenplatte 214 und dem Abstand des Pixelsensors 14 von der Zonenplatte ab.

Der Pixelsensor 14 ist also vorzugsweise in dem Brennpunktbereich der Zonenplatte 214 für den vorbestimmten Wellenlängenbereich angeordnet. Der Feldkonzentrationsbereich weist von der Zonenplatte 214 einen vorbestimmten Abstand d auf, der gemäß Ausführungsbeispielen kleiner ist als die zu selektierende Wellenlänge λᵣₑₛ bzw. eine Wellenlänge des vorbestimmten Wellenlängenbereichs. Gemäß Ausführungsbeispielen ist der Abstand d kleiner als 20 µm oder 6-10µm. Integrierte Sensorelemente basierend auf strukturierten Metallschichten mit Zonenplattenstruktur lassen sich mit CMOS-Prozessen, wie beispielsweise einem CMOS-Opto-Prozess realisieren, ohne dass zusätzliche Prozessschritte oder weitere Bearbeitungen erforderlich sind.

Ein Verfahren zum Herstellen eines integrierten Sensorelements 11 auf einem Substrat umfasst gemäß Ausführungsbeispielen einen Schritt des Erzeugens eines Pixelsensors 14 an einer Substratoberfläche des Substrats und ein Aufbringen einer Filterstruktur 12 mit wenigstens einer strukturierten Metallschicht mit Zonenplattenstruktur 214 auf den Pixelsensor 14, so dass die Filterstruktur 12 und der Pixelsensor 14 derart in dem Halbleitersubstrat integriert sind, so dass der Pixelsensor 14 in einem Feldkonzentrationsbereich der Filterstruktur bzw. der Zonenplatten angeordnet ist, wobei das Erzeugen und das Aufbringen Teile eines CMOS-Prozesses sind.

Gemäß Ausführungsbeispielen umfasst das Aufbringen der Filterstruktur 12 das Aufbringen wenigstens einer strukturierten Metallschicht, wobei die wenigstens eine strukturierte Metallschicht Mikrostrukturen in Form von Zonenplatten 214 aufweist, deren Abmessungen und Radien zwischen zwei benachbarten Zonen, eine Fokussierung der elektromagnetischen Strahlung einer vorbestimmten Wellenlänge λᵣₑₛ bzw. eines vorbestimmten Wellenlängenbereichs in dem Brennpunktbereich erlauben.

Ein Zwischenprodukt eines CMOS-Herstellungsprozesses eines integrierten Bauteils gemäß Ausführungsbeispielen wurde schematisch bereits anhand von Fig. 8 beschrieben.

In allen vier metallischen Schichten 134-1 bis 134-4 können beispielsweise laterale deckungsgeliche Zonenplattenstrukturen gebildet werden. Alternativ kann die dem Pixelsensor 14 nächstgelegene Metallschicht 134-1 eine als Blende fungierende Öffnung aufweisen, wie sie im folgenden erläutert wird, in welchem Fall diese Öffnung, der Pixelsensor 14 Oder ein Ort dazwischen vertikal zentriert im Feldkonzentrationsbereich liegt.

Bei einem integrierten Sensorelement gemäß einem alternativen Ausführungsbeispiel der vorliegenden Erfindung können die Metallschichten 134-1 bis 134-3 durch Dielektrika ersetzt sein, so dass lediglich die darüber liegende Schicht 134-4 die Zonenplattenstruktur bildet.

Die jeweils unterste Metallschicht wird in einem Abstand d von dem Pixelsensor 14 angeordnet, wobei der Abstand d zumindest näherungsweise die "Brennweite" einer fokussierenden Zonenplatte in der/den darüber liegenden strukturierten Metallschicht(en) für eine bestimmte Wellenlänge angibt.

Zwischen dem Pixelsensor 14 und der strukturierten Metallschicht 134-1 befindet sich das Substrat 16 bzw. ein Dielektrikum in Form von beispielsweise wenigstens einer dielektrischen Schicht.

Die Metallschichten 134 werden nun gemäß Ausführungsbeispielen derart strukturiert, dass sie eine gute optische Filterwirkung mit gleichzeitig fokussierender Wirkung aufweisen, ohne dass eine zusätzliche Farbfilterbeschichtung für das integrierte Bauteil nötig ist.

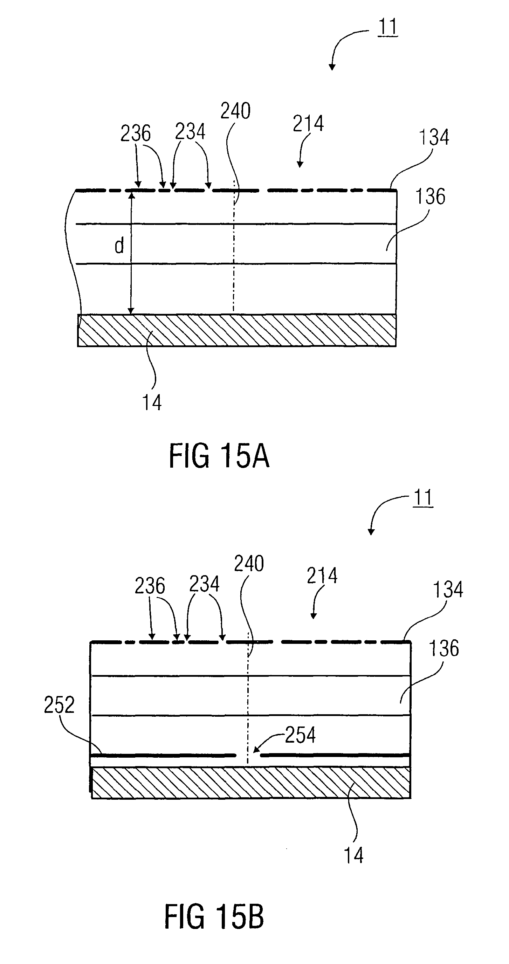

Fig. 15a zeigt eine schematische Seitenansicht eines in CMOS-Technik integrierten Sensorelements 11 gemäß einem Ausführungsbeispiel der vorliegenden Erfindung.

Das integrierte Sensorelement 11 weist eine strukturierte Metallschicht 134 mit Zonenplattenstruktur auf. Die Zonenplatte 214 der strukturierten Metallschicht 134 ist in transparente Zonen 234 und nicht transparente Zonen 236 aufgeteilt. Die transparenten Zonen 234 werden beispielsweise durch ein Dielektrikum 136 gebildet, welches zwischen der strukturierten Metallschicht 134 und dem Pixelsensor 14 angeordnet ist. Die Zonenplatte 214 der strukturierten Metallschicht 134 weist konzentrische Ringe auf, die aus den transparenten und nicht transparenten Zonen mit Sub-Lambda-Zonenbreite gebildet werden, und die einen gemeinsamen Mittelpunkt aufweisen, durch den senkrecht zu der strukturierten Metallschicht 134 eine Rotationsachse 240 des integrierten Sensorelements 11 verläuft. Der Pixelsensor 14 ist in einem Abstand d von der strukturierten Metallschicht 134 angeordnet, so dass sich der Pixelsensor 14 in oder zumindest in der Nähe des Feldkonzentrationsbereichpunkts der Zonenplatte 214 der strukturierten Metallschicht 134 für eine vordefinierte Wellenlänge λᵣₑₛ bzw. einen vordefinierten Wellenlängenbereich befindet. Die Metallschicht 134 kann aus bei CMOS-Prozesses verwendeten Metallen, wie z.B. Aluminium, bestehen. Die dielektrische Schicht 136 kann beispielsweise Siliziumdioxid (SiO₂) aufweisen.

Fig. 15b zeigt schematisch eine Seitenansicht eines integrierten Sensorelements 11 gemäß einem weiteren Ausführungsbeispiel der vorliegenden Erfindung.

Das integrierte Sensorelement 11 weist in Nähe des Pixelsensors 14 eine weitere Metallschicht 252 mit einer Öffnung 254 auf. Dabei kann die Öffnung gemäß Ausführungsformen kreisförmig ausgestaltet sein. Durch diese zusätzliche Metallschicht 252 kann die spektrale Trennung des in Fig. 15a gezeigten integrierten Sensorelements nochmals verbessert werden. Dabei ist zu bemerken, dass die zusätzliche Metallschicht 252 mit der Öffnung 254 nicht zwingend erforderlich ist, wobei die Schicht 252 beispielsweise die zum Pixelsensor nächstgelegene oder beabstandete Metallschicht ist.

Der Abstand d zwischen dem Pixelsensor 14 und der obersten Metallschicht des integrierten Sensorelements liegt in einer Größenordnung der gewünschten Resonanzwellenlänge λᵣₑₛ. Für den optischen Spektralbereich und einen 0,18 µm CMOS-Prozess, liegt der Abstand d im Bereich von ca. 2 µm. Die Zonenplatte 214 der strukturierten Metallschicht wird also vorzugsweise mit sehr kurzer Brennweite realisiert. Mit modernen CMOS-Prozessen kann man aber sehr feine Zonen und damit sehr kurze Brennweiten erreichen, so dass der Pixelsensor 14 im Feldkonzentrationsbereich der Zonenplatte 214 platziert werden kann.

Die Radien für jede Zone in der oberen Metallschicht und der Durchmesser der Öffnung 254 der unteren Metallschicht 252 werden vorzugsweise so gewählt, dass sich bis zum Beginn des Pixelsensors 14 nur eine bestimmte Wellenlänge, d.h. die Resonanzwellenlänge λᵣₑₛ bzw. ein bestimmter Wellenlängenbereich ausbreiten kann.

Fig. 16 zeigt ein Beispiel für eine Sub-Lambda-Zonenplatte 214, welche lediglich exemplarisch drei transparente Kreisringe, nämlich erster, zweiter und dritter Ordnung von innen aus gezählt, und vier nicht transparente Kreisringe aus Metall umfasst. Zonenplatten weisen in der Praxis meist 20 oder mehr Zonen auf. Der Übersichtlichkeit halber sind hier nur die ersten drei Zonen dargestellt.

Die Zonenplatte 214 der Metallschicht 134 besitzt eine fokussierende Wirkung. Bei entsprechendem Verhältnis der Radien der transparenten Zonen 234 und der nicht transparenten Zonen 236 in einem bestimmten Abstand von der Zonenplatte 214 entsteht für eine bestimmte Wellenlänge eine Konzentration der auftreffenden elektromagnetischen Strahlung ähnlich einem Brennpunkt. Eine an oder zumindest in der Nähe dieser Stelle platzierte Photodiode kann nun von der geöffneten Metallschicht 252, so abgedeckt werden, dass nur die elektromagnetische Strahlung bzw. das Licht der gewünschten Wellenlänge zumindest näherungsweise verlustfrei auf die Photodiode 14 trifft, während andere Wellenlängen ausgefiltert werden. Durch die Metallschicht 252 mit der Öffnung 254 wird die spektrale Trennung deutlich verbessert.

In dem Fall der exemplarisch dargestellten Sub-Lambda-Zonenplatte nimmt die Zonenbreite der transparenten Zonen 234 mit zunehmender Ordnungszahl bzw. mit zunehmendem Abstand vom Zentrum ab. Gleiches gilt innerhalb der nichttransparenten Zonen dazwischen. Zusätzlich ist nach dem Beispiel von Fig. 16 die Zonenbreite zumindest einer der transparenten Zonen 234 kleiner als die gewünschte Durchlasswellenlänge, wie z.B. 2 µm oder 1,2 µm, wie z.B. die 2. bis zur letzten Ordnung.

Der für die Durchlasswellenlänge aus der Zonenplatte 214 resultierende Feldkonzentrationsbereich kann, wie bereits erwähnt, beispielsweise bis 20 µm von der Zonenplatte entfernt sein. Dabei befindet sich in diesem Bereich bei kollimierter Beleuchtung mit der Durchlasswellenlänge beispielsweise 90% der transmittierten Leistung, die beispielsweise 50% der ankommenden Leistung oder weniger entspricht, und dieser Bereich hat beispielsweise eine laterale Ausdehnung, die beispielsweise weniger als ein Halb einer lateralen Ausdehnung der Zonenplatte - gemessen am äußersten Rand der transparenten Zone höchster Ordnung - aufweist.

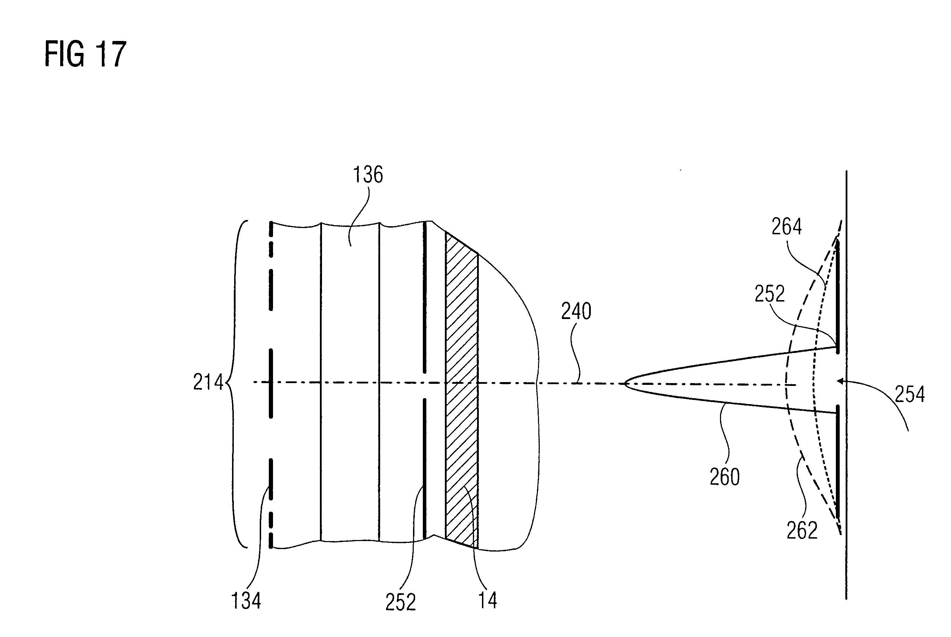

Fig. 17 zeigt ein erläuterndes Beispiel für drei Feldverteilungen 260, 262, 264 für drei unterschiedliche Wellenlängen in der Nähe des Pixelsensors 14.

Aus Fig. 17 lässt sich erkennen, dass die elektromagnetische Feldkonzentration 260 für eine Resonanzwellenlänge λᵣₑₛ in der Nähe des entsprechenden Feldkonzentrationsbereichs der Zonenplatte 214 am höchsten ist. Das bedeutet, dass für die Resonanzwellenlänge λᵣₑₛ die ganze elektromagnetische Energie bzw. ein Großteil davon von dem Pixelsensor 14, insbesondere einer Photodiode, detektiert werden kann, während für andere Wellenlängen die entsprechenden elektromagnetischen Feldkonzentrationen 262, 264 geringer sind, d.h. nur ein kleiner Anteil der jeweiligen elektromagnetischen Strahlung eine PN-Übergang der Photodiode 14 erreicht. Obwohl die mit der Öffnung versehene Metallplatte 252 die spektrale Selektivität zusätzlich erhöht, gilt das im Vorhergehenden beschriebene gleichermaßen für Ausführungsformen ohne die Metallschicht 252. Durch die erhöhte spektrale Selektivität bei der Kombination aus Zonenplatte 214 und einer direkt vor der Photodiode 14 liegenden Öffnung 254 der Metallschicht 252 wird darin eine bevorzugte Ausführungsform der vorliegenden Erfindung zu sehen sein.

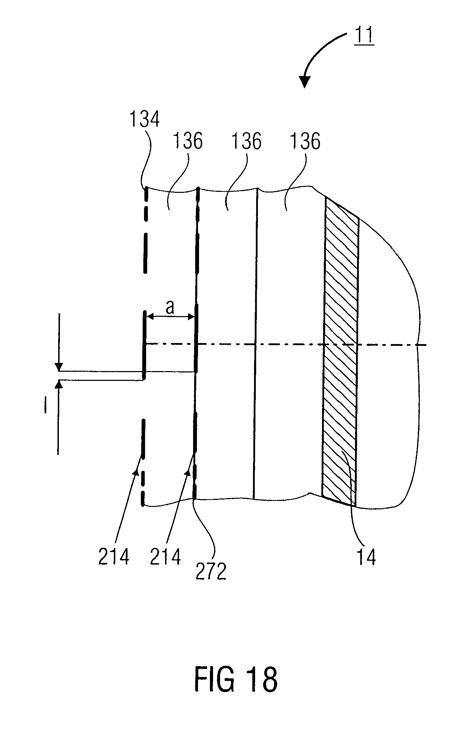

Eine weitere Ausführungsform eines integrierten Sensorelements für einen erfindungsgemäßen multispektralen Bildsensor ist in Fig. 18 gezeigt.

Fig. 18 zeigt ein integriertes Sensorelement 270, welches in einem Abstand a von der Zonenplatte 214 der strukturierten Metallschicht 134 eine zweite um 1 lateral versetzte Zonenplatte in einer zweiten strukturierten Metallschicht 272 aufweist.

Die Funktion der in Fig. 18 gezeigten Struktur ist ähnlich zu der anhand der Fig. 15b und 17 beschriebenen Strukturen. Die strukturierten Metallschichten 134 und 272 mit Zonenplattenstruktur weisen einen lateralen Versatz um den Abstand 1 auf, um eine bessere spektrale Trennung erzielen zu können. Dabei liegt der laterale Versatz 1 zwischen den Zonenplattenstrukturen der verschiedenen Metallschichten in einer Größenordnung von 2 mal der gewünschten Wellenlänge λᵣₑₛ bzw. des gewünschten Wellenlängenbereichs.

Eine weitere Möglichkeit zur spektralen Trennung besteht darin, das Verhältnis der Radien der Zonen der Schichten 134 und 272 leicht unterschiedlich zu wählen. In diesem Fall hat die Metallschicht 134 eine beugende und fokussierende Wirkung und die Metallschicht 272 eine zusätzlich filternde Wirkung, die nur die gewünschte Resonanzwellenlänge λᵣₑₛ hindurchlässt. Ferner ist eine Kombination obiger Möglichkeiten möglich, nämlich der laterale Versatz der vertikal beabstandeten Zonenplattenstrukturen bei gleichzeitiger Veränderung ihrer Zonenradien.

Nachdem im Vorhergehenden Aufbau und Funktionsweise von integrierten Sensorelementen gemäß Ausführungsbeispielen eingehend beschrieben wurden, soll im Nachfolgenden noch auf integrierte multispektrale Bildsensoren auf Basis der integrierten Sensorelemente mit Zonenplattenstrukturen eingegangen werden.

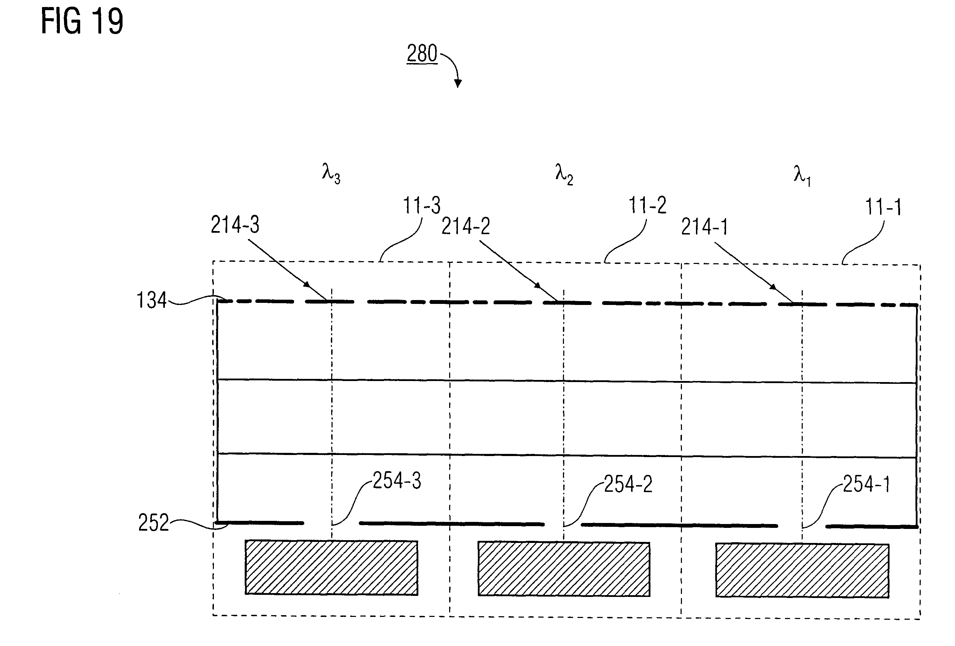

Fig. 19 zeigt dazu eine schematische Seitenansicht eines integrierten multispektralen Bildsensors bzw. Spektrometers 280 auf CMOS-Basis, welcher eine Mehrzahl von gemeinsamen auf einem Substrat integrierten Sensorelementen 11 aufweist.

In Fig. 19 sind lediglich exemplarisch drei planar benachbart integrierte Sensorelemente 11 dargestellt, wobei jedes der drei Sensorelemente auf einen unterschiedlichen Wellenlängenbereich bzw. eine unterschiedliche Resonanzwellenlänge λᵣₑₛ abgestimmt ist. Beispielsweise könnte das linke Sensorelement 11-1 auf eine Wellenlänge aus einem ersten Spektralbereich, das mittlere Sensorelement 11-2 auf eine Wellenlänge aus einem zweiten Spektralbereich und das rechte Sensorelement 11-3 auf eine Wellenlänge aus einem dritten Spektralbereich eingestellt sein. Das Zonenplattenarray 214-1, 214-2, 214-3 der strukturierten Metallschicht 134 ist hier auf die jeweiligen Spektralbereiche bzw. Wellenlängen abgestimmt. Dasselbe gilt ebenfalls für die Öffnungen 254-1, 254-2, 254-3.

Wie es im Vorhergehenden bereits erläutert wurde, kann ein Sensorelement beispielsweise durch Adaption der jeweiligen Zonenplatte bzw. der Radien der unterschiedlichen Zonen auf eine vorbestimmte Resonanzfrequenz λᵣₑₛ eingestellt werden. In dem in Fig. 19 gezeigten Ausführungsbeispiel weisen somit die Strukturen der Zonenplatten 214-1, 214-2 und 214-3 der benachbarten Sensorelemente unterschiedliche Radien der transparenten und nicht transparenten Ringe auf. Des Weiteren könnten die Abstände und Abmessungen der Lochöffnungen 254-1, 254-2 und 254-3 variieren. Die Metallschicht 252 mit den Lochöffnungen 254-1, 254-2, 254-3 kann bei einem Farbsensor also in unterschiedlichen Ebenen entsprechend den Abständen der Lochöffnungen 254-1, 254-2 und 254-3 zu den Zonenplatten 214-1, 214-2 und 214-3 verlaufen.

Gemäß einem weiteren Ausführungsbeispiel könnten die Metallschicht 252 auch weggelassen werden, wie es im Vorhergehenden bereits beschrieben wurde.

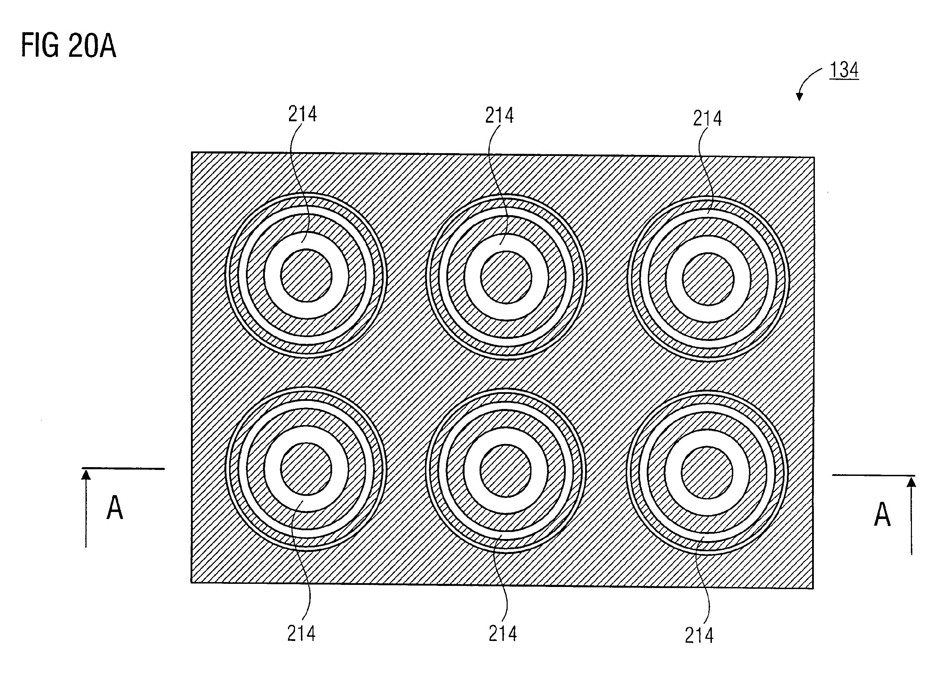

An dieser Stelle soll noch auf den Fall eingegangen werden, dass der Pixelsensor 14 von seinen Abmessungen her größer ist als eine einzelne Zonenplatte 214. In diesem Fall sind die Metallschichten array-förmig strukturiert, wie es in der schematischen Draufsicht in Fig. 20a gezeigt ist.

Fig. 20a zeigt die Draufsicht auf eine array-förmig strukturierte Metallschicht 134, welche 2x3 identische Zonenplattenstrukturen 214 aufweist. Ein unter der strukturierten Metallschicht 134 liegender Pixelsensor 14 ist dabei größer als ein einzelnes Mikroelement (mit einer Zonenplatte) der Struktur und wird von der Metallschicht bzw. der Gesamtstruktur vollständig abgedeckt. D.h., um einen Pixelsensor 14 vollständig abzudecken, kann ein integriertes Sensorelement gemäß Ausführungsbeispielen auch eine Mehrzahl von identischen Zonenplattenstrukturen 214 aufweisen.

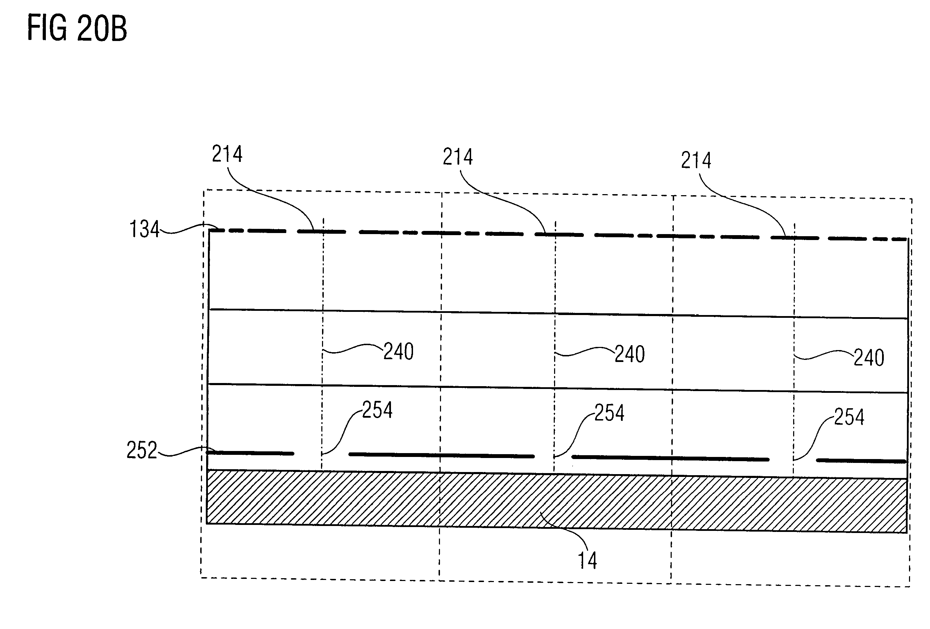

Fig. 20b zeigt den Querschnitt bzw. die Seitenansicht A-A des in Fig. 20a in Draufsicht gezeigten Sensorelements. In diesem Beispiel wird die Filterfunktion erfüllt durch eine Kombination aus den Zonenplatten 214 und den Öffnungen 254, die im Vorhergehenden bereits beschrieben wurden. Die einzelnen Zonenplatten 214 des Zonenplattenarrays der oberen Metallschicht 134 sind dabei genau zentriert bezüglich der Öffnungen 254 der unteren Metallschicht 252, was durch die Symmetrieachsen 240 in Fig. 20b angedeutet ist. Wie im Vorhergehenden bereits beschrieben wurde, könnte statt der in Fig. 20b gezeigten Öffnungen 254 die zweite strukturierte Metallschicht 284 auch einen um 1 lateral versetzten zweiten Zonenplattenarray aufweisen.

Nachdem im Vorhergehenden detailliert auf Sensorelemente mit Zonenplattenstrukturen eingegangen wurde, werden im Nachfolgenden Ausführungsbeispiele von Sensorelementen eines erfindungsgemäßen multispektralen Bildsensors mit Metallschichtstrukturen beschrieben, die den Plasmon-Polariton-Resonanz-Effekt erlauben.

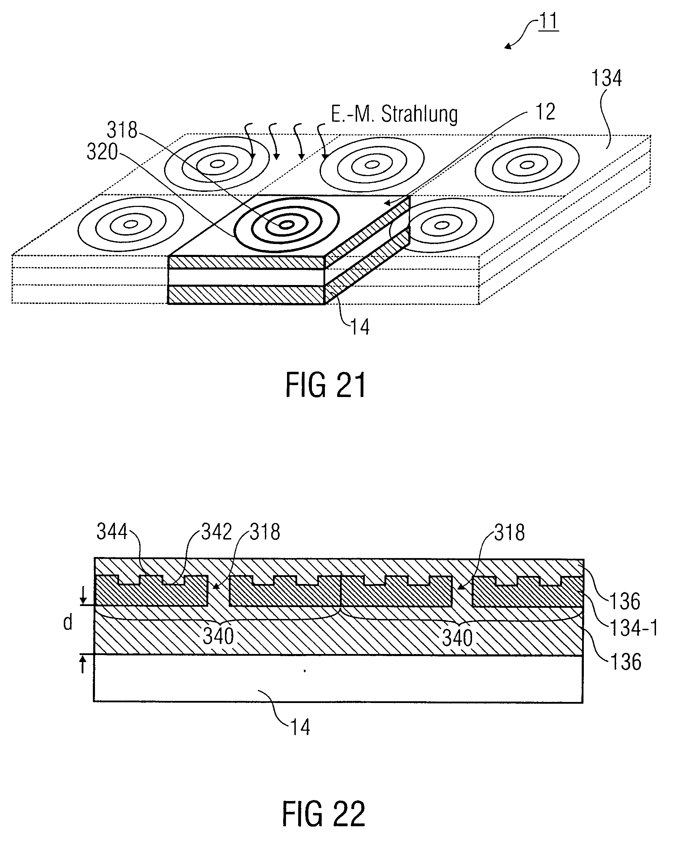

Dazu zeigt Fig. 21 ein integriertes Sensorelement 11 für elektromagnetische Strahlung 118 mit einem Pixelsensor 14 und einer strukturierten Metallschicht 134, wobei zur Verdeutlichung des Aufbaus des integrierten Sensorelements 11 ein Ausschnitt besonders hervorgehoben ist.

Die Metallschicht 134 ist strukturiert, um ansprechend auf elektromagnetische Strahlung 118 eines vorbestimmten Durchlasswellenlängenbereichs bzw. einer vorbestimmten Resonanzwellenlänge λᵣₑₛ einen Plasmon-Polariton-Resonanz-Effekt zu ermöglichen. Der Pixelsensor 14 und die strukturierte Metallschicht 134 sind gemäß Ausführungsbeispielen gemeinsam auf einem Substrat, insbesondere einem Halbleitersubstrat, integriert, so dass sich aufgrund des Plasmon-Polariton-Resonanz-Effekts für den Durchlasswellenlängenbereich eine höhere Transmission durch die Metallschicht 134 zu dem Pixelsensor 14 ergibt als für den Durchlasswellenlängenbereich umgebende Wellenlängen.

Gemäß Ausführungsbeispielen weist die Metallschicht 134 eine Öffnung 318 mit Subwellenlängenabmessung auf. Damit die auftreffende elektromagnetische Strahlung 118 Oberflächenplasmonen bewirken kann, ist die Subwellenlängenöffnung 318 gemäß Ausführungsbeispielen von rotationssymmetrischen periodisch angeordneten Rillen 320 um die Öffnung umgeben. Bei geeigneter Dimensionierung der Öffnung 318 und der Rillen 320 kann eine resonante Interaktion von der elektromagnetischen Strahlung und den Oberflächenplasmonen der strukturierten Metallschicht 134 zu der im Vorhergehenden bereits erwähnten verstärkten außergewöhlichen Übertragung in dem vorbestimmten Wellenlängenbereich führen.

Wenn die elektromagnetische Strahlung 118 auf die erste, dem Pixelsensor 14 abgewandte Seite der strukturierten Metallschicht 134 trifft, breitet sich ausgehend von der Subwellenlängenöffnung 318 jenseits der zweiten, dem Pixelsensor 14 zugewandten Seite der strukturierten Metallschicht 134 gerichtete elektromagnetische Strahlung des vorbestimmten Wellenlängenbereichs bzw. der Resonanzwellenlänge λᵣₑₛ aus.

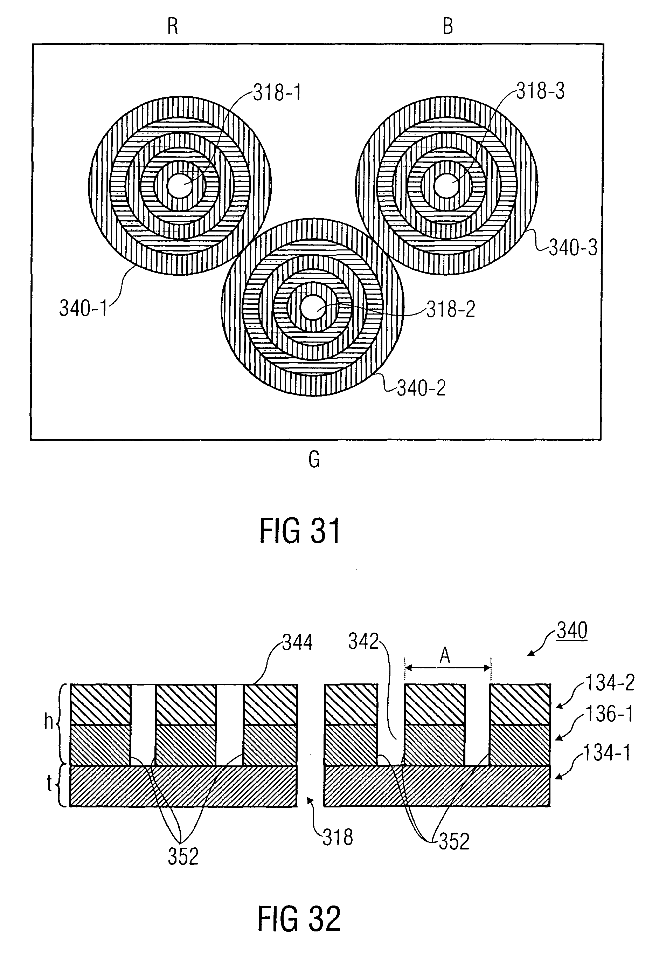

An dieser Stelle soll bemerkt sein, dass es sich bei dem in Fig. 21 schematisch dargestellten integrierten Sensorelement 11 lediglich um ein Element einer größeren Sensorstruktur mit einer Mehrzahl von integrierten Sensorelementen handeln kann, wie es später noch anhand von Fig. 31 beschrieben wird.

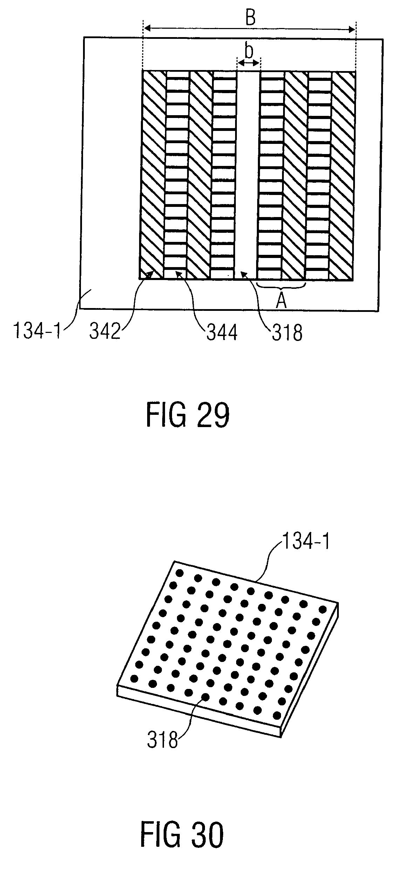

Des Weiteren sind auch nicht rotationssymmetrische Oberflächenstrukturen der Metallschicht 134 denkbar, welche den Plasmon-Polariton-Resonanz-Effekt hervorrufen können, wie beispielsweise eine schlitzförmige Öffnung mit parallel dazu angeordneten Rillen oder eine matrixähnliche Anordnung von Subwellenlängenöffnungen, wie es in Fig. 30 gezeigt ist.

Integrierte Sensoren bzw. Sensorelemente für elektromagnetische Strahlung gemäß Ausführungsbeispielen lassen sich mit CMOS-Prozessen, wie beispielsweise einem CMOS-Opto-Prozess, realisieren, ohne dass zusätzliche Prozessschritte oder weitere Bearbeitungen erforderlich sind.

Ein Verfahren zum Herstellen eines integrierten Sensorelements auf einem Substrat umfasst gemäß Ausführungsbeispielen einen Schritt des Erzeugens einer Photodiode an einer Substratoberfläche des Substrats und ein Aufbringen einer Metallschicht, die strukturiert ist, um ansprechend auf elektromagnetische Strahlung eines vorbestimmten Wellenlängenbereichs einen Plasmon-Polariton-Resonanz-Effekt zu ermöglichen, wobei das Erzeugen und das Aufbringen Teile eines CMOS-Prozesses sind. Dabei sind Photodiode und die Metallschicht so gemeinsam auf dem Halbleitersubstrat integriert, dass sich aufgrund des Plasmon-Polariton-Resonanz-Effekts an der Photodiode eine elektromagnetische Feldkonzentration ausbilden kann, für die die Photodiode empfindlich ist.

Gemäß Ausführungsbeispielen umfasst das Aufbringen der Metallschicht eine Strukturierung der Metallschicht mit einer Öffnung 318 mit einer Subwellenlängenabmessung, wobei die Öffnung von rotationssymmetrischen periodisch angeordneten Rillen um die Öffnung 318 umgeben ist. Dabei weisen die Rillen um die Öffnung Abmessungen und Abstände auf, die geeignet sind, um für den vorbestimmten Wellenlängenbereich in der strukturierten Metallschicht 134 den Plasmon-Polariton-Resonanz-Effekt zu erzeugen.

Gemäß einem weiteren Ausführungsbeispiel umfasst das Aufbringen der Metallschicht eine Strukturierung einer schlitzförmigen Öffnung in der Metallschicht, welche eine Breite kleiner als eine Wellenlänge (Resonanzwellenlänge λᵣₑₛ) des vorbestimmten Wellenlängenbereichs aufweist, und eine Strukturierung von zumindest näherungsweise parallel zu der schlitzförmigen Öffnung verlaufenden Rillen in der Metallschicht 134, wobei die Abmessungen der Rillen geeignet sind, um für den vorbestimmten Wellenlängenbereich in der strukturierten Metallschicht den Plasmon-Polariton-Resonanz-Effekt zu bewirken.

Eine Strukturierung der Metallschicht mit in einem Gitternetz aus matrixförmig angeordneten Subwellenlängenöffnungen 318 ist ebenfalls denkbar, so wie es schematisch in Fig. 30 gezeigt ist. Dabei ist zu bemerken, dass eine Form der Subwellenlängenöffnungen generell beliebig gewählt werden kann.

Ein Zwischenprodukt eines CMOS-Herstellungsprozesses eines integrierten Sensorelemets gemäß Ausführungsbeispielen wurde schematisch anhand von Fig. 8 beschrieben.

Eine lichtempfindliche Oberfläche der Photodiode 14 weist einen Abstand d von der der Photodiode am nächstliegenden Metallschicht 134-1 auf, wobei der Abstand d im Wesentlichen durch den Herstellungsprozess bestimmt wird und kleiner als 20 µm und bevorzugt kleiner als 8 µm ist. Bei 0,18 µm- CMOS-Prozessen ist der Abstand zwischen der Photodiode 14 und der Metallschicht 134-1 kleiner als 2 µm.

Bei integrierten Sensorelementen mit einer strukturierten Metallschicht gemäß Ausführungsbeispielen wird also lediglich die unterste, dem Pixelsensor 14 bzw. der Photodiode am nächsten liegende Metallschicht 134-1 verbleiben. Die darüber liegenden Schichten werden erst gar nicht aufgebracht oder zur Herstellung des integrierten Sensors nach ihrer Aufbringung wieder abgetragen. Die Metallschicht 134-1 kann beispielsweise durch Ätzen strukturiert werden.

Eine gemäß einem Ausführungsbeispiel strukturierte Metallschicht mit darunter liegender Photodiode ist schematisch in einer Seiten- bzw. Schnittansicht in Fig. 22 gezeigt.

Die in Fig. 22 dargestellte strukturierte Metallschicht 134-1 ist von einem Dielektrikum 136 umgeben und weist beispielhaft zwei Strukturelemente 340 auf, die durch die geschweiften Klammern in Fig. 22 gekennzeichnet sind. Ein Strukturelement 340 weist jeweils eine Subwellenlängenöffnung 318 auf, welche beispielsweise kreisförmig oder linienförmig ausgebildet sein kann. Bei einer kreisförmigen bzw. rotationssymmetrischen Subwellenlängenöffnung 318 sind die die Öffnung 18 umgebenden Rillen aus Vertiefungen 342 und Erhöhungen 344 ebenfalls rotationssymmetrisch angeordnet. Bei einer linienförmigen bzw. schlitzförmigen Subwellenlängenöffnung 318 sind die Vertiefungen 342 und Erhöhungen 344 parallel zu der linienförmigen Erhöhung 318 angeordnet.

Durch die Subwellenlängenöffnungen 318 kann durch den Plasmon-Polariton-Resonanz-Effekt Licht einer vordefinierten Wellenlänge λᵣₑₛ selektiert werden und dann auf den Pixelsensor 14 treffen.

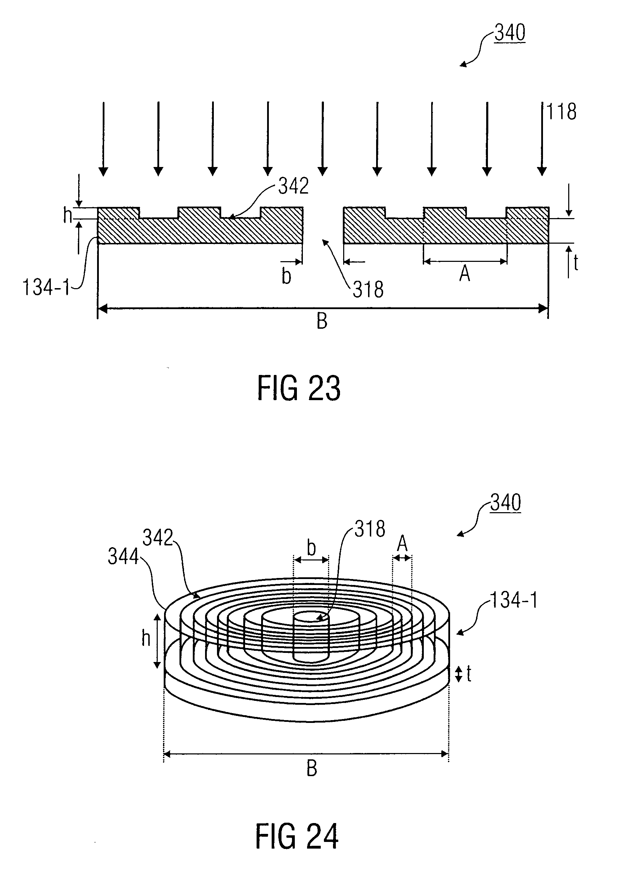

Fig. 23 zeigt ein Einzelelement bzw. ein Strukturelement 340 der in Fig. 22 dargestellten arrayförmigen Struktur in der Metallschicht 134-1.

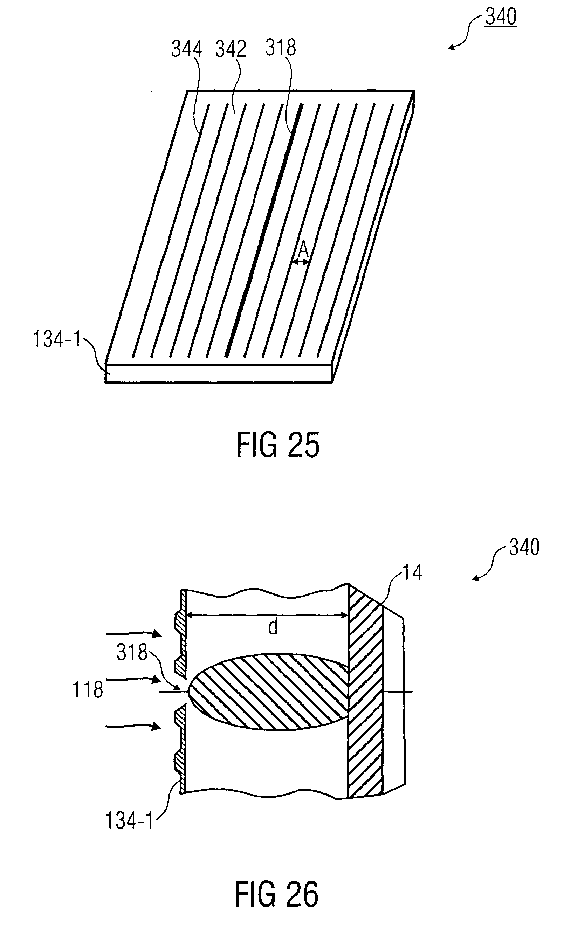

Das in Fig. 23 gezeigte Strukturelement 340 kann rotationssymmetrisch bezüglich der Subwellenlängenöffnung 318 in der Mitte sein, so wie es zur besseren Veranschaulichung in der Perspektivansicht in Fig. 24 gezeigt ist. Bei anderen Ausführungsformen kann das Strukturelement 340 eine streifenförmige oder linienartige Struktur aufweisen, sowie es zur besseren Veranschaulichung in der Perspektivansicht in Fig. 25 gezeigt ist. Eine Draufsicht des in Fig. 25 dargestellten Strukturelements 340 mit streifenförmiger oder linienartiger Öffnung 318 und Struktur ist zudem in Fig. 29 gezeigt.

Ein Strukturelement 340 gemäß Ausführungsbeispielen umfasst einen Bereich der Metallschicht 134-1, der eine mit Vertiefungen 342 und Erhöhungen 344 periodisch strukturierte Oberfläche der Periode A und eine Subwellenlängenöffnung 318 aufweist, die im Zentrum der Struktur 340 liegt. Für eine vorbestimmte Resonanz-Wellenlänge-λᵣₑₛ einer auf die Struktur 340 einfallenden elektromagnetischen Strahlung 118 entsteht der Plasmon-Polariton-Resonanz-Effekt. Dieser Effekt bewirkt, dass für die Resonanzwellenlänge λᵣₑₛ durch die Subwellenlängenöffnung 318, beispielsweise mehr als 15% der einfallenden elektromagnetischen Strahlung tritt, obwohl ein Flächenverhältnis der Öffnung 318 zu der Fläche des gesamten Elements 340 sehr klein ist. Für andere Wellenlängen als die Resonanzwellenlänge λᵣₑₛ entsteht dagegen keine Resonanz und damit nahezu keine Transmission von elektromagnetischer Strahlung der anderen Wellenlängen durch die Öffnung 318. Das bedeutet, dass die Transmission für eine vorbestimmte Wellenlänge λᵣₑₛ durch das Strukturelement 340 vom Flächenverhältnis der Fläche der Öffnung 318 zu der Fläche des gesamten Elements 340 abhängt, sowie von der Periode A der strukturierten Oberfläche bzw. der Erhöhungen 344 und Vertiefungen 342.

Diejenige Periode A, die die höchste Transmission zulässt, hängt unter anderem von der Dicke (t+h) der strukturierten Metallschicht 134-1 ab. Für eine Resonanzwellenlänge λᵣₑₛ von 650 nm könnte die Breite bzw. der Durchmesser b der Öffnung 318 beispielsweise zu 110 nm gewählt werden. das Flächenverhältnis der Fläche der Öffnung 318 zu der Fläche des gesamten Elements 340 könntebeispielsweise 0.01 betragen und A könnte zu 90 nm und t zu 20 nm gewählt werden. An dieser Stelle soll betont werden, dass diese Werte lediglich Beispielswerte darstellen, um eine Vorstellung von möglichen Größenordnungen zu geben. Gemäß Ausführungsbeispielen liegt A in einem Bereich von 10 nm bis 2110 nm. Die Dicke (t+h) der Metallschicht 134-1 liegt bei Ausführungsbeispielen in einem Bereich von 30 nm bis 2500 nm, bevorzugt in einem Bereich von 350 nm bis 550 nm. Die Höhe h der Vertiefung ist natürlich kleiner als die Dicke (t+h) der Metallschicht ^134-1 und liegt bei Ausführungsbeispielen in einem Bereich überhalb von (t+h)/2. Das Flächenverhältnis der Fläche der Öffnung 318 zu der Fläche des gesamten Elements 340 ist bei Ausführungsbeispielen kleiner als 0.3.

Eine Seitenansicht einer weiteren Ausführungsform eines Strukturelements 340 ist in Fig. 32 gezeigt. Sie zeigt eine Möglichkeit, die Rillen des Strukturelements zu erzeugen, die beispielsweise auch in CMOS-Prozessen implementierbar ist, wofür in Fig. 8 exemplarisch ein Beispiel gezeigt wurde.

Fig. 32 zeigt ein Strukturelement bzw. eine Metallstruktur 340, welche(s) eine erste strukturierte Metallschicht 134-1 und eine zweite strukturierte Metallschicht 134-2 mit einem dazwischenliegenden Dielektrikum 136-1 umfasst, durch welches sich wiederum metallische Durchkontaktierungen 352 erstrecken. Die erste strukturierte Metallschicht 134-1 weist eine Subwellenlängenöffnung 318 auf. Die darüber liegenden Durchkontaktierungen 352 und die zweite strukturierte Metallschicht 134-2 sind jeweils strukturiert, um zusammen die periodischen Vertiefungen 342, Erhöhungen 344 und die Subwellenlängenöffnung 318 zu bilden. D.h. an Orten von Vertiefungen 342 und der Subwellenlängenöffnung 318 wurde sowohl Metall der zweiten strukturierten Metallschicht 134-2 entfernt. An Orten der Erhöhungen 344 wurde das Metall der zweiten strukturierten Metallschicht 134-2 nicht entfernt, und die Durchkontaktierungen 352 können dort lateral deckungsgleich mit dem Metall der zweiten Metallstruktur 134-2 in beispielsweise Ringen gebildet sein. Das Metall der Durchkontaktierungen 352 kann zu dem Metall der Metallschichten 134-1 und 134-2 gleich sein oder unterschiedlich. Das Dielektrikum 136-1 füllt sowohl den Zwischenraum in der Öffnung 318 als auch in den entstehenden Rillen bzw. Vertiefungen 342. In der Herstellung wird beispielsweise zunächst die Metallschicht 34-1 aufgebrecht und strukturiert, woraufhin die Durchkontaktierungen an den entsprechenden Stellen gebildet werden. Daraufhin wird dann beispielsweise ein erster Teil des Dielektrikums aufgebracht, um die bis dahin entstandenen Vertiefungen zu füllen, woraufhin wieder die zweite Metallschicht 134-2 aufgebracht und strukturiert wird.

Ein entsprechender Aufbau eines Strukturelements 340 mit mehr als zwei strukturierten Metallschichten und mehr als einer Durchkontaktierungsebene 136-1 ist natürlich ebenso denkbar. Ferner sei erneut darauf hingewiesen, dass die Rillen bzw. Vertiefungen und Vorsprünge bzw. Erhöhungen natürlich nicht ringförmig sein müssen sondern auch andere laterale Formen möglich sind, wie z.B. geradlinige Verläufe, wie sie in Fig. 25 gezeigt sind, aber auch andere, wie z.B. rechteckige.

Strukturierte Metallschichten gemäß Ausführungsbeispielen der vorliegenden Erfindung lassen sich im Rahmen von CMOS-Technologie beispielsweise mittels nicht vollständig oder vollständig durchgeätzter Metallschichten realisieren. Auch bei sich ändernden Prozessparametern kann die Strukturperiode A konstant gehalten werden.

In Fig. 26 ist der fokussierende Effekt bzw. der Plasmon-Polariton-Resonanz-Effekt der strukturierten Metallschicht 134-1 gemäß Ausführungsbeispielen schematisch dargestellt.

Die elektromagnetische Strahlung 118 trifft zunächst auf die ganze Fläche des Strukturelements 340. Aufgrund des Plasmon-Polaritron-Resonanz-Effekts konzentriert sich die elektromagnetische Strahlung der Resonanzwellenlänge λᵣₑₛ bzw. des Resonanzwellenlängenbereichs in der Nähe der Subwellenlängenöffnung 318, tritt durch diese hindurch, breitet sich in Richtung Pixelsensor 14 aus, und trifft schließlich auf den Pixelsensor bzw. die Photodiode 14. Dabei ist gemäß Ausführungsbeispielen der Abstand d zwischen der Metallschicht 134-1 und der Photodiode 14 kleiner als die Resonanzwellenlänge λᵣₑₛ, beispielsweise kleiner als 3 µm.

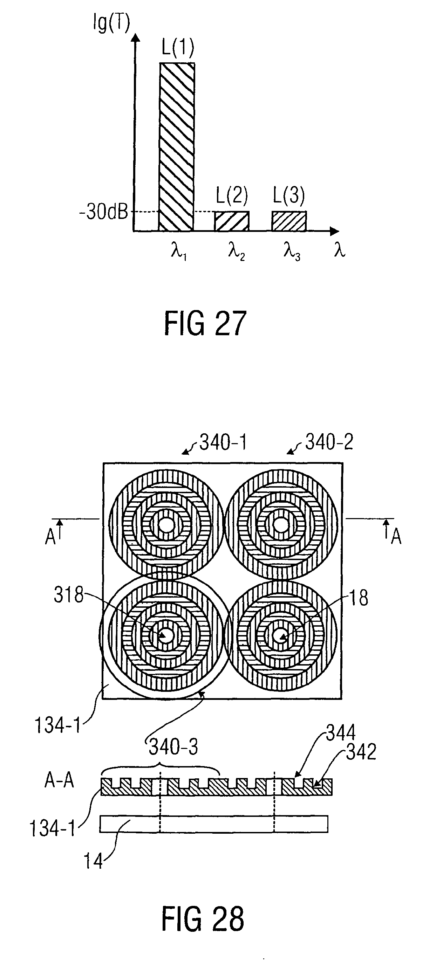

In Fig. 27 ist ein Transmissionverhältnis dreier unterschiedlicher Wellenlängen λ₁, λ₂ und λ₃ für ein Verhältnis b/B = 0.01 dargestellt. Dabei ist die Transmissionsleistung jeweils logarithmisch dargestellt.

Wie sich aus Fig. 27 erkennen lässt, entspricht λ₁ zumindest näherungsweise der Resonanzwellenlänge λᵣₑₛ der gemäß Ausführungsbeispielen strukturierten Metallschicht. Die Subwellenlängenöffnung 318 bzw. deren Breite oder Durchmesser b ist vorzugsweise kleiner als die Resonanzwellenlänge λᵣₑₛ. B kann theoretisch sehr groß gewählt werden, praktisch verkleinert sich die elektromagnetische Feldstärke für die Resonanzwellenlänge λᵣₑₛ aufgrund einer Rauhheit einer Oberfläche der strukturierten Metallschicht. Bei diesen Größenverhältnissen (b/B = 0.01) liegt das Flächenverhältnis der Fläche der Öffnung 318 zu der Fläche des gesamten Elements 340 bei 1 : 10.000, d.h. ohne Resonanzeffekt wird die einfallende elektromagnetische Strahlung 118 bzw. das einfallende Licht, um ca. 40 dB gedämpft. Bei der Resonanzwellenlänge λᵣₑₛ dagegen liegt eine Dämpfung bei weniger als 10 dB vor.

Aus der in Fig. 27 gezeigten Transmission für die drei Wellenlängen λ₁, λ₂ und λ₃ normiert auf λ₁, lässt sich erkennen, dass bei einer Verwendung von strukturierten Metallschichten gemäß Ausführungsbeispielen der vorliegenden Erfindung eine sehr gute spektrale Trennung zwischen verschiedenen Spektralkanälen möglich ist. Es sind gute Dämpfungen für ungewünschte Spektralwerte mit steilen spektralen Flanken möglich.

In der Praxis kann es vorkommen, dass die geometrischen Abmessungen, insbesondere die Ausdehnung B, eines einzelnen Strukturelements 340 kleiner sind als Abmessungen einer darunter liegenden Photodiode 14. In diesem Fall kann ein integriertes Sensorelement realisiert werden, indem in einer Metallschicht eine Mehrzahl von Strukturelementen 340 angeordnet wird, so dass eine Photodiode von der strukturierten Metallschicht vollständig abgedeckt werden kann. Dieser Zusammenhang ist exemplarisch in Fig. 28 gezeigt.

Fig. 28 zeigt eine Draufsicht auf eine strukturierte Metallschicht 134-1 mit vier Strukturelementen 340.

Die vier dargestellten Strukturelemente können gemäß Ausführungsbeispielen identisch ausgeführt sein. Das heißt, die Subwellenlängenöffnungen 318 und die zylindrischen Strukturen bzw. Rillen weisen jeweils die gleichen Abmessungen auf. Dadurch wird es genau einer Resonanzwellenlänge λᵣₑₛ bzw. einem Resonanzwellenlängenbereich ermöglicht, sich durch den Plasmon-Polariton-Resonanz-Effekt bis hin zu dem unter der Metallschicht 134-1 liegenden Pixelsensor bzw. der Photodiode 14 auszubreiten.

Dabei weisen benachbarte Ringe eine unterschiedliche Höhe auf. Das heißt, die Vertiefungen 342 liegen tiefer als die Erhöhungen 344.

Nachdem im Vorhergehenden Aufbau und Funktionsweise von integrierten Sensorelementen mit Plasmon-Polariton-Resonanz-Effekt gemäß Ausführungsbeispielen eingehend beschrieben wurden, soll im Nachfolgenden noch auf integrierte multispektrale Bildsensoren bzw. Spektrometer auf Basis der integrierten Sensorelemente eingegangen werden. Dazu zeigt Fig. 31 exemplarisch eine Draufsicht auf eine strukturierte Metallschicht 134-1 mit drei Strukturelementen 340-1 bis 340-3.

Die in Fig. 31 gezeigten Strukturelemente 340-1 bis 340-3 könnten jeweils auf einen unterschiedlichen Wellenlängenbereich bzw. eine unterschiedliche Resonanzwellenlänge λᵣₑₛ abgestimmt sein, wobei in diesem Fall jedem Strukturelement ein separater Pixelsensor zum Detektieren der jeweiligen Resonanzwellenlänge λᵣₑₛ zugeordnet wird. Beispielsweise könnte ein erstes Strukturelement 340-1 auf eine Wellenlänge aus einem ersten Spektralbereich, ein zweites Strukturelement 340-2 auf eine Wellenlänge aus einem zweiten Spektralbereich und ein drittes Strukturelement 340-3 auf eine Wellenlänge aus einem dritten Spektralbereich eingestellt sein, usw.. Die Strukturelemente 340 der strukturierten Metallschicht sind bei einem multispektralen Bildsensor also auf die jeweiligen Spektralbereiche bzw. Wellenlängen abgestimmt. Dasselbe gilt ebenfalls für die Öffnungen 318-1 bis 318-3. Dabei ist zu bemerken, dass natürlich auch mehrere benachbarte Strukturelemente 340 eines multispektralen Bildsensors auf eine bestimmte Wellenlänge bzw. einen Spektralkanal eingestellt sein können, wenn es die Abmessungen einer Fotodiode erforderlich machen, so wie es im Vorhergehen bereits erläutert wurde. D.h. für jeden Spektralkanal könnte beispielsweise eine Anordnung mit mehreren identischen Strukturelementen gemäß Fig. 28 vorgesehen sein.

Wie es im Vorhergehenden bereits erläutert wurde, kann ein Sensorelement beispielsweise durch Adaption der jeweiligen Strukturelemente 340 auf eine vorbestimmte Resonanzfrequenz λᵣₑₛ eingestellt werden. In dem in Fig. 31 gezeigten Ausführungsbeispiel können somit die Strukturelemente 340 benachbarter Sensorelemente unterschiedliche Radien der Ringe aufweisen. Des Weiteren können die Abmessungen der Lochöffnungen 318-1, 318-2 und 318-3 variieren.

Ausführungsbeispiele umfassen also einen integrierten multispektralen Bildsensor mit einer Mehrzahl von integrierten Sensorelementen, wobei die strukturierten Metallschichten bzw. Strukturelemente 340 der integrierten Sensorelemente ausgebildet sind, um ansprechend auf elektromagnetische Strahlung unterschiedlicher Durchlasswellenlängenbereiche durch den Plasmon-Polariton-Effekt für den jeweiligen Durchlasswellenlängenbereich eine höhere Transmission durch die jeweilige Metallschicht zu dem jeweiligen Pixelsensor zu ermöglichen als für den jeweiligen Durchlasswellenlängenbereich umgebende Wellenlängen.

Zusammenfassend umfasst die vorliegende Erfindung also ein integriertes Spektrometer, dessen integrierte Sensorelemente jeweils auf elektromagnetische Strahlung unterschiedlicher Wellenlängenbereiche eingestellt werden können, so wie es im Vorhergehenden detailliert beschrieben wurde. Das integrierte Spektrometer kann im Rahmen von herkömmlichen CMOS-Prozessen hergestellt werden.

Mit Hilfe von Ausführungsbeispielen der vorliegenden Erfindung besteht die Möglichkeit, im Rahmen eines CMOS-Prozesses ein ein- bzw. zweidimensionales Photodiodenarray zu realisieren, so dass für jede einzelne Photodiode ein entsprechender schmalbandiger Filter für einen bestimmten Spektralbereich aufgebaut wird, und sich ein Effekt wie durch ein dispersives Element (Prisma oder Gitter) in der Spektroskopie ergibt.

Einige der vorhergehenden Ausführungsbeispiele verwendeten als Filterstruktur solche, die als photonischer Kristall ausgebildet waren oder einen Plasmon-Polariton-Effekt ermöglichten. Wie beschrieben ist es möglich, solche Filterstrukturen in einer CMOS-Technologie zu erzeugen, indem die Metallschichten 134 verwendet werden. Insbesondere wurde auch auf die Möglichkeit hingewiesen, dass die unterste, d.h. dem Pixelsensor 14 nächstgelegene, Metallschicht 134-1 als eine Art Blendenschicht verwendet werden könnte, während eine oder mehrere der darüber gelegenen Metallschichten 134-2 bis 134-4 dazu verwendet werden, den photonischen Kristall zu bilden bzw. die den Plasmon-Polariton-Effekt ermöglichende Struktur. Ergänzend für diese Ausführungsbeispiele sei darauf hingewiesen, dass der Abstand zwischen der dem Pixelsensor 14 nächstgelegenen Metallschicht, die zur Bildung des photonischen Kristalls bzw. der den Plasmon-Polariton-Effekt ermöglichenden Struktur beiträgt, wie z.B. der Metallschicht 134-2, zu der als Blendenschicht fungierenden Metallschicht 134-1 vorzugsweise kleiner oder gleich der mittleren Durchlasswellenlänge des Durchlassbereiches der Durchlasscharakteristik der Filterstruktur ist, die sich durch den photonischen Kristall bzw. die Plasmon-Polariton-Effekt ermöglichende Struktur in Kombination mit der Blendenschicht ergibt. Liegen beispielsweise die Mittendurchlasswellenlängen der Subpixel im sichtbaren Spektrum so kann beispielsweise der Abstand zwischen den vorbesagten Metallschichten kleiner oder gleich 400 nm sein. Die mittlere Durchlassfrequenz könnte als diejenige Frequenz betrachtet werden, bei der das Integral über die Durchlasscharakteristik 50% des Gesamtintegrals beträgt. Die Durchlassbreite der Bandpässe der einzelnen Subpixel könnte beispielsweise kleiner 100 nm sein und vorzugsweise kleiner als 50 nm. Lediglich vorsichtshalber wird darauf hingewiesen, dass abhängig von den Gegebenheiten zwischen den vorbesagten Metallschichten oder der Blendenmetallschicht und dem Pixelsensor auch eine oder mehrere andere Metallschichten liegen könnten, wenn andererseits die soeben erwähnten Maximalabstände eingehalten werden können. Wenn diese Maximalabstände nämlich eingehalten werden, sitzt die Blendenschicht in einem Nahfeldabstand zu dem photonischen Kristall bzw. der dem Plasmon-Polariton-Effekt ermöglichenden Struktur, und durch geeignetes Platzieren von einer oder mehreren Öffnungen in der Blendenschicht an Orten, an denen die Feldkonzentration des photonischen Kristalls bzw. die Plasmon-Polariton-Struktur bei der gewünschten Durchlassfrequenz Maxima aufweist, kann die Wellenlängenselektivität der so entstehenden Filterstruktur relativ zu dem Zustand, da die Blendenschicht fehlt, gesteigert werden.

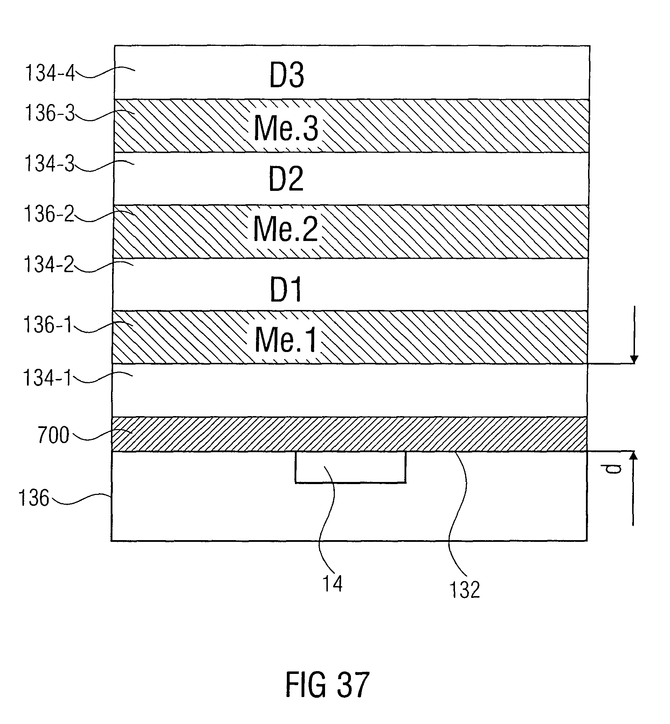

Schließlich sei noch darauf hingewiesen, dass es nicht unbedingt notwendig ist, dass Metallschichten zur Definition der Filterstruktur verwendet werden, und zwar unabhängig davon, ob es sich gemäß obiger Ausführungsbeispiele um einen photonischen Kristall, eine Zonenplattenoptik oder eine Plasmon-Polariton-Struktur handelt. Vielmehr kann statt oder zusätzlich zu den dort gezeigten strukturierten Metallschicht auch eine strukturierte Polysiliziumschicht verwendet werden. Die Fig. 37 zeigt wie Fig. 8 ein Ausführungsbeispiel eines in CMOS-Technik hergestellten Multispektralsensors. Wie es zu sehen ist, existieren nach dieser CMOS-Technik die gleichen Schichten wie in Fig. 8. Allerdings ist zwischen der untersten Metallschicht 133-1 und dem Halbleitersubstrat 136 eine Polysiliziumschicht 700 angeordnet. Gemäß einem Ausführungsbeispiel der vorliegenden Erfindung ist es nun auch möglich, ein Filterelement durch Kombination des Pixelsensorsensors 131 mit einer Filterstruktur zu bilden, die nicht nur durch die Metallschichten sondern auch durch Strukturierung der Polysiliziumschicht 700 erhalten wird, also in Kombination mit einer Strukturierung einer oder mehrerer der Metallschichten 133-1 bis 133-3. Gemäß alternativen Ausführungsbeispielen wäre natürlich auch eine Kombination mehrerer Polysiliziumschichten möglich, falls solche Schichten in der verwendeten Technologie vorhanden sind. Wie es zu sehen ist, liegt die Polysiliziumschicht 700 direkt auf dem Substrat 136 auf. Hierzu gibt es natürlich auch Alternativen. Ebenso wie die Metallschichten könnte die Polysiliziumschicht 700 auch weiter von dem Halbleitersubstrat 136 entfernt sein, wenn dies ein jeweiliger CMOS-Prozess zulässt. Auch eine Bildung einer Filterstruktur durch Strukturierung lediglich einer Polysiliziumschicht wäre möglich. Ferner wäre statt der Verwendung von Polysilizium auch die Verwendung von anderem polykristallinen Halbleitermaterial möglich. Die Strukturierung der Schicht 700, um eine geeignete, oben gezeigte Bandpassfilterwirkung zu erhalten, kann auf die gleiche Art und Weise bzw. mit den gleichen Abmessungen und Formen vorgenommen werden, wie es im Vorhergehenden Bezug nehmend auf die Metallschichten beschrieben worden ist. Schließlich kann die Polysiliziumschicht 700 auch als die vorerwähnte Blendenschicht fungieren, zum Beispiel wenn die Bandpasswellenlänge in einem Spektralbereich liegt, bei welchem die Polysiliziumschicht absorbierend wirkt, bzw. wenn die Polysiliziumschicht für den Frequenzmessbereich des Multispektralsensors absorbierend wirkt.

Schließlich sei noch erwähnt, das die oben beschrieben CMOS-Metallschichten, wie z.B. die CMOS-Metall1-Schicht, teilweise neben den Öffnungen zur Bildung der Filterstrukturen elektrische Verbindungen bzw. Leiterbahnen aufweisen können, die elektrischen Verbindungen zwischen Schaltungselementen (z.B. Transistoren) des integrierten Bildsensors herstellen. Das gilt auch für die soeben gezeigte Polysiliziumschicht. Auch die kann zur Bildung von Leiterbahnen oder Bauelementen lateral beabstandet von den eigentlichen Pixelsensoren verwendet werden.

Abschließend ist darauf hinzuweisen, dass die vorliegende Erfindung nicht auf die jeweiligen beschriebenen Bauteile oder die erläuternden Vorgehensweisen beschränkt ist, da diese Bauteile und Verfahren variieren können. Die hier verwendeten Begriffe sind lediglich dafür bestimmt, besondere Ausführungsformen zu beschreiben und werden nicht einschränkend verwendet. Wenn in der Beschreibung und in den Ansprüchen die Anzahl oder unbestimmte Artikel verwendet werden, beziehen sich diese auch auf die Mehrzahl dieser Elemente, solange nicht der Gesamtzusammenhang eindeutlich etwas anderes deutlich macht. Dasselbe gilt in umgekehrter Richtung.

Obige ausführungsbeispiele zeigen somit unter anderem einen Multispektraler Bildsensor 10; 20; 30; 40, der mittels eines CMOS-Prozesses gefertigt ist und ein zweidimensionales Array aus Superpixeln aufweist, wobei jeder Superpixel wenigstens fünf Sensorelemente 11 aufweist mit jeweils einem Pixelsensor 14; einer Filterstruktur 12 mit wenigstens einer strukturierten Schicht aus Metall oder polykristallinem Halbleitermaterial des CMOS-Prozesses, die ansprechend auf elektromagnetische Strahlung eines Wellenlängenbereichs eine höhere Transmission durch die Filterstruktur zu dem Pixelsensor 14 ergibt als für den Wellenlängenbereich umgebende Wellenlängen; wobei die wenigstens fünf Sensorelemente 12 gemeinsam auf einem Halbleitersubstrat 16 integriert sind und paarweise auf unterschiedliche Wellenlängenbereiche ausgelegt sind. Die erste Filterstruktur 12-1 kann aus einem ersten Array 124-1 aus ersten photonischen Kristallen 122 gebildet sein, um eine der ersten Filterstruktur 12-1 zugewandte Oberfläche des ersten Pixelsensors 14-1 vollständig abzudecken, und eine zweite Filterstruktur 12-2 kann aus einem zweiten Array 124-2 aus zweiten photonischen Kristallen 122 gebildet sein, um eine der zweiten Filterstruktur 12-2 zugewandte Oberfläche des zweiten Pixelsensors 14-2 vollständig abzudecken. Die Größenordnung der Abmessungen und Abstände der obigen Mikroelemente 148-1 kann in einem Bereich zwischen dem 0,3-fachen und dem 10-fachen der ersten Wellenlänge liegen, und die Größenordnung der Abmessungen und Abstände der obigen Mikroelemente 148-2 in einem Bereich zwischen dem 0,3-fachen und dem 10-fachen der zweiten Wellenlänge. Die ersten und zweiten Mikroelemente 148 können als Split-Ring-Resonatoren ausgebildet sein. Die strukturierten Schichten des wenigstens einen ersten und zweiten photonischen Kristalls 122-1;122-2 können jeweils mit metallischen Durchkontaktierungen verbunden sein, um dreidimensionale Mikroelemente des wenigstens einen ersten und zweiten photonischen Kristalls 122-1;122-2 zu erhalten. Obige erste und zweite Zonenplattenstruktur 214-1;214-2 können jeweils eine eine Raumwinkelverteilung beeinflussende Wirkung aufweisen. Die oben genannte erste weitere strukturierte Schicht 272 kann eine dem ersten Pixelsensor 14-1 am nächsten liegende aber zu demselben beabstandeten Schicht aus Metall oder polykristallinem Halbleitermaterial in dem Halbleitersubstrat 16 sein, und bei dem der zweiten weiteren strukturierten Schicht 272 kann es sich um eine dem zweiten Pixelsensor 14-2 am nächsten liegende Schicht aus Metall oder polykristallinem Halbleitermaterial in dem Halbleitersubstrat 16 handeln. Obige erste Zonenplattenstruktur 214-1 kann ein erstes Array von Zonenplatten aufweisen, die jeweils einen Teil des ersten Feldkonzentrationsbereiches definieren, und die Zonenplatten des ersten Arrays können gemeinsam dem ersten Pixelsensor 14-1 zugeordnet sein, und obige zweite Zonenplattenstruktur 214-2 kann ein zweites Array von Zonenplatten aufweisen, die jeweils einen Teil des zweiten Feldkonzentrationsbereiches definieren, und die Zonenplatten des zweiten Arrays können gemeinsam dem zweiten Pixelsensor 14-2 zugeordnet sein. Zischen einer dem ersten Pixelsensor 14-1 zugewandten Seite der ersten Filterstruktur 12-1 und dem ersten Pixelsensor 14-1 kann eine erste strukturierte Schicht 134-1 des CMOS-Prozesses aus Metall oder polykristallinem Halbleitermaterial angeordnet sein, und zwischen einer dem zweiten Pixelsensor 14-2 zugewandten Seite der zweiten Filterstruktur 12-2 und dem zweiten Pixelsensor 14-2 kann eine zweite strukturierte Schicht 134-2 des CMOS-Prozesses aus Metall oder polykristallinem Halbleitermaterial angeordnet sein. Dabei kann der Feldkonzentrationsbereich wellenlängenabhängig sein, so dass eine optische Kopplung zwischen der ersten Filterstruktur und dem ersten Pixelsensor 14-1 auf einen ersten Filterwellenlängentransmissionsbereich begrenzt ist und die erste strukturierte Schicht 134-1 eine erste Öffnung 152-1 aufweist, die angeordnet ist, so dass die optische Kopplung von dem ersten Filterwellenlängentransmissionsbereich weiter eingeschränkt wird, und so dass eine optische Kopplung zwischen der zweiten Filterstruktur und dem zweiten Pixelsensor 14-2 auf einen zweiten Filterwellenlängentransmissionsbereich begrenzt ist und die zweite strukturierte Schicht 134-2 eine zweite Öffnung 152-2 aufweist, die angeordnet ist, so dass die optische Kopplung von dem zweiten Filterwellenlängentransmissionsbereich weiter eingeschränkt wird. Die wenigstens eine strukturierte Schicht 134-1 einer ersten Filterstruktur 12-1 kann ansprechend auf elektromagnetische Strahlung 118 eines ersten Wellenlängenbereichs einen Plasmon-Polariton-Resonanz-Effekt ermöglichen, und die wenigstens eine strukturierte Schicht 134-1 einer zweiten Filterstruktur 12-1 kann ansprechend auf elektromagnetische Strahlung 118 eines zweiten Wellenlängenbereichs einen Plasmon-Polariton-Resonanz-Effekt ermöglichen. Dabei kann die wenigstens eine strukturierte Schicht 134-1 der ersten Filterstruktur 12-1 eine erste Öffnung 318-1 mit Subwellenlängenabmessung aufweisen, wobei die erste Öffnung 318-1 von periodisch angeordneten ersten Rillen 342, 344 um die erste Öffnung 318-1 umgeben ist, die Abmessungen und Abstände zueinander aufweisen, die geeignet sind, um für den ersten Wellenlängenbereich in der wenigstens eine strukturierte Schicht 134-1 der ersten Filterstruktur 12-1 den Plasmon-Polariton-Resonanz-Effekt zu erzeugen, und die wenigstens eine strukturierte Schicht 134-1 der zweiten Filterstruktur 12-2 kann eine zweite Öffnung 318-2 mit Subwellenlängenabmessung aufweist, wobei die zweite Öffnung 318-2 von periodisch angeordneten zweiten Rillen 342, 344 um die zweite Öffnung 318-2 umgeben ist, die Abmessungen und Abstände zueinander aufweisen, die geeignet sind, um für den zweiten Wellenlängenbereich in der wenigstens einen strukturierten Schicht 134-1 der zweiten Filterstruktur 12-1 den Plasmon-Polariton-Resonanz-Effekt zu erzeugen. Die erste Öffnung 318-1 und die ersten Rillen und die zweite Öffnung 318-2 und die zweiten Rillen können jeweils rotationssymmetrisch sein. Ein Flächenverhältnis einer Fläche der ersten Öffnung 318-1 zu einer umschlossenen Fläche einer rotationssymmetrischen ersten Rille um die erste Öffnung mit einem größten Durchmesser (B) kann kleiner als 0.4 sein, und ein Flächenverhältnis einer Fläche der zweiten Öffnung 318-2 zu einer umschlossenen Fläche einer rotationssymmetrischen zweiten Rille um die zweite Öffnung mit einem größten Durchmesser (B) kleiner als 0.4 sein. Die erste Öffnung 318-1 kann linienförmig ausgebildet sein und eine Breite (b) kleiner als eine Wellenlänge des ersten Wellenlängenbereichs aufweisen, und die ersten Rillen 342, 344 können zumindest näherungsweise parallel zu der ersten Öffnung verlaufen, und bei dem die zweite Öffnung 318-2 linienförmig ausgebildet sein und eine Breite (b) kleiner als eine Wellenlänge des zweiten Wellenlängenbereichs aufweist, und bei dem die zweiten Rillen (342, 344) zumindest näherungsweise parallel zu der zweiten Öffnung verlaufen. Ein Verhältnis der Fläche (b) der linienförmigen Öffnungen 318-1;318-2 zu einer von zwei jeweils am weitesten von der jeweiligen Öffnung 318-1;318-2 entfernter paralleler Rillen aufgespannten Fläche kann kleiner als 0.4 sein. Die wenigstens eine strukturierte Schicht 134-1 der ersten Filterstruktur 12-1 kann eine zweidimensionale periodische Anordnung von Subwellenlängenöffnungen aufweisen, und bei dem die wenigstens eine strukturierte Schicht 134-1 der zweiten Filterstruktur 12-2 eine zweidimensionale periodische Anordnung von Subwellenlängenöffnungen aufweisen. Wenigstens eine strukturierte Schicht einer ersten Filterstruktur 12-1 kann Strukturen aufweisen, um einen ersten Pixelsensor 14-1 vollständig abzudecken, und wenigstens eine strukturierte Schicht einer zweiten Filterstruktur 12-2 Strukturen aufweisen, um einen zweiten Pixelsensor 14-1 vollständig abzudecken. Ein erster Pixelsensor 14-1 kann von einer dem ersten Pixelsensor 14-1 zugewandten Seite einer ersten Filterstruktur 12-1 einen vorbestimmten Abstand (d) aufweisen, der kleiner als 20 µm und bevorzugt kleiner als 8 µm ist, und ein zweiter Pixelsensor 14-2 von einer dem zweiten Pixelsensor 14-2 zugewandten Seite einer zweiten Filterstruktur 12-2 einen vorbestimmten Abstand (d) aufweisen, der kleiner als 20 µm und bevorzugt kleiner als 8 µm ist.

## Patentansprüche

1. System, mit
einem multispektralen Bildsensor (10; 20; 30; 40) , der mittels eines CMOS-Prozesses gefertigt ist und ein zweidimensionales Array aus Superpixeln aufweist, wobei jeder Superpixel wenigstens fünf
Sensorelemente (11) aufweist mit jeweils
einem Pixelsensor (14);
einer Filterstruktur (12) mit wenigstens einer strukturierten Schicht aus Metall oder polykristallinem Halbleitermaterial des CMOS-Prozesses, die ansprechend auf elektromagnetische Strahlung eines Wellenlängenbereichs eine höhere Transmission durch die Filterstruktur zu dem Pixelsensor (14) ergibt als für den Wellenlängenbereich umgebende Wellenlängen;
wobei die wenigstens fünf Sensorelemente (12) gemeinsam auf einem Halbleitersubstrat (16) integriert sind und paarweise auf unterschiedliche Wellenlängenbereiche ausgelegt sind;
einer Quelle (45) zur Bestrahlung eines Objekts (44) mit elektromagnetischer Strahlung (S) mit einem Spektrum, das zumindest teilweise mit dem Wellenlängenbereich der Filterstruktur (12) wenigstens eines der Sensorelemente (11) der Superpixel (42) überlappt;
einer Verarbeitungseinrichtung (47) zum Bestimmen eines 3D-Bildes des Objekts (44) basierend auf einem Ausgangssignal des multispektralen Bildsensors (40).

2. System gemäß Anspruch 1, bei dem eine erste Filterstruktur (12-1) eines ersten Sensorelements (11-1) wenigstens einen ersten photonischen Kristall (122-1) aufweist und bei dem eine zweite Filterstruktur (12-2) eines zweiten Sensorelements (11-2) wenigstens einen zweiten photonischen Kristall (122-2) aufweist, wobei der wenigstens eine erste photonische Kristall (122-1) eine fokussierende Wirkung für elektromagnetische Strahlung eines ersten Wellenlängenbereichs aufweist, so dass die elektromagnetische Strahlung eines ersten Wellenlängenbereichs in einem ersten Feldkonzentrationsbereich fokussiert wird, und wobei der erste Pixelsensor (14-1) in dem ersten Feldkonzentrationsbereich der ersten Filterstruktur (12-1) angeordnet ist, und bei dem der wenigstens eine zweite photonische Kristall (122-2) eine fokussierende Wirkung für elektromagnetische Strahlung eines zweiten Wellenlängenbereichs aufweist, so dass die elektromagnetische Strahlung des zweiten Wellenlängenbereichs in einem zweiten Feldkonzentrationsbereich fokussiert wird, und bei dem der zweite Pixelsensor (14-2) in dem ersten Feldkonzentrationsbereich der zweiten Filterstruktur (12-2) angeordnet ist.

3. System gemäß Anspruch 2, bei dem der wenigstens eine erste photonische Kristall (122-1) aus einem ersten Schichtstapel von dielektrischen Schichten (136) und strukturierten Metallschichten (134) des CMOS-Prozesses gebildet ist, und bei dem der wenigstens eine zweite photonische Kristall (122-2) aus einem zweiten Schichtstapel von dielektrischen Schichten (136) und strukturierten Metallschichten (134) des CMOS-Prozesses gebildet ist.

4. System gemäß einem der Ansprüche 2 oder 3, bei dem die strukturierten Schichten (134) des ersten Schichtstapels erste Mikroelemente (148-1) aufweisen, deren Abstände und Abmessungen eine Größenordnung aufweisen, um in der Nähe des ersten Pixelsensors (14-1) eine erste spektrale Selektion zu bewirken, und bei dem die strukturierten Schichten (134) des zweiten Schichtstapels zweite Mikroelemente (148-2) aufweisen, deren Abstände und Abmessungen eine Größenordnung aufweisen, um in der Nähe des zweiten Pixelsensors (14-2) eine zweite spektrale Selektion zu bewirken.

5. System gemäß Anspruch 4, bei dem die Abmessungen und Abstände der ersten Mikroelemente (148-1) eine Größenordnung aufweisen, welche unterhalb einer ersten Wellenlänge des ersten Wellenlängenbereichs liegt, und bei dem die Abmessungen und Abstände der zweiten Mikroelemente (148-2) eine Größenordnung aufweisen, welche unterhalb einer zweiten Wellenlänge des zweiten Wellenlängenbereichs liegt.

6. System gemäß Anspruch 1, bei dem eine erste Filterstruktur (12-1) eine erste strukturierte Schicht (134) mit einer ersten Zonenplattenstruktur (214-1) mit einem ersten Feldkonzentrationsbereich aufweist, wobei die erste Filterstruktur (12-1) und ein erster Pixelsensor (14-1) derart in dem Halbleitersubstrat (16) integriert sind, so dass der erste Pixelsensor (14-1) in dem ersten Feldkonzentrationsbereich der ersten Filterstruktur (12-1) angeordnet ist, und bei dem eine zweite Filterstruktur (12-2) eine zweite strukturierte Schicht (134) des CMOS-Prozesses mit einer zweiten Zonenplattenstruktur (214-2) mit einem zweiten Feldkonzentrationsbereich aufweist, wobei die zweite Filterstruktur (12-2) und ein zweiter Pixelsensor (14-2) derart in dem Halbleitersubstrat (16) integriert sind, so dass der zweite Pixelsensor (14-2) in dem zweiten Feldkonzentrationsbereich der zweiten Filterstruktur (12-2) angeordnet ist.

7. System gemäß Anspruch 6, bei dem die erste Filterstruktur (12-1) ferner eine erste weitere strukturierte Schicht (272) des CMOS-Prozesses mit zumindest näherungsweise identischer Zonenplattenstruktur (214) wie die erste strukturierte Schicht (134) aufweist, wobei die zumindest näherungsweise identische Zonenplattenstrukturen der ersten strukturierten Schicht (134) und der ersten weiteren strukturierten Schicht (272) zueinander lateral versetzt sind, um eine spektrale Filterwirkung des ersten Sensorelements (11-1) zu erhalten, und bei dem die zweite Filterstruktur (12-2) ferner eine zweite weitere strukturierte Schicht (272) mit zumindest näherungsweise identischer Zonenplattenstruktur (214) wie die zweite strukturierte Schicht (134) aufweist, wobei die zumindest näherungsweise identische Zonenplattenstrukturen der zweiten strukturierten Schicht (134) und der zweiten weiteren strukturierten Schicht (272) zueinander lateral versetzt sind, um eine spektrale Filterwirkung des zweiten Sensorelements (11-2) zu erhalten.

8. System gemäß einem der Ansprüche 6 oder 7, bei dem die erste Filterstruktur (12-1) ferner eine erste weitere strukturierte Schicht (272) mit Zonenplattenstruktur (214) aufweist, wobei die Zonenplattenstruktur (214) der ersten weiteren strukturierten Schicht (272) gegenüber der Zonenplattenstruktur der ersten strukturierten Schicht (134) unterschiedliche Verhältnisse von Zonenradien aufweist, um eine erste spektrale Filterwirkung zu erhalten, und bei dem die zweite Filterstruktur (12-2) ferner eine zweite weitere strukturierte Schicht (272) mit Zonenplattenstruktur (214) aufweist, wobei die Zonenplattenstruktur (214) der zweiten weiteren strukturierten Schicht (272) gegenüber der Zonenplattenstruktur der zweiten strukturierten Schicht (134) unterschiedliche Verhältnisse von Zonenradien aufweist, um eine zweite spektrale Filterwirkung zu erhalten.

9. System gemäß Anspruch 1, bei dem die wenigstens eine strukturierte Schicht (134-1) einer ersten Filterstruktur (12-1) ansprechend auf elektromagnetische Strahlung (118) eines ersten Wellenlängenbereichs einen Plasmon-Polariton-Resonanz-Effekt ermöglicht, und bei dem die wenigstens eine strukturierte Schicht (134-1) einer zweiten Filterstruktur (12-1) ansprechend auf elektromagnetische Strahlung (118) eines zweiten Wellenlängenbereichs einen Plasmon-Polariton-Resonanz-Effekt ermöglicht.

10. System gemäß Anspruch 9, bei dem der erste Pixelsensor (14-1) in einem Abstand (d) von der wenigstens einen strukturierten Schicht (134-1) der ersten Filterstruktur (12-1) angeordnet ist, der kleiner ist als eine Wellenlänge des ersten Wellenlängenbereichs, und bei dem der zweite Pixelsensor (14-2) in einem Abstand (d) von der wenigstens einen strukturierten Schicht (134-1) der zweiten Filterstruktur (12-1) angeordnet ist, der kleiner ist als eine Wellenlänge des zweiten Wellenlängenbereichs.

11. System gemäß einem der vorhergehenden Ansprüche, wobei die elektromagnetische Strahlung (118) Licht ist.

12. System gemäß einem der vorhergehenden Ansprüche, bei dem die wenigstens fünf Pixelsensoren (14-1; 14-2) PN-Übergangssensoren sind.

13. System gemäß einem der vorhergehenden Ansprüche, der in CMOS-Technologie gefertigt ist.

14. System gemäß einem der vorhergehenden Ansprüche, bei dem die Verarbeitungseinrichtung (47) ausgebildet ist, um das 3D-Bild des Objekts (44) mittels Triangulation, Laufzeitmessung oder Interferometrie zu bestimmen.

15. System gemäß einem der vorhergehenden Ansprüche, bei dem die Verarbeitungseinrichtung (47) ausgebildet ist, um das 3D-Bild so zu bestimmen, dass das 3D-Bild für eines oder mehrere der Superpixel eine Entfernungsinformation aufweist, die von dem Ausgangssignal des wenigstens einen der Sensorelemente (11) der Superpixel (42) abhängt, sowie eine spektrale Verteilung, die von dem Ausgangssignal von wenigstens mehreren der anderen Sensorelemente (11) der Superpixel (42) abhängt.
